(19) Europäisches Patentamt
European Patent Office
Office européen des brevets

(11) EP 4 755 636 A1

(12) EUROPEAN PATENT APPLICATION

(43) Date of publication:
**10.06.2026 Bulletin 2026/24**

(21) Application number: **25218578.0**

(22) Date of filing: **26.11.2025**

(51) International Patent Classification (IPC):
***B41C 1/10*** *(2006.01)*

(52) Cooperative Patent Classification (CPC):
**B41C 1/1008;** B41C 2210/04; B41C 2210/08; B41C 2210/26

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.12.2024 JP 2024213998**

(71) Applicant: **FUJIFILM Corporation**
**Tokyo 106-8620 (JP)**

(72) Inventors:
- **AIZU, Kohei**
  **Shizuoka, 421-0396 (JP)**
- **YOKOKAWA, Natsumi**
  **Shizuoka, 421-0396 (JP)**
- **SONE, Nobuyuki**
  **Shizuoka, 421-0396 (JP)**

(74) Representative: **HGF**
**HGF Limited**
**4th Floor, 1 City Square**
**Leeds LS1 2ES (GB)**

# (54) LITHOGRAPHIC PRINTING PLATE PRECURSOR AND METHOD OF PREPARING LITHOGRAPHIC PRINTING PLATE

(57) A lithographic printing plate precursor including a support and an image-recording layer on the support, in which the image-recording layer contains a polymer A having a main chain containing two or more silicon atoms, and a hydrophilic group.

EP 4 755 636 A1

**Description**

BACKGROUND OF THE INVENTION

1. Field of the Invention

The present disclosure relates to a lithographic printing plate precursor and a method of preparing a lithographic printing plate.

2. Description of the Related Art

In general, a lithographic printing plate is composed of lipophilic image areas that receive ink during a printing process and hydrophilic non-image areas that receive dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

In the related art, in order to prepare this lithographic printing plate, a lithographic printing plate precursor (PS plate) has been widely used which is obtained by providing a lipophilic photosensitive resin layer, that is, an image-recording layer, on a hydrophilic support. Usually, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing a surface of the hydrophilic support.

The image-recording layer includes a negative tone photosensitive image-recording layer that contains a polymerizable compound and a polymerization initiator and in which an exposed portion is polymerized and cured to form an image area, and a positive tone photosensitive image-recording layer that contains an alkali-soluble resin, an infrared absorber (for example, an infrared absorbing dye, hereinafter also referred to as an IR dye), and the like and in which the solubility of the exposed portion is improved to form an image area. In the positive tone photosensitive image-recording layer, the infrared absorber, particularly, the IR dye or the like acts as a development suppressing agent that substantially reduces the solubility of the resin in a developer by an interaction with the resin in a non-exposed portion, and is converted to an image area of the lithographic printing plate, and in an exposed portion, the interaction between the IR dye or the like and the resin is weakened by heat generated from the IR dye or the like, and the IR dye or the like and the resin are dissolved in a developer to be converted to a non-image area.

The image-recording layer in the lithographic printing plate precursor is a photosensitive resin layer which forms an image area and a non-image area by applying energy to the image-recording layer by exposure or the like.

As the characteristics required for the lithographic printing plate precursor, both removability of a non-image area after energy application and printing durability of an image area to be formed have been required.

In the negative tone photosensitive image-recording layer which is one aspect of the image-recording layer, in a case where the removability of the non-image area is improved, the film hardness before exposure may be decreased. In a case where the film hardness before exposure is reduced, the film may be destroyed due to friction with various members in contact with the film surface of the image-recording layer during handling in the manufacturing, transportation, and plate-making steps of the lithographic printing plate precursor, and as a result, the image-recording layer may be transferred to each member, and thus improvement is required.

In addition, in recent years, in order to further reduce the environmental load, there is a tendency to simplify or eliminate development or plate making as a method that does not require treatment of waste liquid associated with wet treatment such as development treatment. As one of the simple production methods, a method called "on-press development" is performed in the negative tone photosensitive image-recording layer. That is, the on-press development is a method of exposing a lithographic printing plate precursor, then immediately mounting the precursor on a printer without performing development of the related art, and removing an unnecessary portion of the image-recording layer at an initial stage of the ordinary printing step.

In the present disclosure, the lithographic printing plate precursor that can be used for such on-press development, that is, the lithographic printing plate precursor having an on-press development type negative tone photosensitive image-recording layer is referred to as an "on-press development type" lithographic printing plate precursor.

In the on-press development type negative tone photosensitive image-recording layer, it is more difficult to achieve both the transfer suppression property and the developability described above. This is because, in the on-press development type image-recording layer, in a case where the film hardness is increased, in a case where the ink and

dampening water come into contact with the image-recording layer and are developed, the film of the non-image area of the image-recording layer tends to be developed and the dispersibility tends to decrease due to the weak tack force of the ink during printing, and development defects are likely to occur. On the other hand, it is considered that in a case where the film hardness is lowered, as described above, the film breakage and transfer occurring during the handling in the manufacturing, transportation, and plate-making steps of the lithographic printing plate are more likely to occur as compared with the negative tone photosensitive image-recording layer which requires development.

Examples of the lithographic printing plate precursors in the related art include those described in WO2024/117242A, WO2007/097302A, or WO2018/181993A.

WO2024/117242A discloses a lithographic printing plate precursor including a support, an image-recording layer on the support, and the image-recording layer contains a (meth)acrylic polymer having a substituent having two or more silicon atoms in a side chain.

WO2007/097302A discloses a lithographic printing plate precursor having a support, an image-recording layer and a protective layer on the support, in which the image-recording layer contains a siloxane-based surfactant, and the protective layer contains polyvinyl alcohol (hereinafter, PVA) having a saponification degree of 94% or more.

WO2018/181993A discloses a lithographic printing plate precursor having a support and a negative tone image-recording layer on the support, in which the image-recording layer contains a siloxane-based surfactant, and an arithmetic average height of a surface of an outermost layer is defined.

SUMMARY OF THE INVENTION

An object to be achieved by an embodiment of the present disclosure is to provide a lithographic printing plate precursor having a good transfer suppression property of an image-recording layer and good developability of a non-image area.

An object to be achieved by another embodiment of the present disclosure is to provide a method of preparing a lithographic printing plate obtained by using the lithographic printing plate precursor.

Means for solving the above issues include the following aspects.

<1> A lithographic printing plate precursor comprising:

a support; and
an image-recording layer on the support,
in which the image-recording layer contains a polymer A having a main chain containing two or more silicon atoms, and a hydrophilic group.

<2> The lithographic printing plate precursor according to <1>,
in which the polymer A has the hydrophilic group in at least any of a side chain or a main chain terminal.
<3> The lithographic printing plate precursor according to <2>,
in which the polymer A has the hydrophilic group in the side chain.
<4> The lithographic printing plate precursor according to any one of <1> to <3>,
in which the hydrophilic group contained in the polymer A is at least one selected from the group consisting of a hydroxy group, an amine group, a carboxy group, a carbinol group, an alkylamino group, a (poly)ether group, a (poly) glycerol group, a (poly)ester group, and a (poly)amide group.
<5> The lithographic printing plate precursor according to any one of <1> to <4>,
in which the polymer A is a polymer represented by Formula (A).

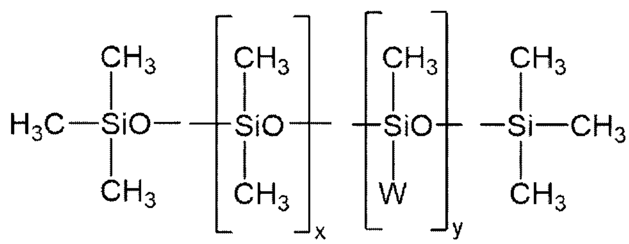 (A)

In Formula (A), W represents a hydrophilic group, x represents the number of bonds of a dimethylsiloxane structural unit and is in a range of 0 or more, and y represents the number of bonds of a siloxane structural unit having a hydrophilic group in a side chain and is in a range of 1 or more, where a bonding order between the dimethylsiloxane structural unit and the siloxane structural unit having a hydrophilic group in a side chain in Formula (A) may be either

block-shaped or random-shaped.

<6> The lithographic printing plate precursor according to any one of <1> to <5>,

in which the image-recording layer is a negative tone photosensitive image-recording layer containing a polymerizable compound and a polymerization initiator.

<7> The lithographic printing plate precursor according to <6>,

in which the negative tone photosensitive image-recording layer contains an infrared absorber and an onium salt polymerization initiator as the polymerization initiator, and is an on-press development type.

<8> The lithographic printing plate precursor according to <6> or <7>,

in which the negative tone photosensitive image-recording layer further contains polymer particles, and is an on-press development type.

<9> The lithographic printing plate precursor according to any one of <6> to <8>,

in which the negative tone photosensitive image-recording layer further contains a color forming substance precursor, and is an on-press development type.

<10> The lithographic printing plate precursor according to any one of <6> to <9>,

in which the negative tone photosensitive image-recording layer contains a polyfunctional polymerizable compound, and is an on-press development type.

<11> The lithographic printing plate precursor according to any one of <6> to <10>,

in which the negative tone photosensitive image-recording layer contains a borate compound represented by Formula (B1), and is an on-press development type.

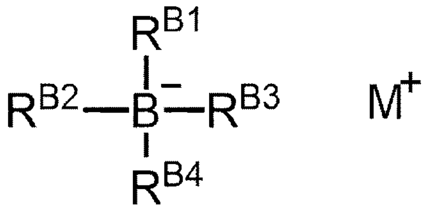 (B1)

In Formula (B1), $R^{B1}$ to $R^{B4}$ each independently represent an unsubstituted or substituted alkyl group, an unsubstituted or substituted aryl group, an unsubstituted or substituted alkenyl group, or an unsubstituted or substituted alkynyl group, and $R^{B1}$ to $R^{B4}$ may each independently have a ring structure, provided that, at least one of $R^{B1}$, $R^{B2}$, $R^{B3}$, or $R^{B4}$ is different from the others, and $M^+$ represents a cation.

<12> The lithographic printing plate precursor according to any one of <1> to <11>, further comprising:

a protective layer on the image-recording layer.

<13> The lithographic printing plate precursor according to any one of <1> to <12>, further comprising:

an undercoat layer between the support and the image-recording layer.

<14> A method of preparing a lithographic printing plate, the method comprising:

a step of imagewise exposing the lithographic printing plate precursor according to any one of <1> to <13>; and
a step of supplying at least one selected from the group consisting of a printing ink and dampening water on a printer to remove an image-recording layer in a non-image area.

According to an embodiment of the present disclosure, it is possible to provide a lithographic printing plate precursor having excellent transfer suppression property of an image-recording layer and good developability of a non-image area.

Furthermore, according to another embodiment of the present disclosure, it is possible to provide a method of preparing a lithographic printing plate obtained by using the lithographic printing plate precursor.

BRIEF DESCRIPTION OF THE DRAWINGS

FIG. 1 is a schematic cross-sectional view of an embodiment of a support.

FIG. 2 is a schematic cross-sectional view of another embodiment of a support.

FIG. 3 is a schematic view of an embodiment of a mechanical roughening treatment device comprising a rotating bundled brush.

FIG. 4 is a graph showing an embodiment of an alternating current power source waveform in an electrochemical roughening treatment.

FIG. 5 is a schematic view of an embodiment of an electrolytic cell used for an electrochemical roughening treatment of an aluminum support using an aqueous nitric acid solution.

FIG. 6 is a schematic view of an embodiment of an anodization treatment device used for an anodization treatment in a method of producing a support having an anodic oxide film.

## DESCRIPTION OF THE PREFERRED EMBODIMENTS

Hereinafter, the contents of the present disclosure will be described in detail. The description of configuration requirements below is made based on representative embodiments of the present disclosure in some cases, but the present disclosure is not limited to such embodiments.

In the present disclosure, a numerical range expressed using "to" includes numerical values listed before and after "to" as the lower limit value and the upper limit value.

In addition, in the present disclosure, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present disclosure, "(meth)acryl" is a term used to explain a concept including both the acryl and methacryl, and "(meth)acryloyl" is a term used to explain a concept including both the acryloyl and methacryloyl.

The term "step" in the present disclosure means not only an independent step but also a step that cannot be clearly differentiated from other steps as long as the intended goal of the step is achieved.

In the present disclosure, "% by mass" and "% by weight" have the same meaning, and "part(s) by mass" and "part(s) by weight" have the same meaning.

In the present disclosure, unless otherwise specified, as each component contained in a composition or each constitutional unit contained in a polymer, one component or one constitutional unit may be used alone, or two or more components or two or more constitutional units may be used in combination.

In the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

In the present disclosure, a combination of two or more preferred aspects is a more preferred aspect.

In the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. The term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "*" in a chemical structural formula represents a bonding position with other structures.

### Lithographic printing plate precursor

The lithographic printing plate precursor according to the present disclosure includes a support and an image-recording layer on the support, in which the image-recording layer contains a polymer A having a main chain containing two or more silicon atoms, and a hydrophilic group.

Hereinafter, each of the configuration requirements in the lithographic printing plate precursor according to the present disclosure will be specifically described.

### Image-recording layer

The image-recording layer in the lithographic printing plate precursor according to the present disclosure is not particularly limited as long as it contains the polymer A (hereinafter, also referred to as a "polymer A") having a main chain containing two or more silicon atoms, and a hydrophilic group, and may be a negative tone photosensitive image-recording

layer or a positive tone photosensitive image-recording layer.

Among these, from the viewpoint of further improving the balance between the transfer suppression property and the developability of the image-recording layer in the lithographic printing plate precursor of the present disclosure, the image-recording layer is preferably a negative tone photosensitive image-recording layer (hereinafter, also referred to as a negative tone image-recording layer), and from the viewpoint of ease of application as an on-press development type, a water-soluble or water-dispersible negative tone image-recording layer is preferable.

Negative tone image-recording layer

In a case where the negative tone image-recording layer in the lithographic printing plate precursor according to the embodiment of the present disclosure is applied to an on-press development type, from the viewpoint of on-press developability, it is preferable that an unexposed portion of the image-recording layer can be removed by at least any of dampening water or printing ink.

Hereinafter, each component contained in the image-recording layer will be described in detail.

Polymer A

The polymer A has a main chain containing two or more silicon atoms and a hydrophilic group.

The bonding position of the hydrophilic group in the polymer A is optional, and the bonding position may be any of a main chain terminal, between silicon atoms of the main chain, or a side chain.

Among these, from the viewpoint of further improving the transfer suppression property of the image-recording layer, the polymer A preferably has a hydrophilic group in at least any of the side chain or the main chain terminal, and more preferably has a hydrophilic group at the side chain.

Main chain

Examples of the main chain containing two or more silicon atoms include a main chain containing two or more dimethylsiloxane structural units having the following structure.

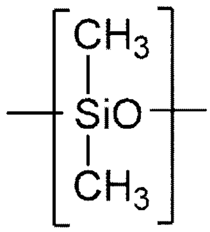

Hydrophilic group

From the viewpoint of easily removing the non-image area, the hydrophilic group contained in the polymer A is preferably at least one selected from the group consisting of a hydroxy group, an amine group, a carboxy group, a carbinol group, an alkylamino group, a (poly)ether group, a (poly)glycerol group, a (poly)ester group, and a (poly)amide group, more preferably a carbinol group or a (poly)ether group, and still more preferably a (poly)ether group.

Examples of the polyether group which is a preferred hydrophilic group include an aspect in which a plurality of alkyleneoxy groups are linked, and a side chain in which two or more of at least one alkyleneoxy group selected from a methyleneoxy group and an ethyleneoxy group are linked is preferable. From the viewpoint of hydrophilicity, the number of linked alkyleneoxy groups is preferably 3 to 100, more preferably 5 to 50, and still more preferably 8 to 20.

The hydrophilic group contained in the polymer A may be only one kind or two or more kinds, but from the viewpoint of synthetic suitability, it is preferable that the hydrophilic group is only one kind.

Examples of the polymer A include a polymer represented by Formula (A) as an aspect in which a hydrophilic group is provided in a side chain.

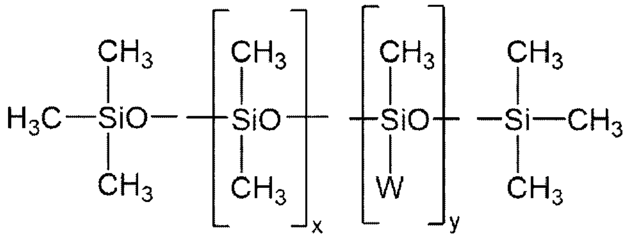 (A)

In Formula (A), W represents a hydrophilic group, and x represents the number of bonds of a dimethylsiloxane structural unit and is in a range of 0 or more. y represents the number of bonds of a siloxane structural unit having a hydrophilic group in a side chain, and is in a range of 1 or more. The bonding order between the dimethylsiloxane structural unit and the siloxane structural unit having a hydrophilic group in a side chain in Formula (A) is optional, and may be either block-shaped or random.

In Formula (A), the bonding order between the dimethylsiloxane structural unit and the siloxane structural unit having a hydrophilic group in the side chain is optional, and the siloxane structural unit may be a random copolymer or a block copolymer. The copolymerization ratio of the dimethylsiloxane structural unit and the siloxane structural unit having a hydrophilic group in the side chain is also optional, but from the viewpoint of further improving the coating surface properties of the image-recording layer coating solution used in a case of forming the image-recording layer and the transfer suppression property of the formed image-recording layer, x:y is preferably 50:50 to 90:10 in a case where $x + y = 100$, in terms of the ratio of molar amounts.

From the viewpoint of the transfer suppression property of the image-recording layer, the weight-average molecular weight of the polymer A is preferably in a range of 500 to 50000 and more preferably in a range of 2000 to 20000.

The polymer A may be, for example, a polymer represented by Formula (A2) as an aspect having a hydrophilic group at a terminal of a main chain.

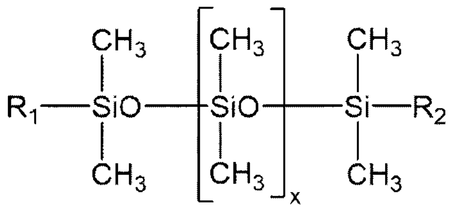 (A 2)

In Formula (A2), $R_1$ and $R_2$ each independently represent a methyl group or a hydrophilic group, and at least one of $R_1$ or $R_2$ is a hydrophilic group. x represents the number of bonds of the dimethylsiloxane structural unit, and is in a range of 0 or more.

Hereinafter, more specific examples of the structure of the polymer A used in the lithographic printing plate precursor according to the present disclosure will be shown below. In addition, a numerical value described together with the following structure is a numerical value (for example, 9) in a hydrophilic group of a side chain, and indicates the number of bonds such as an ethyleneoxy group, which means that the number of bonds is 9.

In addition, the numerical value (for example, 6 or 10) in the main chain indicates the number of bonds of a repeating unit having four dimethylsiloxane structural units and one siloxane structural unit having a hydrophilic group in the side chain, and means that six repeating units are linked or ten repeating units are linked.

It goes without saying that the polymer A is not limited to the following specific examples.

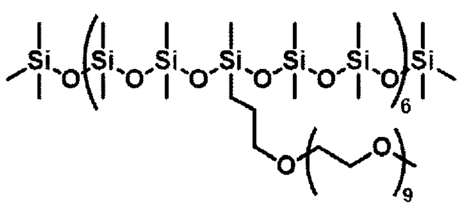 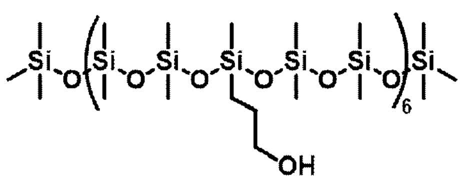

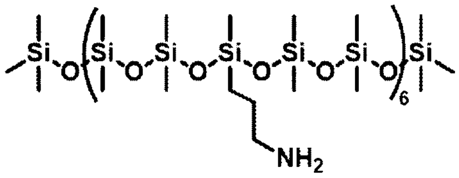

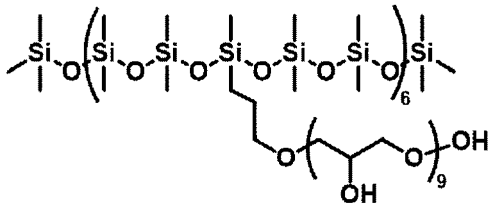

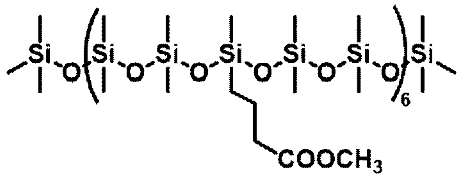

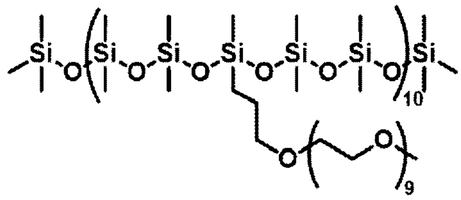

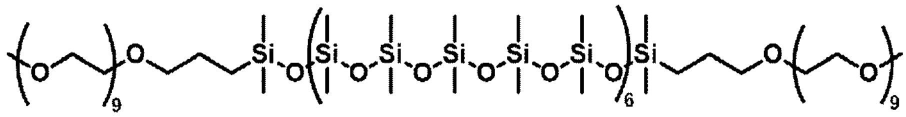

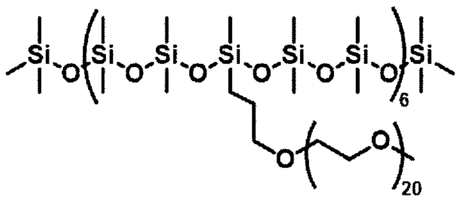

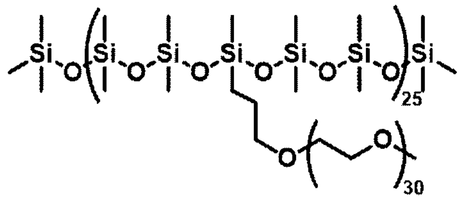

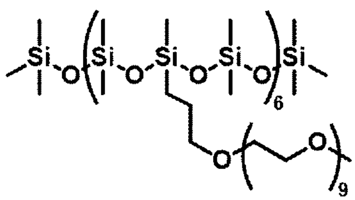

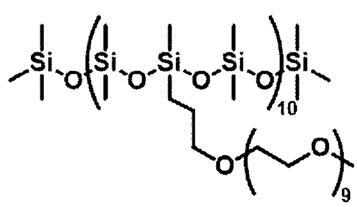

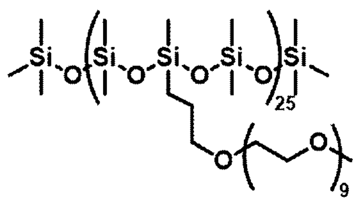

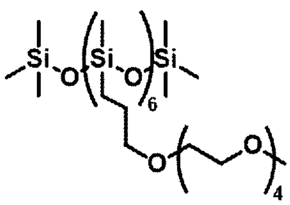

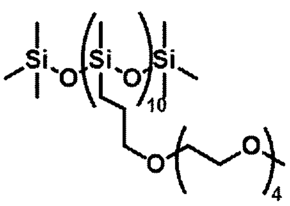

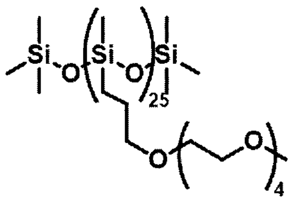

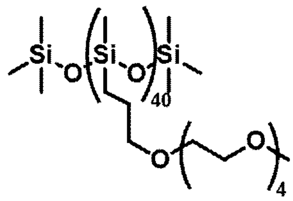

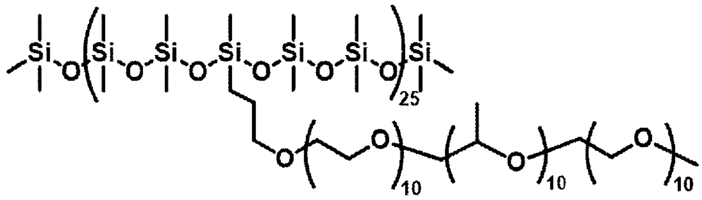

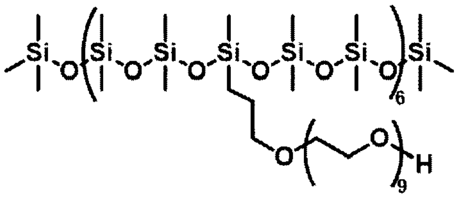

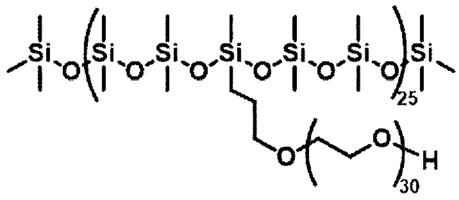

Among the above specific examples, a compound having a hydrophilic group in a side chain is preferable, and a compound having a polyether group and a compound having a carbinol group as the hydrophilic group are more preferable.

As the polymer A, a commercially available product may be used, and specific examples of the commercially available product of the polymer A include the following products.

In the names of commercially available products described below, "DOWSIL", "XIAMETER", and "SYLGARD" are registered trademarks. Hereinafter, the description that "DOWSIL", "XIAMETER", and "SYLGARD" are registered trademarks will be omitted.

Examples of products manufactured by Dow Toray Co., Ltd. include DOWSIL BY 16-205, DOWSIL BY 16-849 Fluid, DOWSIL FZ-3710 Fluid, DOWSIL FZ-3760, DOWSIL FZ-3785, DOWSIL SF 8417 Fluid, DOWSIL BY 16-891, DOWSIL FZ-3789, DOWSIL BY 16-839 Fluid, DOWSIL SF 8411 Fluid, DOWSIL SF 8413 Fluid, DOWSIL SF 8421 Fluid, DOWSIL BY 16-880 Fluid, DOWSIL BY 16-201, DOWSIL SF 8427 Fluid, DOWSIL SF 8428 Fluid, DOWSIL 580 WAX, DOWSIL BY 16-606, DOWSIL BY 16-846 Fluid, XIAMETER OFX-0203 Fluid, XIAMETER OFX-0230 Fluid, DOWSIL SF 8416 Fluid, DOWSIL SF 8419 Fluid, DOWSIL 501W Additive, DOWSIL FZ-2110, DOWSIL FZ-2123, DOWSIL L-7001, SYLGARD OFX-0309 Fluid, XIAMETER OFX-5211 Fluid, DOWSIL SF 8410 Fluid, DOWSIL SH 3746 Fluid, DOWSIL SH 8400 Fluid, DOWSIL SH 8700 Fluid, DOWSIL SH 510 Fluid (100 cSt, 500 cSt), DOWSIL SH 550 Fluid, DOWSIL SH 710 Fluid, and DOWSIL FS 1265 Fluid.

Examples of Shin-Etsu Silicone (registered trademark) products of Shin-Etsu Chemical Co., Ltd. include KP series such as KP-124, KP-109, KP-110, KP-121, KP-118, KP-341, KP-112, KP-125, KP-101, KP-106, KP-120, KP-105, KP-104, KP-611, KP-626, KP-327, KP-323, KP-322, KP-625, KP-623, KP-624, KP-620, KP-651, KP-652, KP-650, KP-310, KP-306, KP-301, KP-621, KP-369, KP-368, and KP-126, and KF series and FL series such as KF-868, KF-865, KF-864, KF-859, KF-393, KF-860, KF-880, KF-8004, KF-8002, KF-8005, KF-867, KF-8021, KF-869, KF-861, KF-877, KF-101, KF-1001, KF-102, KF-1002, KF-1005, KF-2001, KF-2004, KF-99, KF-9901, PAM-E, KF-8010, KF-8012, KF-8008, KF-105, KF-6000, KF-6001, KF-6002, KF-6003, KF-6123, KF-9701, KF-2012, KF-857, KF-862, KF-858, KF-351A, KF-352A, KF-353, KF-354L, KF-355A, KF-615A, KF-945, KF-640, KF-642, KF-643, KF-644, KF-6020, KF-6204, KF-6011, KF-6012, KF-6015, KF-6017, KF-410, FL-5, FL-100-100cs, FL-100-450cs, FL-100-1,000cs, FL-100-10,000cs, KF-412, KF-413, KF-414, KF-415, KF-4003, KF-4701, KF-4917, KF-7235B, KF-3935, KF-50-100cs, KF-50-300cs, KF-50-1,000cs, KF-50-3,000cs, KF-53, KF-54, and KF-6004.

Examples of products of BYK-Chemie GmbH include BYK-300, BYK-302, BYK-306, BYK-307, BYK-310, BYK-313, BYK-315 N, BYK-320, BYK-322, BYK-323, BYK-325 N, BYK-326*, BYK-327*, BYK-330, BYK-331, BYK-333, BYK-342, BYK-345/346, BYK-347, BYK-348, BYK-349, BYK-370, BYK-375, BYK-377, BYK-378, BYK-3450*, BYK-3451*, BYK-3455, BYK-3456*, BYK-3760*, BYK-UV 3500, BYK-UV 3505*, BYK-UV 3510, BYK-UV 3530, BYK-UV 3535*, BYK-UV 3570, BYK-UV 3575*, BYK-UV 3576, BYK-350, BYK-354, BYK-355/356 acrylic copolymer, BYK-358 N/361 N, BYK-381 acrylic copolymer, BYK-392 acrylic copolymer, BYK-394 acrylic copolymer, BYK-3441 acrylic copolymer, BYK-399, BYK-3440*, BYK-3550, BYK-3560*, BYK-3565*, BYK-3566*, BYK-SILCLEAN 3700, BYK-SILCLEAN 3701*, BYK-SILCLEAN 3720, and BYK-DYNWET 800 N.

Examples of the products of Evonik include Tego Glide 100, Tego Glide 410, Tego Glide 432, Tego Glide 435, Tego Glide 440, Tego Glide 450, Tego Glide 490, Tego Glide 492, Tego Glide 494, Tego Glide 496, Tego Glide A116, Tego Glide B1484, Tego Glide ZG400, Tego Flow 425, Tego wet 240, Tego wet 250, Tego wet 260, Tego wet 270, Tego wet 280, Tego Twin 4000, Tego Twin 4100, and Tego Twin 420.

The image-recording layer may contain only one kind of the polymer A, or may contain two or more kinds thereof.

The content of the polymer A in the image-recording layer is preferably 0.001% by mass to 5% by mass, and more preferably 0.01% by mass to 2% by mass, with respect to the total solid content of the image-recording layer coating solution.

The image-recording layer is preferably a negative tone photosensitive image-recording layer containing a polymerizable compound and a polymerization initiator.

Hereinafter, a case where the lithographic printing plate precursor according to the embodiment of the present disclosure is a negative tone photosensitive image-recording layer will be described.

Polymerizable compound

In a case where the image-recording layer is a negative tone photosensitive image-recording layer, it is preferable that the image-recording layer contains a polymerizable compound.

In the present disclosure, a polymerizable compound refers to a compound having a polymerizable group.

The polymerizable group is not particularly limited, may be a known polymerizable group, and is preferably an ethylenically unsaturated group. In addition, the polymerizable group may be a radically polymerizable group or a cationically polymerizable group, and is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound may be, for example, a radically polymerizable compound or a cationically polymerizable compound. As the polymerizable compound, an addition polymerizable compound having at least one ethylenically unsaturated bond (ethylenically unsaturated compound) is preferable.

The ethylenically unsaturated compound is preferably a compound having at least one terminal ethylenically unsaturated bond, and more preferably a compound having two or more terminal ethylenically unsaturated bonds. The chemical form of the polymerizable compound is, for example, a monomer, a prepolymer which is in other words a dimer, a trimer, or an oligomer, a mixture of these, or the like.

Particularly, from the viewpoint of printing durability, the polymerizable compound preferably includes a polymerizable compound having functionalities of 2 or more, more preferably includes a polymerizable compound having functionalities of 6 or more, and even more preferably includes a polymerizable compound having functionalities of 10 or more. In addition, from the viewpoint of printing durability of the lithographic printing plate to be obtained, the polymerizable compound preferably includes a polyfunctional polymerizable compound having 2 or more functional groups (preferably 6 or more functional groups and more preferably 10 or more functional groups), and it is more preferable that the polymerizable compound includes a polyfunctional (meth)acrylate compound as the polyfunctional polymerizable compound.

From the viewpoint of on-press developability and contamination suppressing property, the aforementioned polymerizable compound preferably includes a polymerizable compound having functionalities of 2 or less, more preferably includes a difunctional polymerizable compound, and particularly preferably includes a difunctional (meth) acrylate compound.

From the viewpoints of printing durability, on-press developability, and contamination suppressing property, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and even more preferably 15% by mass to 100% by mass.

In the polymerizable compound, from the viewpoint of on-press developability, a smaller weight-average molecular weight is preferable, and from the viewpoint of printing durability, a larger weight-average molecular weight is preferable. From the viewpoint of achieving both on-press developability and printing durability, the weight-average molecular weight of the polymerizable compound is preferably 100 or greater and less than 15,000, more preferably 500 or greater and less than 13,000, and even more preferably 1,000 or greater and less than 10,000.

From the viewpoint of the suppressing property of development defect over time, the polymerizable compound preferably includes a polymerizable compound having an aromatic ring. The proportion of the aromatic ring in the molecule is preferably 1 or more, more preferably 2 or more, and still more preferably 3 or more per molecule.

As the polymerizable compound to be incorporated into in the image-recording layer, a polymerizable compound which is an oligomer (hereinafter, also simply called "oligomer") is preferable.

In the present disclosure, an oligomer represents a polymerizable compound which has a molecular weight (weight-average molecular weight in a case where the compound has molecular weight distribution) of 600 or more and 15,000 or less and at least one polymerizable group.

From the viewpoints of excellent chemical resistance and excellent printing durability, the molecular weight of the oligomer is preferably 1,000 or more and 15,000 or less.

In addition, from the viewpoint of improving printing durability, the number of polymerizable groups in one molecule of the oligomer is preferably 2 or more, more preferably 3 or more, even more preferably 6 or more, and particularly preferably 10 or more.

The upper limit value of the number of the polymerizable groups in the oligomer is not particularly limited, but the number of polymerizable groups is preferably 20 or less.

From the viewpoints of printing durability and on-press developability, an oligomer having 7 or more polymerizable groups and a molecular weight of 1,000 or more and 15,000 or less is preferable, and an oligomer having 7 or more

and 20 or less polymerizable groups and a molecular weight of 1,000 or more and 15,000 or less is more preferable.

The oligomer may contain a polymer component which is likely to be generated in the process of manufacturing the oligomer.

From the viewpoints of printing durability, visibility, and on-press developability, the oligomer preferably has at least one selected from the group consisting of a compound having a urethane bond, a compound having an ester bond, and a compound having an epoxy residue, and more preferably has a compound having a urethane bond.

In the present disclosure, an epoxy residue refers to a structure formed of an epoxy group and for example, means a structure similar to a structure obtained by the reaction between an acid group (carboxylic acid group or the like) and an epoxy group.

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

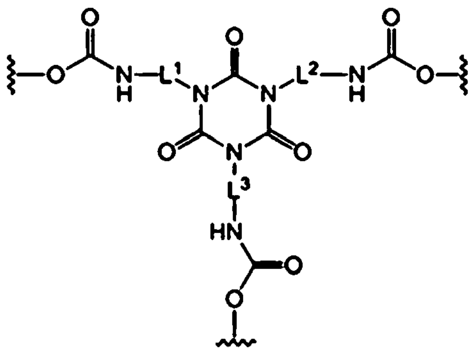

( Ac - 1 )

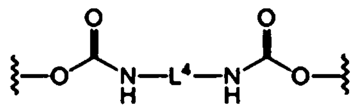

( Ac - 2 )

In Formula (Ac-1) and Formula (Ac-2), $L^1$ to $L^4$ each independently represent a divalent hydrocarbon group having a carbon number of 2 to 20, and the portion of the wavy line represents a bonding position with other structures.

$L^1$ to $L^4$ preferably each independently represent an alkylene group having a carbon number of 2 to 20, more preferably each independently represent an alkylene group having a carbon number of 2 to 10, and even more preferably each independently represent an alkylene group having a carbon number of 4 to 8. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

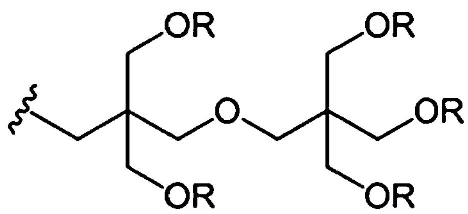

( Ae - 1 )

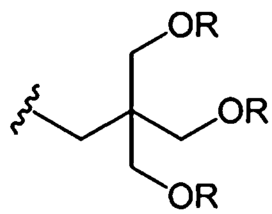

( Ae - 2 )

In Formula (Ae-1) and Formula (Ae-2), R each independently represent an acryloyloxy group or a methacryloyloxy group, and the portion of the wavy line represents a bonding position with portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the obtained polyurethane by a polymer reaction.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy

group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown as follows, but the oligomer used in the present disclosure is not limited thereto.

As the oligomer, commercially available products may also be used. Examples thereof include UA-510H, UA-306H, UA-306I, and UA-306T (all manufactured by KYOEISHA CHEMICAL Co., Ltd.), UV-1700B, UV-6300B, and UV7620EA(all manufactured by The Nippon Synthetic Chemical Industry Co., Ltd.), U-15HA (manufactured by SHIN-NAKAMURA CHEMICAL Co., Ltd.), EBECRYL450, EBECRYL657, EBECRYL885, EBECRYL800, EBECRYL3416, and EBECRYL860 (all manufactured by DAICEL-ALLNEX LTD.), and the like. However, the oligomer is not limited to these.

From the viewpoints of improving chemical resistance and printing durability and further suppressing the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 600.

From the viewpoints of excellent chemical resistance, excellent printing durability, and excellently suppressing the residues of on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than the oligomer, from the viewpoints of chemical resistance and printing durability and suppressing the residues of on-press development, the ratio (oligomer/low-molecular-weight polymerizable compound) of the oligomer to the low-molecular-weight polymerizable compound (total amount in a case where the polymerizable compound includes two or more low-molecular-weight polymerizable compounds) based on mass is preferably 10/1 to 1/10, more preferably 10/1 to 3/7, and even more preferably 10/1 to 7/3.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the additive amount of the compound, can be optionally set.

Particularly, from the viewpoint of printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

Polymerization initiator

In a case where the image-recording layer is a negative tone photosensitive image-recording layer, it is preferable that the image-recording layer contains a polymerization initiator. The polymerization initiator is a compound that generates a polymerization initiation species such as a radical by energy application, and the polymerizable compound is polymerized and cured by the generated polymerization initiation species to form an image area.

The polymerization initiator may be an electron-accepting polymerization initiator, for example, an onium compound, or an electron-donating polymerization initiator, for example, a borate compound, and any of the electron-accepting polymerization initiator or the electron-donating polymerization initiator may be contained. In addition, the

negative tone photosensitive image-recording layer may contain both the electron-accepting polymerization initiator and the electron-donating polymerization initiator.

Onium compound

The negative tone photosensitive image-recording layer preferably contains an onium compound as the electron-accepting polymerization initiator.

The electron-accepting polymerization initiator is a compound that generates a polymerization initiation species such as a radical by accepting one electron through intermolecular electron transfer in a case where electrons of the infrared absorber are excited by exposure to infrared in one aspect.

In addition, the onium compound used in the present disclosure is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

From the viewpoint of printing durability, the onium compound is preferably an iodonium compound, a sulfonium compound, or an azinium compound, more preferably an iodonium compound or a sulfonium compound, and particularly preferably an iodonium compound.

Specific examples of these compounds will be shown below, but the present disclosure is not limited thereto.

As the iodonium compound, for example, a diaryliodonium compound is preferable. Particularly, an electron-donating group, for example, a diphenyl iodonium compound substituted with an electron-donating group such as an alkyl group or an alkoxy group is more preferable. In addition, an asymmetric diphenyl iodonium compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

In addition, specific examples of the onium compound include the compounds described in paragraphs 0044 to 0046 of WO2020/262685A.

It is preferable that the onium compound includes a compound A represented by Formula (Ia) and one or more compounds B selected from the group consisting of a compound represented by Formula (Ib) and a compound represented by Formula (Ic).

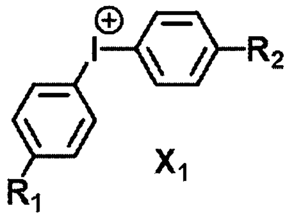
Formula (Ia)

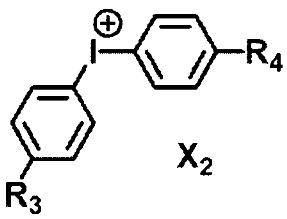
Formula (Ib)

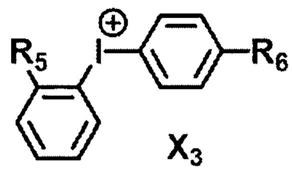
Formula (Ic)

In Formulae (Ia) to (Ic), $R_1$, $R_2$, $R_3$, $R_4$, $R_5$, and $R_6$ are each independently a substituted or unsubstituted alkyl group having 2 to 9 carbon atoms or a substituted or unsubstituted alkoxy group having 2 to 9 carbon atoms, at least one of $R_3$ or $R_4$ is different from $R_1$ or $R_2$, a difference between a total number of carbon atoms in $R_1$ and $R_2$ and a total number of carbon atoms in $R_3$ and $R_4$ is 0 to 4 (that is, 0, 1, 2, 3, or 4), a difference between the total number of carbon atoms in $R_1$ and $R_2$ and a total number of carbon atoms in $R_5$ and $R_6$ is 0 to 4, and $X_1$, $X_2$, and $X_3$ are the same or different anions.

$R_1$, $R_2$, $R_3$, $R_4$, $R_5$, and $R_6$ are each independently preferably a substituted or unsubstituted alkyl group having 2 to 9 carbon atoms or a substituted or unsubstituted alkoxy group having 2 to 9 carbon atoms, more preferably a substituted or unsubstituted alkyl group having 3 to 6 carbon atoms or a substituted or unsubstituted alkoxy group having 3 to 6 carbon atoms, and even more preferably a substituted or unsubstituted alkyl group having 3 to 6 carbon atoms. The alkyl group and the alkoxy group all may be linear or branched, but are preferably branched.

Examples of the substituted or unsubstituted alkyl group include an ethyl group, an n-propyl group, an iso-propyl group, an n-butyl group, an iso-butyl group, a sec-butyl group, a t-butyl group, an n-pentyl group, a t-pentyl group, a sec-pentyl group, a neopentyl group, an n-hexyl group, an iso-hexyl group, a sec-hexyl group, a t-hexyl group, an n-heptyl group, an n-octyl group, an iso-octyl group, a 2-ethyl hexyl group, and an n-nonyl group.

Examples of the substituted or unsubstituted alkoxy group include an ethoxy group, a propoxy group, an iso-propoxy group, a t-butoxy group, an n-butoxy group, and an n-octyloxy group.

As $X_1$, $X_2$, and $X_3$, $ClO_4^-$, $PF_6^-$, $BF_4^-$, $SbF_6^-$, $CH_3SO_3^-$, $CF_3SO_3^-$, $C_6H_5SO_3^-$, $CH_3C_6H_4SO_3^-$, $HOC_6H_4SO_3^-$, $ClC_6H_4SO_3^-$, and a borate anion represented by the following formula (Id) are preferable.

$B^-(R^1)(R^2)(R^3)(R^4)$ Formula (Id)

In Formula (Id), $R^1$, $R^2$, $R^3$, and $R^4$ each independently represent a substituted or unsubstituted alkyl group, a substituted or unsubstituted aryl group (including a halogen-substituted aryl group), a substituted or unsubstituted alkenyl group, a substituted or unsubstituted alkynyl group, a substituted or unsubstituted cycloalkyl group, or a substituted or unsubstituted heterocyclic group. Two or more of $R^1$, $R^2$, $R^3$, and $R^4$ may be linked to each other to form a substituted or unsubstituted heterocyclic ring containing a boron atom. The heterocyclic ring to be obtained has a maximum of 7 carbon atoms, nitrogen atoms, oxygen atoms, or nitrogen atoms.

Examples of the substituent in $R^1$, $R^2$, $R^3$, and $R^4$ include a chlorine atom, a fluorine atom, a nitro group, an alkyl group, an alkoxy group, and an acetoxy group.

All of $R^1$, $R^2$, $R^3$, and $R^4$ are preferably a substituted or unsubstituted aryl group, and more preferably an unsubstituted phenyl group.

It is preferable that at least one of $X_1$, $X_2$, or $X_3$ is a tetraaryl borate anion including the same or different aryl groups, it is more preferable that one or more of $X_1$, $X_2$, and $X_3$ are tetraphenyl borate anions, and it is even more preferable that each of $X_1$, $X_2$, and $X_3$ is a tetraphenyl borate anion.

Preferred aspects include an aspect in which the onium compound includes a compound represented by Formula (Ic), $R_1$ is the same as $R_5$, and $R_2$ is the same as $R_6$. In particular, it is preferable that $R_1$ is the same as $R_2$, and for example, both $R_1$ and $R_2$ are an iso-propyl group, an iso-butyl group, or a t-butyl group.

In addition, examples of another preferable aspect include an aspect in which the onium compound includes a compound represented by Formula (Ib), $R_1$ is the same as $R_2$, and $R_3$ is the same as $R_4$. In this case, it is preferable that both $R_1$ and $R_2$ are an iso-propyl group, an iso-butyl group, or a t-butyl group. In addition, the difference in the number of carbon atoms between $R_1$ and $R_3$ is preferably 1 or 2.

The compounds represented by Formulae (Ia) to (Ic) may be obtained from Sigma-Aldrich Co., LLC or the like, or may be synthesized by a known synthesis method using easily available starting materials.

From the viewpoint of the suppressing property of the development defect over time and the printing durability, the onium compound is preferably a diaryliodonium compound represented by Formula (5) or Formula (6).

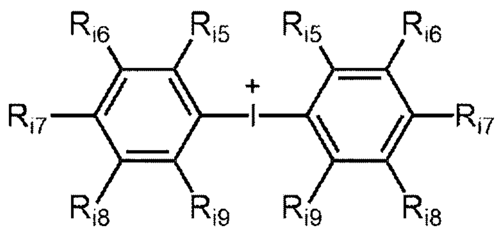

$X^-$ (5)

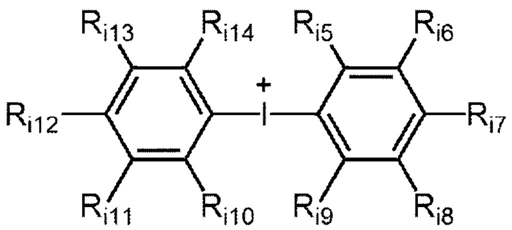

$X^-$ (6)

In Formulae (5) and (6), $R_{i5}$ to $R_{i14}$ each independently represent a hydrogen atom, a substituted or unsubstituted alkyl group, a substituted or unsubstituted aryl group, a substituted or unsubstituted alkenyl group, or a substituted or unsubstituted alkynyl group, at least two of $R_{i5}$ to $R_{i14}$ may be bonded to each other to form a ring structure, and $X^-$ represents a counteranion.

In the diaryliodonium compound represented by Formula (5), it is preferable that the cationic moiety has a symmetrical shape.

In the diaryliodonium compound represented by Formula (6), it is preferable that the cationic moiety has an asymmetric shape.

In addition, it is preferable that at least one of $R_{i5}$, ..., or $R_{i9}$ is a substituted or unsubstituted alkyl group, and it is preferable that at least one of $R_{i10}$, ..., or $R_{i14}$ is a substituted or unsubstituted alkyl group.

$R_{i5}$ to $R_{i14}$ each independently represent preferably a hydrogen atom or a substituted or unsubstituted alkyl group

having 1 to 9 carbon atoms, more preferably a hydrogen atom or a substituted or unsubstituted alkyl group having 3 to 6 carbon atoms, and still more preferably a substituted or unsubstituted alkyl group having 3 to 6 carbon atoms. The alkyl group may be linear or branched, but is preferably branched.

Examples of the substituted or unsubstituted alkyl group include a methyl group, an ethyl group, an n-propyl group, an iso-propyl group, an n-butyl group, an iso-butyl group, a sec-butyl group, a t-butyl group, an n-pentyl group, a t-pentyl group, a sec-pentyl group, a neopentyl group, an n-hexyl group, an iso-hexyl group, a sec-hexyl group, a t-hexyl group, an n-heptyl group, an n-octyl group, an iso-octyl group, a 2-ethyl hexyl group, and an n-nonyl group.

As the above-described $X^-$, $ClO_4^-$, $PF_6^-$, $BF_4^-$, $SbF_6^-$, $CH_3SO_3^-$, $CF_3SO_3^-$, $C_6H_5SO_3^-$, $CH_3C_6H_4SO_3^-$, $HOC_6H_4SO_3^-$, $ClC_6H_4SO_3^-$, or a borate anion represented by the above-described formula (Id) is preferable.

From the viewpoint of developability and printing durability of the lithographic printing plate to be obtained, the onium compound may include a compound represented by Formula (II) described in paragraphs 0186 to 0197 of WO2022/019217A.

From the viewpoint of improving sensitivity and making it difficult for plate missing to occur, the lowest unoccupied molecular orbital (LUMO) of the onium compound is preferably -3.00 eV or less, and more preferably -3.02 eV or less.

The lower limit of LUMO is preferably -3.80 eV or more and more preferably -3.60 eV or more.

The onium compound may be used alone or in combination of two or more kinds thereof.

From the viewpoint of visibility, printing durability, and coating liquid stability, the content of the onium compound is preferably in a range of 0.1% by mass to 20% by mass, more preferably in a range of 0.5% by mass to 10% by mass, and particularly preferably in a range of 0.5% by mass to 7% by mass with respect to the total mass of the image-recording layer.

Borate compound

The image-recording layer preferably contains an electron-donating borate compound.

The borate compound is used as an electron-donating polymerization initiator in the image-recording layer.

The borate compound is a compound that generates a polymerization initiation species such as a radical or a cation by light, heat, or energy of both.

The borate compound is preferably a tetraaryl borate compound or a monoalkyltriaryl borate compound, from the viewpoint of compound stability, more preferably a tetraaryl borate compound, and particularly preferably a tetraphenyl borate compound.

The counter cation that the borate compound has is not particularly limited, but is preferably an alkali metal ion or a tetraalkyl ammonium ion and more preferably a sodium ion, a potassium ion, or a tetrabutylammonium ion.

From the viewpoint of visibility, printing durability, and suppressing property of development defect over time, the borate compound is preferably a compound represented by Formula (B1). That is, the negative tone photosensitive image-recording layer preferably contains the borate compound represented by (B1) and is an on-press development type.

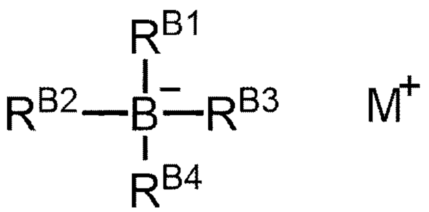
(B1)

In Formula (B1), $R^{B1}$ to $R^{B4}$ each independently represent an unsubstituted or substituted alkyl group, an unsubstituted or substituted aryl group, an unsubstituted or substituted alkenyl group, or an unsubstituted or substituted alkynyl group, and $R^{B1}$ to $R^{B4}$ may each independently have a ring structure, provided that, at least one of $R^{B1}$, $R^{B2}$, $R^{B3}$, or $R^{B4}$ is different from the others, and $M^+$ represents a cation.

Examples of the alkyl group represented by $R^{B1}$ to $R^{B4}$, which include those with 1 to 20 carbon atoms, include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group. The alkyl group described above may be linear or branched, or may have a ring structure.

In addition, the alkyl group represented by $R^{B1}$ to $R^{B4}$ may have a substituent. Examples of the substituent of the alkyl group include a halogen atom, an alkyl group, an aryl group, an alkenyl group, an alkoxy group, an ester group, a carbonyl group, a sulfonyl group, an amino group, an amide group, and a group obtained by combining these groups.

As the alkyl group represented by each of $R^{B1}$ to $R^{B4}$, an unsubstituted linear or branched alkyl group having 1 to

12 carbon atoms is preferable, an unsubstituted linear or branched alkyl group having 1 to 10 carbon atoms is more preferable, and an unsubstituted linear or branched alkyl group having 1 to 6 carbon atoms is still more preferable. Among these, from the viewpoint of suppressing deterioration in development over time, an unsubstituted alkyl group having a branch is particularly preferable.

Examples of the aryl group represented by $R^{B1}$ to $R^{B4}$ include an aryl group having 6 to 20 carbon atoms, and examples thereof include a phenyl group, a naphthyl group, an anthryl group, a phenanthryl group, an indenyl group, an acenaphthenyl group, and a fluorenyl group.

Examples of the substituent of the aryl group include the substituent of the above-described alkyl group.

As the aryl group represented by each of $R^{B1}$ to $R^{B4}$, an unsubstituted or substituted phenyl group is preferable.

Examples of the alkenyl group represented by $R^{B1}$ to $R^{B4}$ include an alkenyl group having 2 to 20 carbon atoms, and examples thereof include a vinyl group, a 1-propenyl group, a 1-butenyl group, a cinnamyl group, and a 2-chloro-1-etenyl group.

The alkenyl group represented by $R^{B1}$ to $R^{B4}$ may be linear, branched, or have a ring structure.

Examples of the substituent of the alkenyl group include the substituent of the above-described alkyl group.

As the alkenyl group represented by each of $R^{B1}$ to $R^{B4}$, an unsubstituted alkenyl group having 2 to 20 carbon atoms is preferable.

Examples of the alkynyl group represented by $R^{B1}$ to $R^{B4}$ include an alkynyl group having 2 to 20 carbon atoms, and examples thereof include an ethynyl group, a 1-propynyl group, a 1-butynyl group, a trimethylsilyl ethynyl group, and a phenyl ethynyl group.

The alkynyl group may be linear or branched.

Among the above-described functional groups, $R^{B1}$ to $R^{B4}$ are each independently preferably a substituted or unsubstituted aryl group.

Since $R^{B1}$ to $R^{B4}$ are each independently a substituted or unsubstituted aryl group, the HOMO potential of the borate compound is lowered, and the film stability of the image-recording layer is improved. In this manner, the life of the lithographic printing plate can be extended.

In the present disclosure, at least one of $R^{B1}$, ..., or $R^{B4}$ is different from the others. Among these, it is preferable that $R^{B1}$ to $R^{B3}$ are the same and $R^{B4}$ is different from $R^{B1}$ to $R^{B3}$ in $R^{B1}$ to $R^{B4}$. In this manner, a high-purity borate compound can be obtained. In addition, the generation of radicals can be suppressed, and side reactions are less likely to occur.

In the above case, it is more preferable that $R^{B1}$ to $R^{B3}$ are each a phenyl group.

In addition, it is also preferable that at least two of $R^{B1}$ to $R^{B4}$ are a phenyl group, and at least one of them is a substituted aryl group.

Furthermore, it is more preferable that at least two of $R^{B1}$ to $R^{B3}$ are a phenyl group, and $R^{B4}$ is an aryl group having a substituent (that is, a substituted aryl group), and it is particularly preferable that $R^{B1}$ to $R^{B3}$ are a phenyl group, and $R^{B4}$ is an aryl group having a substituent.

In a case where $R^{B1}$ to $R^{B3}$ are each a phenyl group and $R^{B4}$ is an aryl group having a substituent, the total number of carbon atoms and oxygen atoms in the substituent of the aryl group is preferably 2 or more and more preferably 3 or more. The upper limit thereof is, for example, 8 or less.

The compound represented by Formula (B1) is preferably a compound represented by Formula (B2).

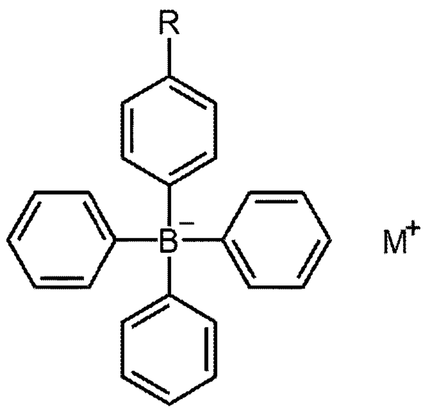

( B2 )

In Formula (B2), R represents an alkyl group having 2 or more carbon atoms or an alkoxy group having a total number of carbon atoms and oxygen atoms of 2 or more. $M^+$ represents an iodonium cation or an infrared absorbing colorant cation.

In Formula (B2), the alkyl group represented by R preferably has 2 to 8 carbon atoms, more preferably has 2 to 6

carbon atoms, and still more preferably has 2 to 4 carbon atoms.

Examples of the above-described alkyl group include an ethyl group, a propyl group, an n-butyl group, a tert-butyl group, an isobutyl group, a sec-butyl group, a pentyl group, a hexyl group, a heptyl group, an octyl group, a neopentyl group, and an isopropyl group.

The alkyl group described above may be linear or branched, or may have a ring structure.

In Formula (B2), the alkoxy group of R preferably has a total number of carbon atoms and oxygen atoms of 2 to 4.

Examples of the above-described alkoxy group include a methoxy group, an n-propoxy group, an isopropoxy group, and an n-butoxy group.

The alkoxy group may be linear or branched.

In addition, in Formula (B1), the phenyl group represented by $R^{B1}$ to $R^{B3}$ is preferably a phenyl group substituted with an electron-withdrawing group.

Examples of the electron-withdrawing group include a halogen atom and a fluoroalkyl group. Among these, a fluorine atom, a chlorine atom, and a fluoroalkyl group having 1 to 3 carbon atoms are preferable.

In Formula (B1), the substituent contained in the aryl group represented by $R^{B4}$ is preferably an alkyl group, an aryl group, an alkenyl group, an alkoxy group, an ester group, a carbonyl group, or an amide group, more preferably an alkyl group, an alkenyl group, or an alkoxy group, and still more preferably an alkyl group or an alkoxy group.

In the present disclosure, the compound represented by Formula (B1) may be a compound represented by Formula (B3).

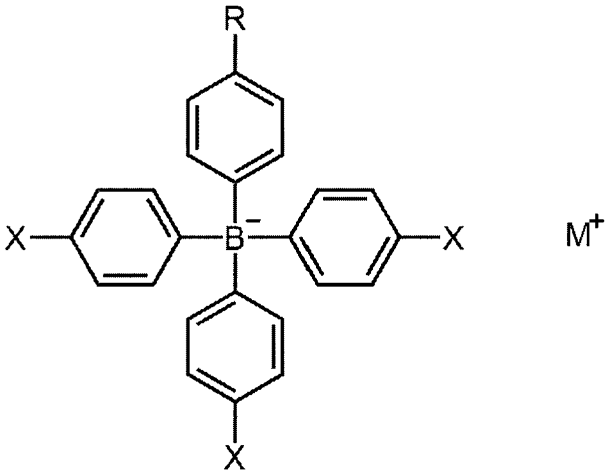

(B3)

In Formula (B3), R represents a group having a total number of carbon atoms and oxygen atoms of 2 or more, X represents a halogen atom, an alkyl group, or an alkoxy group, the sum of Hammett values of R and X is -0.09 to 0.09, and $M^+$ represents $Li^+$, $Na^+$, $K^+$, an iodonium cation, or an infrared absorbing colorant cation.

Examples of R in Formula (B3) include an alkyl group, an aryl group, an alkenyl group, an alkoxy group, an ester group, a carbonyl group, a sulfonyl group, an amide group, and a group obtained by combining these groups.

In Formula (B3), examples of the halogen atom represented by X include a fluorine atom, a chlorine atom, and a bromine atom.

In Formula (B3), the alkyl group and the alkoxy group represented by X are the same as the alkyl group and the alkoxy group in Formula (B2), and the same applies to the preferred aspects thereof.

Among these, R in Formula (B3) is preferably an alkyl group having 2 or more and 4 or less carbon atoms or an alkoxy group having 2 or more and 4 or less carbon atoms and oxygen atoms in total, and more preferably an alkyl group having 2 or more and 4 or less carbon atoms. In the above case, X is preferably a halogen atom. Here, the halogen atoms may be different halogen atoms from each other, but it is more preferable that all the halogen atoms are the same halogen atom.

In Formula (B3), the sum of Hammett $\sigma$ values of the substituents (R and X) introduced into the aryl skeleton is preferably in a range of -0.2 to 0.2, and more preferably in a range of - 0.09 to 0.09. In a case where the HOMO potential is within the above-described range, the HOMO potential can be adjusted to a desired range, and the balance between the film stability and the printing durability of the image-recording layer is excellent.

In the present disclosure, for the calculation of the total Hammett $\sigma$ value of the substituents introduced into the aryl skeleton, the numerical values described in the reference "Chemical Seminar 10 Hammett Side-Structure and Reactivity-" (written by Naoki Inamoto, published by Maruzen Co., Ltd., June 1983) were used.

$M^+$ in Formula (B1) represents a cation. That is, $M^+$ is a counter cation of a boron anion. In the present disclosure, $M^+$ is not particularly limited as long as it is a cation capable of neutralizing a boron anion, but from the viewpoint of

suppressing contamination during development, at least one selected from the group consisting of an inorganic cation, an iodonium cation, and an infrared absorbing colorant cation is preferable. The counter cations may be used alone or in combination of two or more kinds thereof.

In Formula (B3), $M^+$ represents $Li^+$, $Na^+$, $K^+$, an iodonium cation, or an infrared absorbing colorant cation. In Formula (B2), $M^+$ represents an iodonium cation or an infrared absorbing colorant cation.

The combination of two or more kinds of counter cations is not particularly limited, but is preferably a combination of inorganic cations, a combination of iodonium cations, or a combination of infrared absorbing coloring agent cations, and more preferably a combination of iodonium cations or a combination of infrared absorbing colorant cations. In this manner, the suppressing property of the temporal development defect and the printing durability are further improved.

The iodonium cation may be a cationic moiety of an electron-accepting polymerization initiator described later, and the infrared absorbing colorant cation may be a cationic moiety of an infrared absorber described later.

In the image-recording layer, the cationic moiety of the electron-donating polymerization initiator and the cationic moiety of the infrared absorber can be bonded to the anionic moiety of the borate compound represented by Formula (B1) to form a salt.

Examples of the inorganic cation include a lithium cation, a sodium cation, a potassium cation, a calcium cation, and a magnesium cation. Among these, a sodium cation, a lithium cation, or a potassium cation is preferable, and a sodium cation is more preferable.

As the iodonium cation, a cationic moiety of an electron-accepting polymerization initiator described later can be used. Specific examples are shown in the following structural formulae. In the following structural formulae, Me represents a methyl group. The iodonium cation is not limited to the following specific examples.

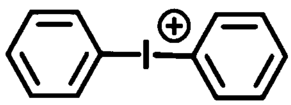
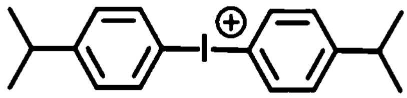
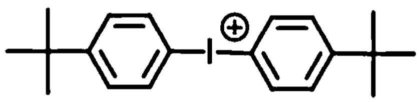
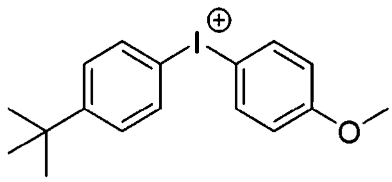
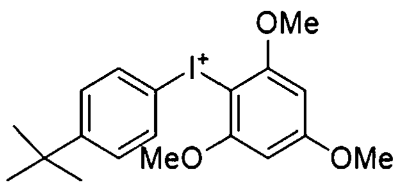
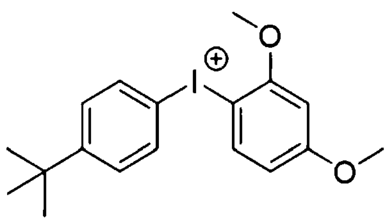
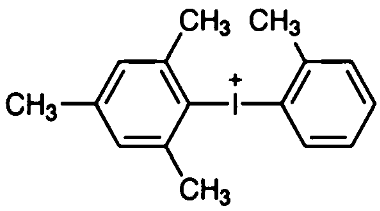
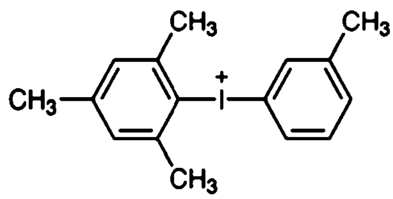
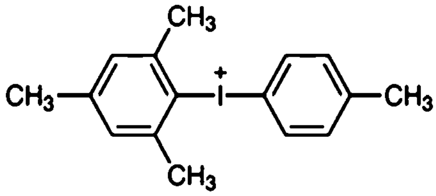
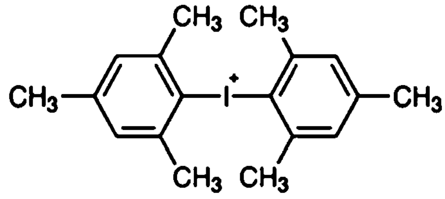

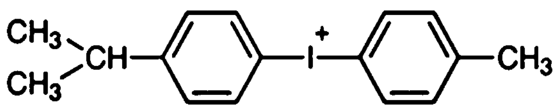

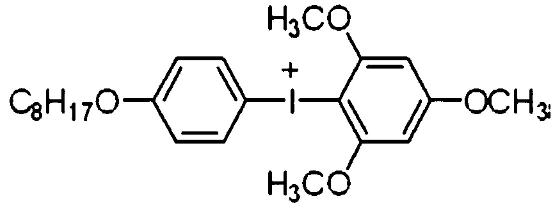

As the infrared-absorbing colorant cation, a cationic moiety of an infrared absorber described later can be used. Specific examples are shown in the following structural formulae. In the following structural formulae, Me represents a methyl group, and Bu represents a butyl group. The infrared absorbing colorant cation is not limited to the following specific examples.

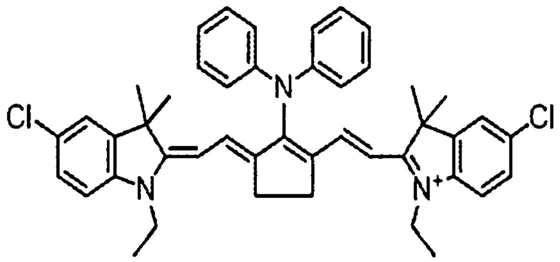

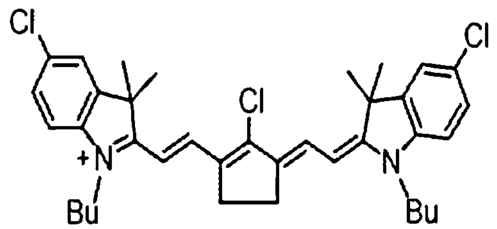

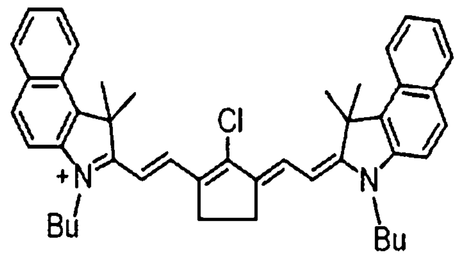

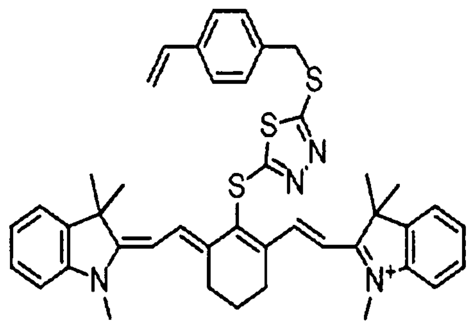

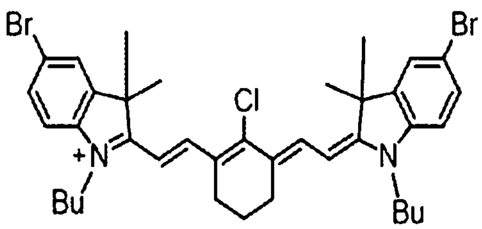

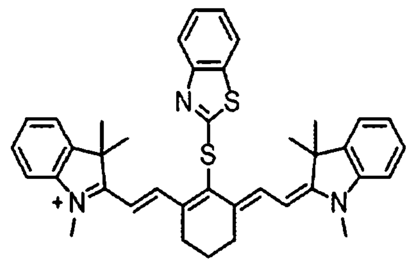

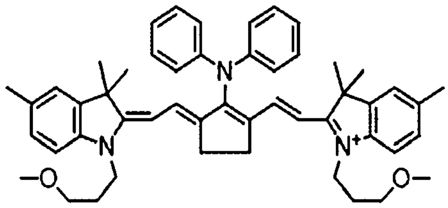

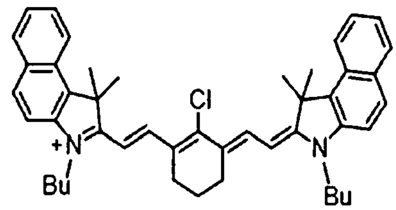

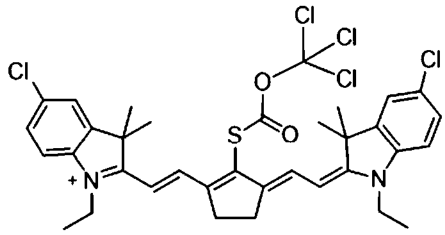

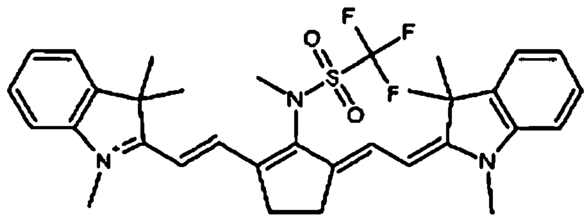

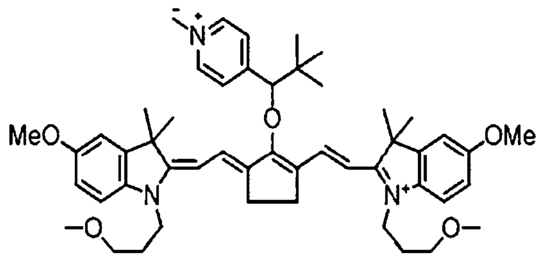

From the viewpoint of chemical resistance and printing durability, the highest occupied molecular orbital (HOMO) of the borate compound is preferably -6.0 eV or more, more preferably -5.95 eV or more, and still more preferably -5.93 eV or more.

The upper limit of HOMO is preferably -5.00 eV or less and more preferably -5.40 eV or less. The range of the HOMO is still more preferably -5.93 eV to -5.70 eV.

In the present disclosure, the highest occupied molecular orbital (HOMO) and the lowest unoccupied molecular orbital (LUMO) are calculated by the following methods.

First, the counteranion in the compound as a calculation object is ignored.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above-described MO energy calculation is converted into Escaled (unit: eV) used as the HOMO value and the LUMO value in the present disclosure.

$$\text{Escaled} = 0.823168 \times 27.2114 \times \text{Ebare} - 1.07634$$

27.2114 is simply a coefficient for converting hartree into eV, and 0.823168 and - 1.07634 are adjustment coefficients. These are determined such that the calculated HOMO and LUMO of the compound as a calculation object match the measured values.

Preferred specific examples of the borate compound represented by Formula (B1) are shown below, but the present invention is not limited thereto. In the following structural formulae, Me represents a methyl group.

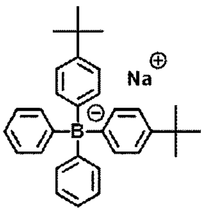

B-1

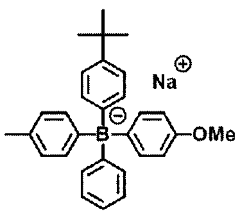

B-2

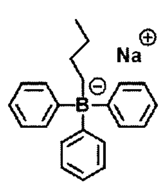

B-3

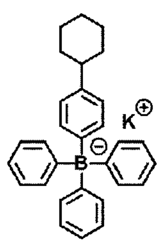

B-4

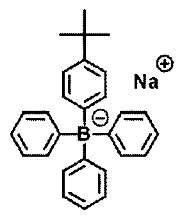

B-5

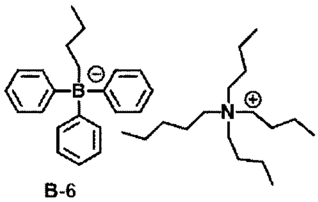
B-6

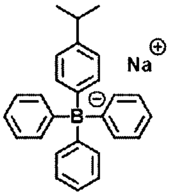
B-7

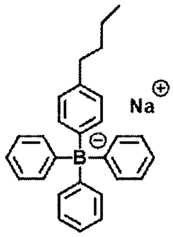
B-8

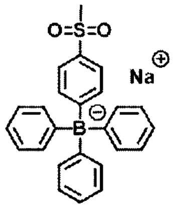
B-9

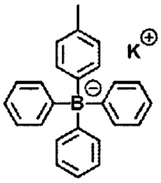
B-10

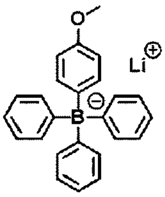
B-11

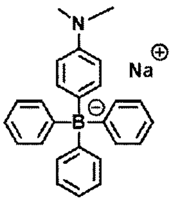
B-12

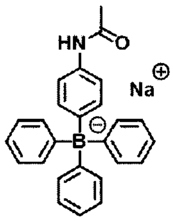
B-13

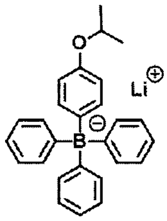
B-14

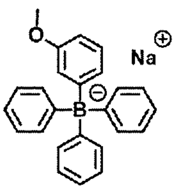
B-15

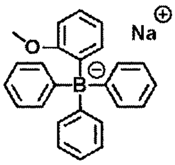
B-16

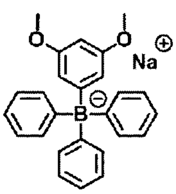
B-17

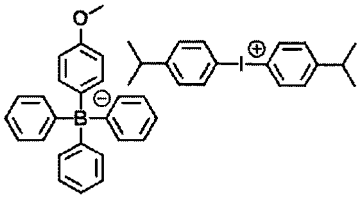
B-18

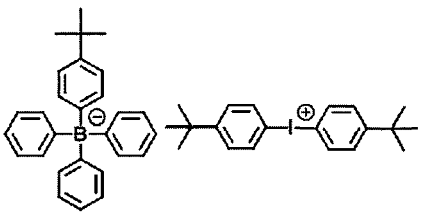
B-19

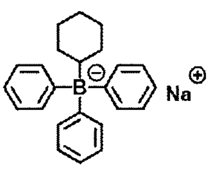
B-20

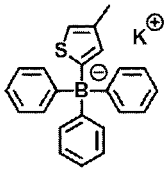
B-21

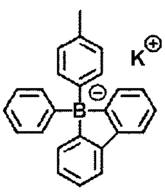
B-22

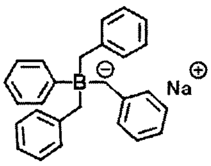
B-23

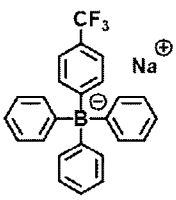
B-24

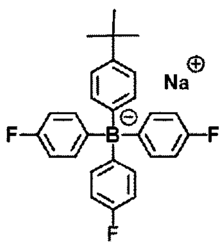
B-25

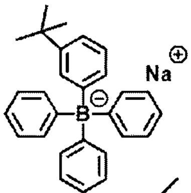

B-26

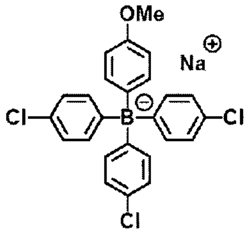

B-27

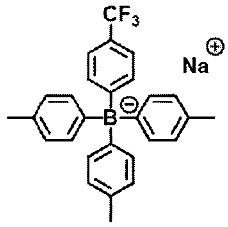

B-28

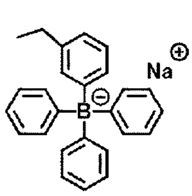

B-29

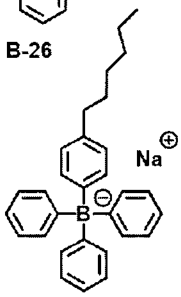

B-30

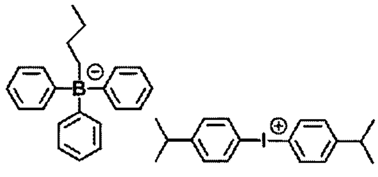

B-31

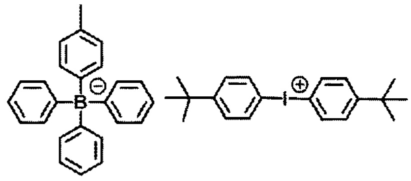

B-32

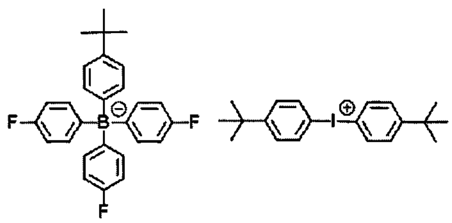

B-33

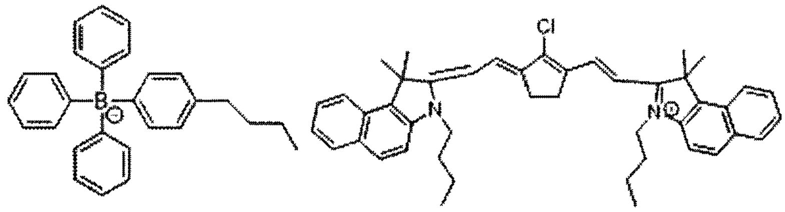

B-34

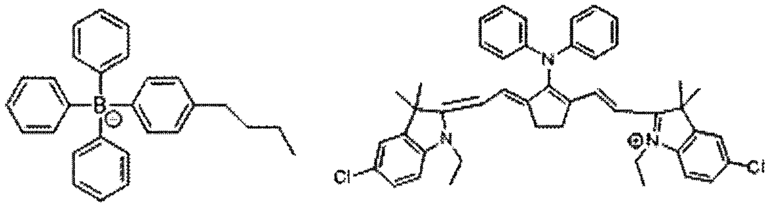

B-35

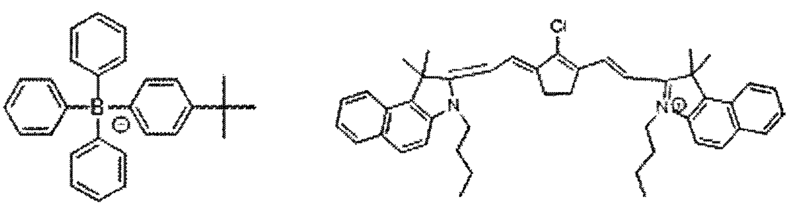

B-36

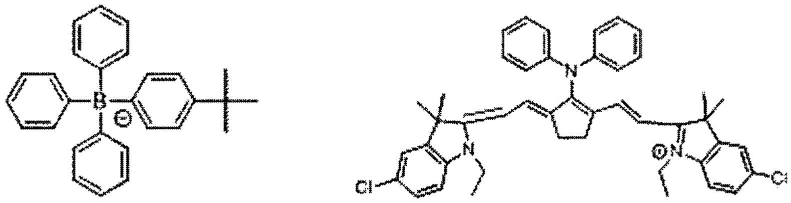

B-37

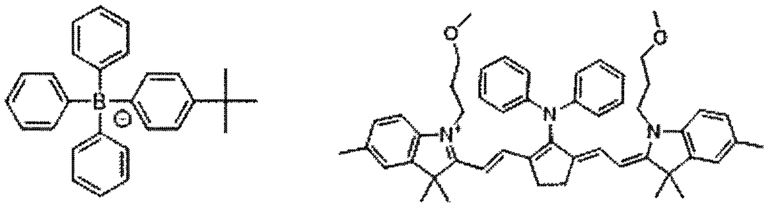

B-38

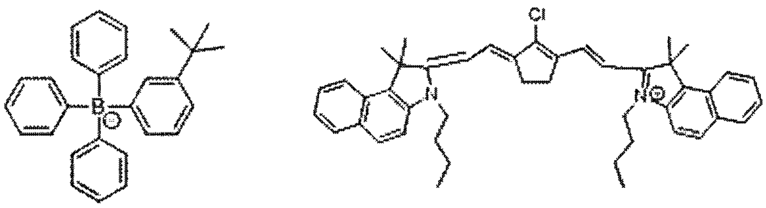

B-39

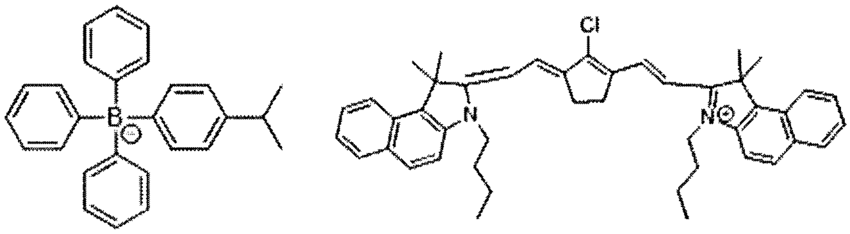

B-40

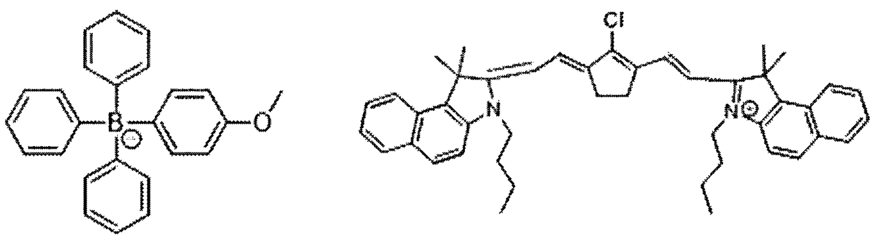

B-41

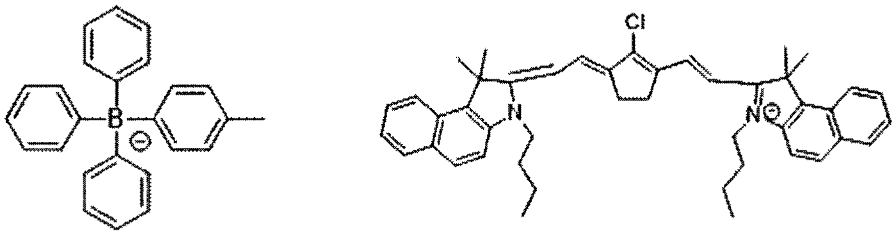

B-42

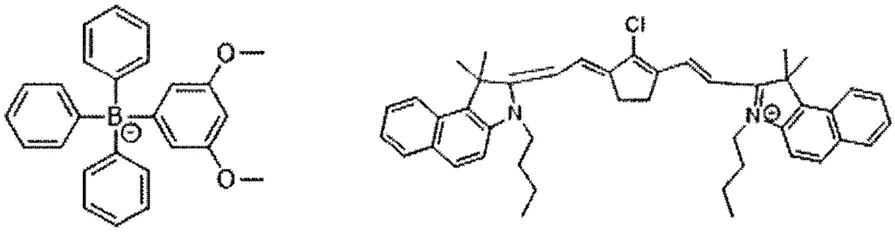

B-43

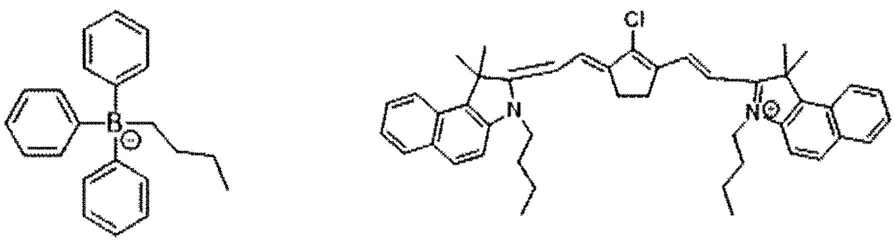

B-44

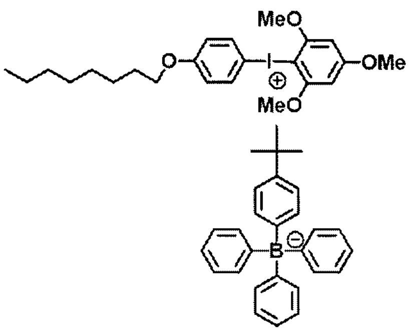

B-45

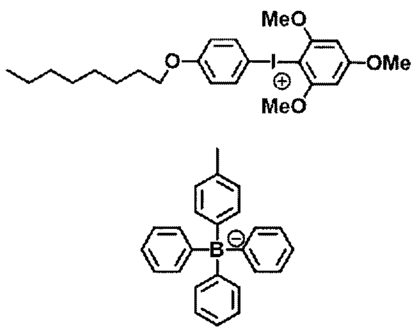

B-46

In a case where the image-recording layer contains a borate compound, the image-recording layer may contain only one kind of the borate compound or may contain two or more kinds thereof.

From the viewpoints of visibility, printing durability, and coating liquid stability, the content of the borate compound is preferably in a range of 0.01% by mass to 30% by mass, more preferably in a range of 0.1% by mass to 20% by mass, and still more preferably in a range of 0.5% by mass to 15% by mass with respect to the total mass of the image-recording layer.

On-press development type negative tone photosensitive image-recording layer

In a case where the negative tone photosensitive image-recording layer is applied to an on-press development type, the negative tone photosensitive image-recording layer preferably contains an infrared absorber and an onium salt polymerization initiator.

Infrared absorber

In a case where the negative tone photosensitive image-recording layer is applied to an on-press development type, it is preferable that the image-recording layer contains an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine colorant, a squarylium colorant, a pyrylium salt, a nickel thiolate complex, and an indolenine cyanine colorant are particularly preferable. Furthermore, for example, a cyanine colorant or an indolenine cyanine colorant is preferable. Among these, a cyanine colorant is particularly preferable.

The infrared absorber is preferably a cationic polymethine colorant having an oxygen or nitrogen atom at the meso-position. Preferred examples of the cationic polymethine colorant include a cyanine colorant, a pyrylium colorant, a thiopyrylium colorant, an azulenium colorant, and the like. From the viewpoint of ease of availability, solubility in a solvent during an introduction reaction, and the like, a cyanine colorant is preferable.

Specific examples of the cyanine colorant include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

In addition, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

In addition, the infrared absorber may include an infrared absorber that decomposes by exposure to infrared (decomposition-type infrared absorber).

Presumably, in a case where a decomposition-type infrared absorber is used as the infrared absorber, the infrared absorber or a decomposition product thereof may promote polymerization, and the decomposition product of the infrared absorber and the polymerizable compound may interact with each other, which may result in excellent printing durability.

The decomposition-type infrared absorber is preferably an infrared absorber that performs a function of forming color by absorbing infrared and decomposing by exposure to infrared.

Hereinafter, a color-forming compound formed as a result of infrared absorption and decomposition of the decomposition-type infrared absorber by exposure to infrared will also be called "color forming substance of the decomposition-type infrared absorber".

In addition, it is preferable that the decomposition-type infrared absorber have a function of absorbing infrared by exposure to infrared and converting the absorbed infrared into heat.

The decomposition-type infrared absorber may be an infrared absorber that decomposes by absorbing at least a part of light in the infrared wavelength region (wavelength of 750 nm to 1 mm). The decomposition-type infrared absorber is preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes upon the exposure to infrared and generates a compound having maximal absorption wavelength in a wavelength region of 500 nm to 600 nm.

The decomposition-type infrared absorber is preferably an infrared absorber that decomposes by either or both of heat and electron migration resulting from exposure to infrared, and more preferably an infrared absorber that decomposes by electron migration resulting from exposure to infrared. "Decomposes by electron migration" mentioned herein means that electrons excited to the lowest unoccupied molecular orbital (LUMO) from the highest occupied molecular orbital (HOMO) of the decomposition-type infrared absorber by exposure to infrared rays move to electron accepting groups (groups having potential close to LUMO) in a molecule by means of intramolecular electron migration and thus result in decomposition.

From the viewpoint of visibility and printing durability, the infrared absorber is preferably a cyanine colorant represented by Formula (7).

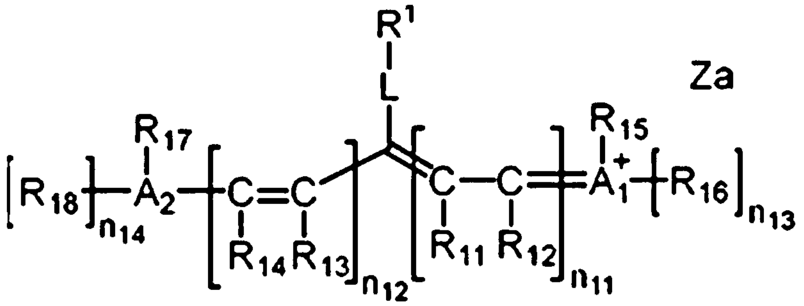

(7)

In Formula (7), $R^1$ represents a group that cleaves an $R^1$-L bond by exposure to infrared, $R_{11}$ to $R_{18}$ each independently represent a hydrogen atom, a halogen atom, -Ra, -ORb, -SRc, or -NRdRe, Ra to Re each independently represent a hydrocarbon group, $A_1$, $A_2$, a plurality of $R_{11}$ to $R_{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

The group that undergoes bond cleavage with $R^1$-L by the above-described heat or infrared exposure is not particularly limited as long as it can be cleaved, but from the viewpoint of visibility, it is preferably a group represented by any of Formula 2-1 to Formula 4-1.

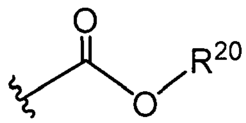

Formula 2-1

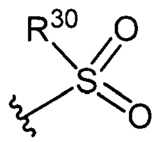

Formula 3-1

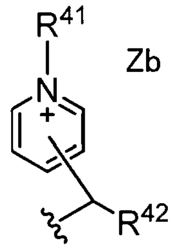

Formula 4-1

In Formula 2-1 to Formula 4-1, $R^{20}$, $R^{30}$, $R^{41}$, and $R^{42}$ each independently represent an alkyl group or an aryl group, Zb represents a counterion that neutralizes charge, and a wavy line represents a bonding site with a group represented by L in Formula (7).

In a case where the compound represented by Formula (7) is exposed to infrared, the $R^1$-L bond is cleaved, L turns into =O, =S, $=NR^{10}$, or the like, and the compound is discolored.

In Formula 2-1, $R^{20}$ represents an alkyl group or an aryl group, and the portion of the wavy line represents a bonding site with the group represented by L in Formula (7).

As the alkyl group represented by $R^{20}$, an alkyl group having a carbon number of 1 to 30 is preferable, an alkyl group having a carbon number of 1 to 15 is more preferable, and an alkyl group having a carbon number of 1 to 10 is even more preferable.

The alkyl group described above may be linear or branched, or may have a ring structure.

The aryl group represented by $R^{20}$ is preferably an aryl group having a carbon number of 6 to 30, more preferably an aryl group having a carbon number of 6 to 20, and even more preferably an aryl group having a carbon number of 6 to 12.

From the viewpoint of visibility, $R^{20}$ is preferably an alkyl group.

From the viewpoint of decomposition properties and visibility, the alkyl group represented by $R^{20}$ is preferably a secondary alkyl group or a tertiary alkyl group, and more preferably a tertiary alkyl group.

Furthermore, from the viewpoint of decomposition properties and visibility, the alkyl group represented by $R^{20}$ is preferably an alkyl group having a carbon number of 1 to 8, more preferably a branched alkyl group having a carbon number of 3 to 10, even more preferably a branched alkyl group having a carbon number of 3 to 6, particularly preferably an isopropyl group or a tert-butyl group, and most preferably a tert-butyl group.

Specific examples of the group represented by Formula 2-1 will be shown below. However, the present disclosure is not limited thereto. In the following structural formulas, • represents a bonding site with the group represented by L in Formula (7).

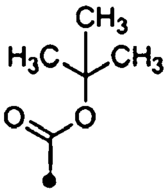 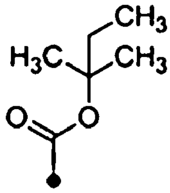 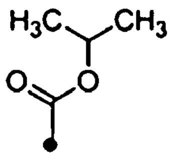 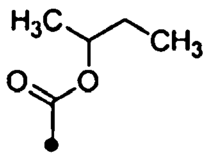 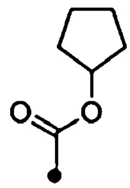

In Formula 3-1, $R^{30}$ represents an alkyl group or an aryl group, and the portion of the wavy line represents a bonding site with the group represented by L in Formula (7).

The alkyl group and aryl group represented by $R^{30}$ are the same as the alkyl group and aryl group represented by $R^{20}$ in Formula 2-1, and the preferred aspects thereof are also the same.

From the viewpoint of decomposition properties and visibility, the alkyl group represented by $R^{30}$ is preferably a secondary alkyl group or a tertiary alkyl group, and more preferably a tertiary alkyl group.

Furthermore, from the viewpoint of decomposition properties and visibility, the alkyl group represented by $R^{30}$ is preferably an alkyl group having a carbon number of 1 to 8, more preferably a branched alkyl group having a carbon number of 3 to 10, even more preferably a branched alkyl group having a carbon number of 3 to 6, particularly preferably an isopropyl group or a tert-butyl group, and most preferably a tert-butyl group.

In addition, from the viewpoint of decomposition properties and visibility, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and visibility, the aryl group represented by $R^{30}$ is preferably a substituted aryl group. Examples of the substituent include an alkyl group (preferably an alkyl group having a carbon number of 1 to 4), an alkoxy group (preferably an alkoxy group having a carbon number of 1 to 4), and the like.

Specific examples of the group represented by Formula 3-1 will be shown below. However, the present disclosure is not limited thereto. In the following structural formulas, • represents a bonding site with the group represented by L in Formula (7).

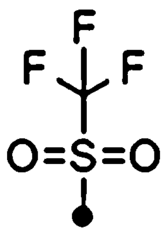 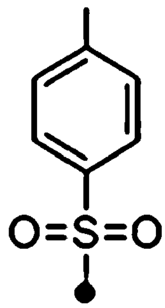

In Formula 4-1, $R^{41}$ and $R^{42}$ each independently represent an alkyl group or an aryl group, Zb represents a counterion that neutralizes charge, and the portion of the wavy line represents a bonding site with the group represented by L in Formula (7).

The alkyl group and aryl group represented by $R^{41}$ or $R^{42}$ are the same as the alkyl group and aryl group represented by $R^{20}$ in Formula 2-1, and preferred aspects thereof are also the same.

From the viewpoint of decomposition properties and visibility, $R^{41}$ is preferably an alkyl group.

From the viewpoint of decomposition properties and visibility, $R^{42}$ is preferably an alkyl group.

From the viewpoint of decomposition properties and visibility, the alkyl group represented by $R^{41}$ is preferably an alkyl group having a carbon number of 1 to 8, more preferably an alkyl group having a carbon number of 1 to 4, and particularly preferably a methyl group.

From the viewpoint of decomposition properties and visibility, the alkyl group represented by $R^{42}$ is preferably a secondary alkyl group or a tertiary alkyl group, and more preferably a tertiary alkyl group.

Furthermore, from the viewpoint of decomposition properties and visibility, the alkyl group represented by $R^{42}$ is preferably an alkyl group having a carbon number of 1 to 8, more preferably a branched alkyl group having a carbon number of 3 to 10, even more preferably a branched alkyl group having a carbon number of 3 to 6, particularly preferably an isopropyl group or a tert-butyl group, and most preferably a tert-butyl group.

Zb in Formula 4-1 may be a counterion that neutralizes charge, and may be included in Za in Formula (7) in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion or a hexafluorophosphate ion.

Specific examples of the group represented by Formula 4-1 will be shown below. However, the present disclosure is not limited thereto. In the following structural formulas, • represents a bonding site with the group represented by L in Formula (7).

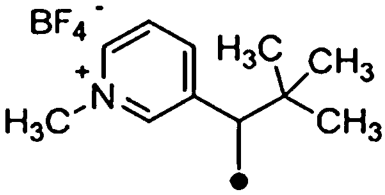 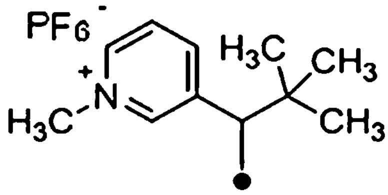

L in Formula (7) is preferably an oxygen atom or $-NR^{10}-$, and particularly preferably an oxygen atom.
In addition, $R^{10}$ in $-NR^{10}-$ is preferably an alkyl group. The alkyl group represented by $R^{10}$ is preferably an alkyl group having a carbon number of 1 to 10. The alkyl group represented by $R^{10}$ may be linear or branched, or may have a ring structure.
Among the alkyl groups, a methyl group or a cyclohexyl group is preferable.
In a case where $R^{10}$ in $-NR^{10}-$ represents an aryl group, the aryl group is preferably an aryl group having a carbon number of 6 to 30, more preferably an aryl group having a carbon number of 6 to 20, and even more preferably an aryl group having a carbon number of 6 to 12. These aryl groups may have a substituent.
In Formula (7), $R^{11}$ to $R^{18}$ preferably each independently represent a hydrogen atom, $-R^a$, $-OR^b$, $-SR^c$, or $-NR^dR^e$.
The hydrocarbon group represented by $R^a$ to $R^e$ is preferably a hydrocarbon group having a carbon number of 1 to 30, more preferably a hydrocarbon group having a carbon number of 1 to 15, and even more preferably a hydrocarbon group having a carbon number of 1 to 10.
The hydrocarbon group may be linear or branched or may have a ring structure.
As the hydrocarbon group, an alkyl group is particularly preferable.
The aforementioned alkyl group is preferably an alkyl group having a carbon number of 1 to 30, more preferably an alkyl group having a carbon number of 1 to 15, and even more preferably an alkyl group having a carbon number of 1 to 10.
The alkyl group described above may be linear or branched, or may have a ring structure.
Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.
Among these alkyl groups, a methyl group, an ethyl group, a propyl group, or a butyl group is preferable.
The alkyl group described above may have a substituent.
Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, groups obtained by combining these, and the like.
$R^{11}$ to $R^{14}$ in Formula (7) preferably each independently represent a hydrogen atom or $-R^a$ (that is, a hydrocarbon group), more preferably each independently represent a hydrogen atom or an alkyl group, and even more preferably each independently represent a hydrogen atom except in the cases described below.
Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.
Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.
In Formula (7), $n_{13}$ is preferably 1, and $R^{16}$ is preferably $-R^a$ (that is, a hydrocarbon group).
Furthermore, it is preferable that $R^{16}$ be linked to $R^{12}$ bonded to the carbon atom, to which $A_1^+$ is bonded, to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.
In Formula (7), $n_{14}$ is preferably 1, and $R^{18}$ is preferably $-R^a$ (that is, a hydrocarbon group).
In addition, it is preferable that $R^{18}$ be linked to $R^{14}$ bonded to the carbon atom, to which $A_2$ is bonded, to form a

ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula (7) be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula (7) be the same group. In addition, $R^{15}$ and $R^{17}$ are preferably $-R^a$ (that is, a hydrocarbon group), more preferably an alkyl group, and even more preferably a substituted alkyl group.

From the viewpoint of improving water solubility, $R^{15}$ and $R^{17}$ in the compound represented by Formula (7) are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}-R^{W1} \qquad (a1)$$

$$-R^{W2}-CO_2M \qquad (a2)$$

$$-R^{W3}-PO_3M_2 \qquad (a3)$$

$$-R^{W4}-SO_3M \qquad (a4)$$

In Formula (a1) to Formula (a4), $R^{W0}$ represents an alkylene group having a carbon number of 2 to 6, W represents a single bond or an oxygen atom, and $n_{W1}$ represents an integer of 1 to 45, $R^{W1}$ represents an alkyl group having a carbon number of 1 to 12 or $-C(=O)-R^{W5}$, $R^{W5}$ represents an alkyl group having a carbon number of 1 to 12, $R^{W2}$ to $R^{W4}$ each independently represent a single bond or an alkylene group having a carbon number of 1 to 12, and M represents a hydrogen atom, a sodium atom, a potassium atom, or an onium group.

Specific examples of the alkylene group represented by $R^{W0}$ in Formula (a1) include an ethylene group, an n-propylene group, an isopropylene group, an n-butylene group, an isobutylene group, an n-pentylene group, an isopentylene group, an n-hexyl group, an isohexyl group, and the like. Among these, an ethylene group, an n-propylene group, an isopropylene group, or an n-butylene group is preferable, and an n-propylene group is particularly preferable.

$n_{W1}$ is preferably 1 to 10, more preferably 1 to 5, and particularly preferably 1 to 3.

Specific examples of the alkyl group represented by $R^{W1}$ include a methyl group, an ethyl group, an n-propyl group, an isopropyl group, an n-butyl group, an isobutyl group, a tert-butyl group, an n-pentyl group, an isopentyl group, a neopentyl group, an n-hexyl group, an n-octyl group, an n-dodecyl group, and the like. Among these, a methyl group, an ethyl group, an n-propyl group, an isopropyl group, an n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferred aspects of the alkyl group represented by $R^{W5}$ are the same as preferred aspects of the alkyl group represented by $R^{W1}$.

Specific examples of the group represented by Formula (a1) will be shown below. However, the present disclosure is not limited thereto. In the following structural formulas, Me represents a methyl group, Et represents an ethyl group, and * represents a bonding site.

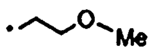 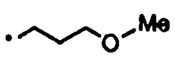 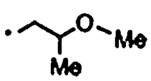 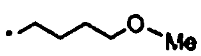 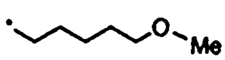

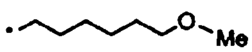 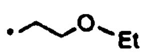 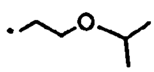 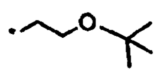

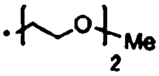 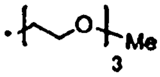 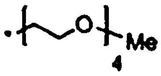 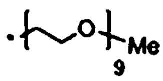 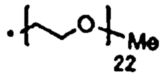

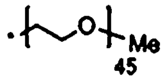 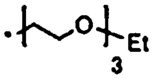 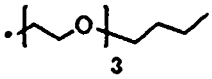 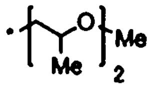 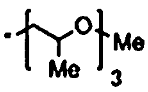

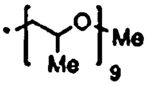 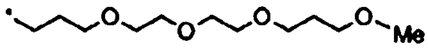

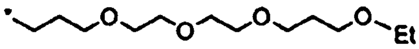 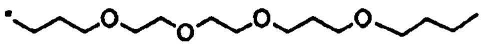

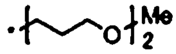 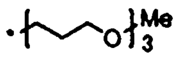 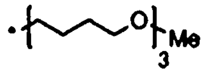

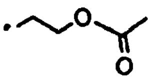 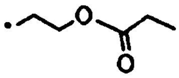 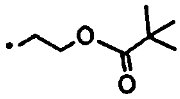 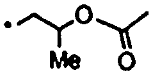 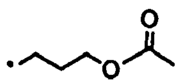

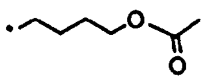 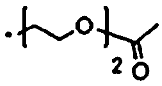 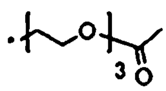 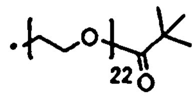

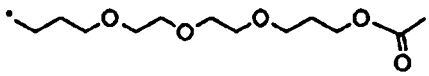

Specific examples of the alkylene group represented by $R^{W2}$ to $R^{W4}$ in Formula (a2) to Formula (a4) include a methylene group, an ethylene group, an n-propylene group, an isopropylene group, an n-butylene group, an isobutylene group, an n-pentylene group, an isopentylene group, an n-hexyl group, an isohexyl group, an n-octylene group, an n-dodecylene group, and the like. Among these, an ethylene group, an n-propylene group, an isopropylene group, or an n-butylene group is preferable, and an ethylene group or an n-propylene group is particularly preferable.

In Formula (a3), two Ms may be the same as or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula (7).

Among the groups represented by Formula (a1) to Formula (a4), the group represented by Formula (a1), Formula (a2), or Formula (a4) is preferable.

$n_{11}$ and $n_{12}$ in Formula (7) are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula (7) each independently represent an oxygen atom, a sulfur atom, or a nitrogen atom. Among these, a nitrogen atom is preferable.

$A_1$ and $A_2$ in Formula (7) are preferably the same atoms.

Za in Formula (7) represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine colorant represented by Formula (7) has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, a sulfonium ion, and the like. Among these, a sodium ion, a potassium ion, an ammonium ion, a pyridinium ion, or a sulfonium ion is preferable, and a sodium ion, a potassium ion, or an ammonium ion is more preferable.

From the viewpoint of visibility, the infrared absorber is preferably a compound represented by Formula (8).

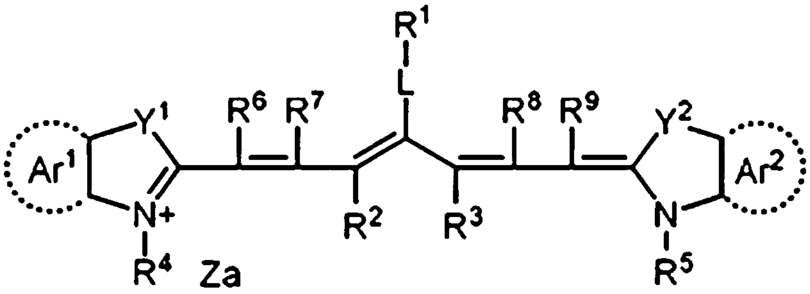

(8)

In Formula (8), $R^1$ represents a group that cleaves an $R^1$-L bond by exposure to infrared, $R^2$ and $R^3$ each independently represent a hydrogen atom or an alkyl group and may be linked to each other to form a ring, $Ar^1$ and $Ar^2$ each independently represent a group that forms a benzene ring or a naphthalene ring, $Y^1$ and $Y^2$ each independently represent an oxygen atom, a sulfur atom, $-NR^0-$, or a dialkylmethylene group, $R^0$ represents a hydrogen atom, an alkyl group, or an aryl group, $R^4$ and $R^5$ each independently represent an aliphatic hydrocarbon group, a $-CO_2M$ group, or a $-PO_3M_2$ group, M represents a hydrogen atom, a Na atom, a K atom, or an onium group, $R^6$ to $R^9$ each independently represent a hydrogen atom or an alkyl group, L represents an oxygen atom, a sulfur atom, or $-NR^{10}-$, $R^{10}$ represents a hydrogen atom, an alkyl group, or an aryl group, and Za represents a counterion that neutralizes charge.

$R^1$, L, and Za in Formula (8) have the same meanings as $R^1$, L, and Za in Formula (7), and the same applies to the preferred aspects thereof.

$Ar^1$ and $Ar^2$ each independently represent a group forming a benzene ring or a naphthalene ring. The benzene ring and the naphthalene ring may have a substituent other than -X. Examples of the substituent include an alkyl group, an alkoxy group, an aryloxy group, an amino group, an alkylthio group, an arylthio group, a carboxy group, a carboxylate group, a sulfo group, a sulfonate group, groups obtained by combining these, and the like. Among these, an alkyl group is preferable.

As the alkyl group as $R^2$ to $R^{10}$ and $R^0$, an alkyl group having 1 to 30 carbon atoms is preferable, an alkyl group having 1 to 15 carbon atoms is more preferable, and an alkyl group having 1 to 10 carbon atoms is still more preferable. The alkyl group described above may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is particularly preferable.

The alkyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and a group obtained by combining these groups.

The aryl group in $R^{10}$ and $R^0$ is preferably an aryl group having 6 to 30 carbon atoms, more preferably an aryl group having 6 to 20 carbon atoms, and still more preferably an aryl group having 6 to 12 carbon atoms.

The aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Specific examples of the aryl group include a phenyl group, a naphthyl group, a p-tolyl group, a p-chlorophenyl group, a p-fluorophenyl group, a p-methoxyphenyl group, a p-dimethylaminophenyl group, a p-methylthiophenyl group, a p-phenylthiophenyl group, and the like.

Among these aryl groups, a phenyl group, a p-methoxyphenyl group, a p-dimethylaminophenyl group, or a naphthyl group is preferable.

It is preferable that $R^2$ and $R^3$ be linked to each other to form a ring.

In a case where $R^2$ and $R^3$ are linked to each other to form a ring, the formed ring is preferably a 5- or a 6-membered ring and more preferably a 6-membered ring. In addition, the ring formed of $R^2$ and $R^3$ linked to each other is preferably a hydrocarbon ring which may have an ethylenically unsaturated bond.

$Y^1$ and $Y^2$ each independently represent an oxygen atom, a sulfur atom, $-NR^0-$, or a dialkylmethylene group, preferably $-NR^0-$ or a dialkylmethylene group, and more preferably a dialkylmethylene group.

$R^0$ represents a hydrogen atom, an alkyl group, or an aryl group. $R^0$ is preferably an alkyl group.

It is preferred that both $R^4$ and $R^5$ represent the same group.

$R^4$ and $R^5$ preferably each independently represent a linear alkyl group or an alkyl group having a sulfonate group on a terminal, and more preferably each independently represent a methyl group, an ethyl group, or a butyl group having a sulfonate group on a terminal.

The countercation of the aforementioned sulfonate group may be a cation on a nitrogen atom in Formula (8) or may be an alkali metal cation or an alkaline earth metal cation.

From the viewpoint of further improving water solubility of the compound represented by Formula (8), $R^4$ and $R^5$ preferably each independently represent an alkyl group having an anion structure, more preferably each independently represent an alkyl group having a carboxylate group or a sulfonate group, and even more preferably each independently represent an alkyl group having a sulfonate group on a terminal.

From the viewpoint of increasing the maximum absorption wavelength of the compound represented by Formula (8) and from the viewpoint of visibility and printing durability of the lithographic printing plate, $R^4$ and $R^5$ preferably each independently represent an alkyl group having an aromatic ring, more preferably each independently represent an alkyl group having an aromatic ring on a terminal, and particularly preferably each independently represent a 2-phenylethyl group, a 2-naphthalenylethyl group, or a 2-(9-anthracenyl)ethyl group.

$R^6$ to $R^9$ each independently represent a hydrogen atom or an alkyl group, and preferably each independently represent a hydrogen atom.

In addition, from the viewpoint of temporal stability and printing durability, the compound represented by Formula (8) preferably has one or more halogen atoms, more preferably has one or more halogen atoms in at least one selected from the group consisting of $R^1$, $Ar^1$, and $Ar^2$, and particularly preferably has one or more halogen atoms in each of $A^1$, $Ar^1$, and $Ar^2$.

Furthermore, from the viewpoint of temporal stability and printing durability, the compound represented by Formula (8) more preferably has two or more halogen atoms, still more preferably has three or more halogen atoms, and particularly preferably has three or more and six or fewer halogen atoms.

Preferred examples of the aforementioned halogen atoms include a chlorine atom and a bromine atom.

Furthermore, from the viewpoint of temporal stability and printing durability, the compound represented by Formula 1 preferably has a halogen atom in at least one of $Ar^1$ or $Ar^2$, more preferably has a chlorine atom or a bromine atom in at least one of $Ar^1$ or $Ar^2$, and particularly preferably has a bromine atom in at least one of $Ar^1$ or $Ar^2$.

As the infrared absorber and the infrared absorber that decomposes by exposure to infrared, those described in WO2020/262692A can also be suitably used.

As the infrared absorber that decomposes by exposure to infrared, those described in JP2008-544322A or WO2016/027886A can also be suitably used.

In addition, as the cyanine colorant which is a decomposition-type infrared absorber, the infrared absorbing compounds described in WO2019/219560A can be suitably used.

The infrared absorber may be used alone or in combination of two or more kinds thereof.

The total content of the infrared absorber in the image-recording layer with respect to the total mass of the image-recording layer is preferably 0.1% by mass to 10.0% by mass and more preferably 0.5% by mass to 5.0% by mass.

In addition, as the relationship between the borate compound (electron-donating polymerization initiator), the onium compound (electron-accepting polymerization initiator), and the infrared absorber, the relationship between HOMO and LUMO of each compound described in paragraphs 0081 to 0083 of WO2023/023681A is preferably mentioned.

Color forming substance precursor

It is preferable that the negative tone photosensitive image-recording layer contains a color forming substance precursor and is an on-press development type negative tone photosensitive image-recording layer.

From the viewpoint of color formability, the color forming substance precursor preferably includes an acid color forming agent. In addition, from the viewpoint of color formability, the color forming substance precursor preferably includes a leuco compound.

"Color forming substance precursor" used in the present disclosure means a compound having properties that form color by a stimulus such as light or acid and thus change the color of the image-recording layer. Furthermore, "acid color forming agent" means a compound having properties that form color by being heated in a state of receiving an

electron accepting compound (for example, a proton of an acid or the like) and thus change the color of the image-recording layer.

The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

Examples of the acid color developing agent, which is a preferred aspect of the color forming substance precursor, include the acid color developing agents described in paragraphs 0229 to 0236 of WO2020/262685A.

Particularly, from the viewpoint of color formability, the color forming agent used in the present disclosure is preferably at least one kind of compound selected from the group consisting of a spiropyran compound, a spirooxazine compound, a spirolactone compound, and a spirolactam compound.

From the viewpoint of visibility, the hue of the colorant after color forming is preferably green, blue, or black.

From the viewpoint of color formability and visibility of exposed portions, the acid color forming agent is preferably a leuco colorant.

The leuco colorant is not particularly limited as long as it has a leuco structure. The leuco colorant preferably has a spiro structure, and more preferably has a spirolactone ring structure.

From the viewpoint of color formability and visibility of exposed portions, the leuco colorant is preferably a leuco colorant having a phthalide structure or a fluoran structure.

Furthermore, from the viewpoint of color formability and visibility of exposed portions, the leuco colorant having a phthalide structure or a fluoran structure is preferably a compound represented by any of Formula (Le-1) to Formula (Le-3), and more preferably a compound represented by Formula (Le-2).

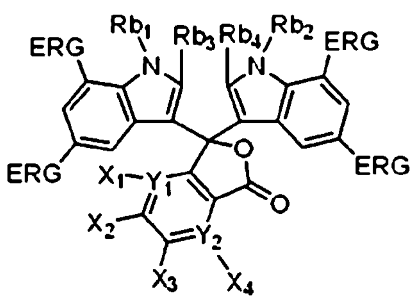

(Le-1)

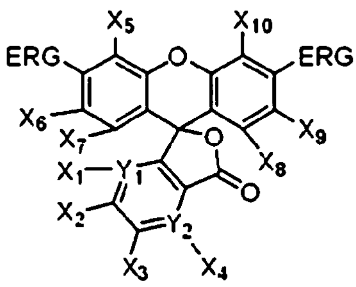

(Le-2)

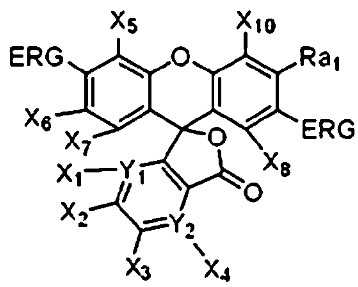

(Le-3)

In Formula (Le-1) to Formula (Le-3), ERG's each independently represent an electron-donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoint of color formability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoints of color formability and visibility of exposed portions, the electron-donating group represented by ERG is preferably a disubstituted amino group having an aryl group that has a substituent on at least one ortho position or a heteroaryl group that has a substituent on at least one ortho position, more preferably a disubstituted amino group having a phenyl group having a substituent on at least one ortho position and an electron-donating group at a para position, even more preferably an amino group having a phenyl group having a substituent on at least one ortho position and an electron-donating group at a para position, and an aryl group or a heteroaryl group, and particularly preferably an amino group having a phenyl group having a substituent on at least one ortho position and an electron-donating group at a para position, and an aryl group having an electron-donating group or a heteroaryl group having an electron-donating

group.

In the present disclosure, in a case where a bonding position of an aryl group or a heteroaryl group with other structures is defined as position 1, the ortho position in the aryl group or heteroaryl group other than a phenyl group is called a bonding position (for example, position 2 or the like) adjacent to the position 1.

Furthermore, from the viewpoints of color formability and visibility of exposed portions, the electron-donating group that the aryl group or heteroaryl group has is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoints of color formability and visibility of exposed portions, $X_1$ to $X_4$ in Formula (Le-1) to Formula (Le-3) each independently are preferably a hydrogen atom or a chlorine atom, and more preferably each independently represent a hydrogen atom.

From the viewpoints of color formability and visibility of exposed portions, $X_5$ to $X_{10}$ in Formula (Le-2) or Formula (Le-3) each independently are preferably a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably a hydrogen atom, a halogen atom, an alkyl group, an aryl group, an alkoxy group, or an aryloxy group, even more preferably a hydrogen atom, a halogen atom, an alkyl group, or an aryl group, and particularly preferably a hydrogen atom.

From the viewpoints of color formability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoints of color formability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoints of color formability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

In addition, from the viewpoints of color formability and visibility of exposed portions, the leuco colorant having a phthalide structure or a fluoran structure is more preferably a compound represented by any of Formula (Le-4) to Formula (Le-6), and even more preferably a compound represented by Formula (Le-5).

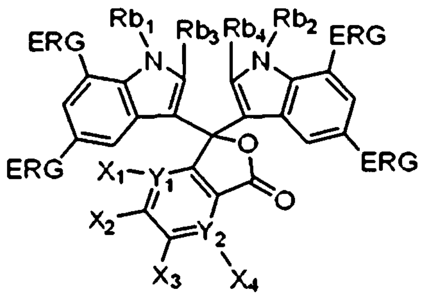

(Le - 4)

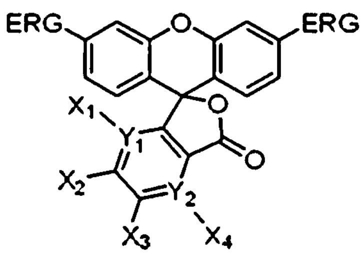

(Le - 5)

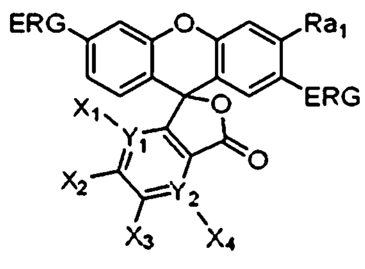

(Le - 6)

In Formula (Le-4) to Formula (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoints of color formability and visibility of exposed portions, the leuco colorant having a phthalide structure or a fluoran structure is even more preferably a compound represented by any of Formula (Le-7) to Formula (Le-9), and particularly preferably a compound represented by Formula (Le-8).

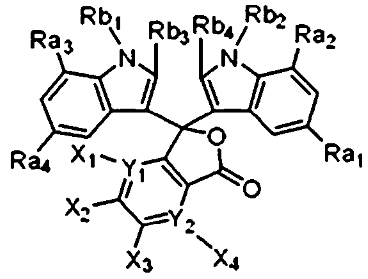

(Le-7)

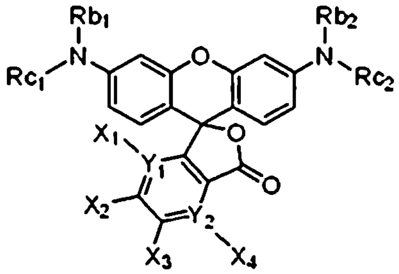

(Le-8)

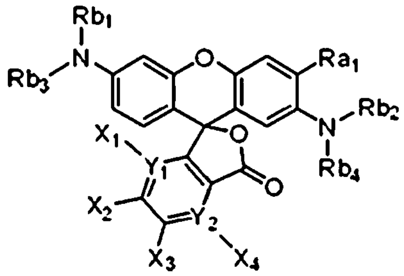

(Le-9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoints of color formability and visibility of exposed portions, $Ra_1$ to $Ra_4$ in Formula (Le-7) or Formula (Le-9) each independently are preferably an alkyl group or an alkoxy group, more preferably an alkoxy group, and particularly preferably represent a methoxy group.

From the viewpoints of color formability and visibility of exposed portions, $Rb_1$ to $Rb_4$ in Formula (Le-7) to Formula (Le-9) each independently are preferably a hydrogen atom, an alkyl group, or an aryl group substituted with an alkoxy group, more preferably an alkyl group, and particularly preferably a methyl group.

From the viewpoints of color formability and visibility of exposed portions, $Rc_1$ and $Rc_2$ in Formula (Le-8) each independently are preferably a phenyl group or an alkylphenyl group, and more preferably a phenyl group.

From the viewpoints of color formability and visibility of exposed portions, $Rc_1$ and $Rc_2$ in Formula (Le-8) each independently are preferably an aryl group having a substituent on at least one ortho position or a heteroaryl group having a substituent on at least one ortho position, more preferably an aryl group having a substituent on at least one ortho position, even more preferably a phenyl group having a substituent on at least one ortho position, and particularly preferably a phenyl group having a substituent on at least one ortho position and having an electron-donating group at the para position. Examples of the substituent in $Rc_1$ and $Rc_2$ include substituents that will be described later.

In Formula (Le-8), from the viewpoints of color formability and visibility of exposed portions, it is preferable that $X_1$ to $X_4$ are a hydrogen atom, and $Y_1$ and $Y_2$ are C.

Furthermore, from the viewpoints of color formability and visibility of exposed portions, in Formula (Le-8), $Rb_1$ and $Rb_2$ each independently are preferably an alkyl group or an aryl group substituted with an alkoxy group.

Moreover, from the viewpoints of color formability and visibility of exposed portions, in Formula (Le-8), $Rb_1$ and $Rb_2$ each independently are preferably an aryl group or a heteroaryl group, more preferably an aryl group, even more preferably an aryl group having an electron-donating group, and particularly preferably a phenyl group having an electron-donating group at the para position.

From the viewpoints of color formability and visibility of exposed portions, the electron-donating group in $Rb_1$, $Rb_2$, $Rc_1$, and $Rc_2$ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

In addition, from the viewpoints of the color formability and the visibility of the exposed portion, it is also preferable that the acid color forming agent includes one or more compounds selected from the group consisting of a compound represented by Formula (Le-10) and a compound represented by Formula (Z-4).

That is, it is preferable that the image-recording layer in the lithographic printing plate precursor according to the present disclosure further contains one or more compounds selected from the group consisting of a compound represented by Formula (Le-10) and a compound represented by Formula (Z-4).

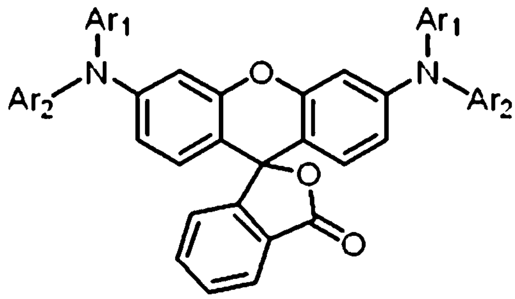

( Le - 10 )

In Formula (Le-10), $Ar_1$'s each independently represent an aryl group or a heteroaryl group, and $Ar_2$'s each independently represent an aryl group having a substituent on at least one ortho position or a heteroaryl group having a substituent on at least one ortho position.

$Ar_1$ in Formula (Le-10) has the same definition as $Rb_1$ and $Rb_2$ in Formula (Le-7) to Formula (Le-9), and preferred aspects thereof are also the same.

$Ar_2$ in Formula (Le-10) has the same definition as $Rc_1$ and $Rc_2$ in Formula (Le-7) to Formula (Le-9), and preferred aspects thereof are also the same.

The alkyl group in Formula (Le-1) to Formula (Le-9) may be linear or branched or may have a ring structure.

The carbon number of the alkyl group in Formula (Le-1) to Formula (Le-9) is preferably 1 to 20, more preferably 1 to 8, even more preferably 1 to 4, and particularly preferably 1 or 2.

The carbon number of the aryl group in Formula (Le-1) to Formula (Le-10) is preferably 6 to 20, more preferably 6 to 10, and particularly preferably 6 to 8.

Specific examples of the aryl group in Formula (Le-1) to Formula (Le-10) include a phenyl group, a naphthyl group, an anthracenyl group, a phenanthrenyl group, and the like which may have a substituent.

Specific examples of the heteroaryl group in Formula (Le-1) to Formula (Le-10) include a furyl group, a pyridyl group, a pyrimidyl group, a pyrazoyl group, a thiophenyl group, and the like which may have a substituent.

Each of the groups in Formula (Le-1) to Formula (Le-10), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. In addition, these substituents may be further substituted with these substituents.

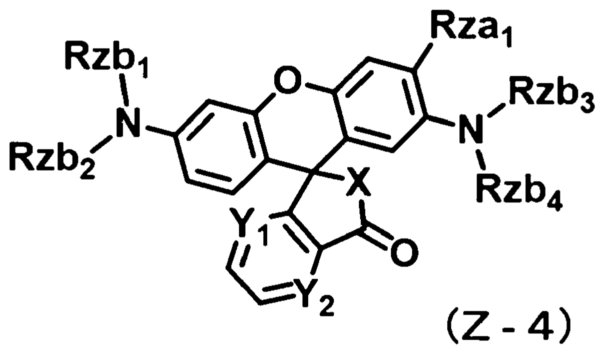

(Z - 4)

in Formula (Z-4), $Rza_1$ represents a hydrogen atom, an alkyl group, or an alkoxy group, $Rzb_1$ to $Rzb_4$ each independently represent a hydrogen atom, an alkyl group, or an aryl group, $Rzb_1$ and $Rzb_2$, and $Rzb_3$ and $Rzb_4$ may be linked to each other to form a ring structure, X represents O or NR, R represents a hydrogen atom, an alkyl group, an aryl group, or a heteroaryl group, and $Y_1$ and $Y_2$ each independently represent CH or N.

$Rza_1$ in Formula (Z-4) is preferably an alkyl group or an alkoxy group.

$Rzb_1$ and $Rzb_2$ in Formula (Z-4) are each independently preferably an alkyl group.

$Rzb_3$ and $Rzb_4$ in Formula (Z-4) each independently represent a hydrogen atom, an alkyl group, or an aryl group,

and it is preferable that one of them represents an aryl group.

X in Formula (Z-4) is preferably O, and $Y_1$ and $Y_2$ are preferably CH.

The alkyl group in Formula (Z-4) may be linear or branched or may have a ring structure.

The number of carbon atoms in the alkyl group in Formula (Z-4) is preferably 1 to 20, more preferably 1 to 8, and even more preferably 1 to 5.

The number of carbon atoms in the aryl group in Formula (Z-4) is preferably 6 to 20, more preferably 6 to 10, and particularly preferably 6 to 8.

Each of the groups such as the alkyl group and the aryl group in Formula (Z-4) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, a cyano group, and the like. In addition, these substituents may be further substituted with these substituents.

In addition, examples of the leuco colorant having the above-described phthalide structure or fluoran structure, which is suitably used, include the acid color forming agent described in paragraphs "0160" to "0168" of WO2023/032681A.

Furthermore, suitable examples of the acid color forming agent also include the following compounds.

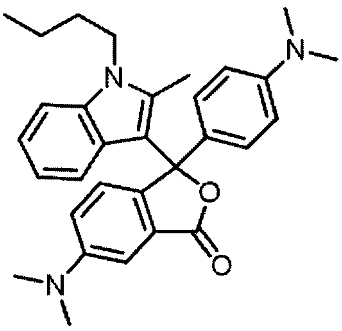

As the color forming agent, a commercially available product can be used, and examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by HODOGAYA CHEMICAL Co., LTD.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), and Crystal Violet Lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these products form a film having excellent visible light absorbance.

Each of these color forming agents may be used alone. Alternatively, two or more components can be used in combination.

The content of the color forming agent with respect to the total mass of the image-recording layer is preferably 0.5% by mass to 10% by mass, and more preferably 1% by mass to 5% by mass.

Polymer particles

The negative tone photosensitive image-recording layer preferably contains polymer particles and is an on-press development type image-recording layer.

In a case where the image-recording layer contains polymer particles, it is expected that the printing durability is further improved and the on-press developability is further improved.

The polymer particles (hereinafter, also referred to as polymer particles) are preferably selected from the group consisting of thermoplastic resin particles, thermally reactive resin particles, polymer particles having a polymerizable group, microcapsules encapsulating a hydrophobic compound, and microgel (crosslinked polymer particles). Among these, polymer particles having a polymerizable group or a microgel are preferable. In a particularly preferable embodiment, the polymer particles have at least one ethylenically unsaturated polymerizable group. The presence of such polymer particles brings about effects of improving the printing durability of an exposed portion and improving the on-press developability of a non-exposed portion.

From the viewpoints of printing durability and on-press developability, the polymer particles are preferably

thermoplastic resin particles.

The thermoplastic resin particles are preferably the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, and the like, or mixtures of these. Preferred examples thereof can include polystyrene, copolymers having styrene and acrylonitrile, or polymethyl methacrylate. The average particle diameter of the thermoplastic resin particle is preferably 0.01 $\mu$m to 3.0 $\mu$m.

Examples of the thermal reactive resin particles include polymer particles having a thermal reactive group. The thermal reactive polymer particles form a hydrophobilized region through crosslinking by a thermal reaction and the accompanying change in functional groups.

The thermal reactive group in the polymer particles having a thermal reactive group may be a functional group that causes any reaction as long as chemical bonds are formed, and is preferably a polymerizable group. Preferred examples thereof include an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating at least some of the constituent components of the image-recording layer as described in JP2001-277740A and JP2001-277742A. The constituent components of the image-recording layer can also be contained in the exterior of the microcapsules. In a preferred aspect, the image-recording layer containing microcapsules is constituted such that hydrophobic constituent components are encapsulated in the microcapsules and hydrophilic constituent components are contained in the exterior of the microcapsules.

The microgel (crosslinked polymer particles) can contain some of the constituent components of the image-recording layer, in at least one of the surface or the interior of the microgel. From the viewpoints of sensitivity of the lithographic printing plate precursor to be obtained and printing durability of the lithographic printing plate to be obtained, a reactive microgel having a radically polymerizable group on the surface thereof is particularly preferable.

In order to encapsulate the constituent components of the image-recording layer in microcapsules or microgels, known methods can be used.

From the viewpoints of printing durability, antifouling property, and storage stability of the lithographic printing plate to be obtained, the polymer particles are preferably polymer particles which are obtained by a reaction of a polyvalent isocyanate compound that is an adduct of a polyhydric phenol compound having two or more hydroxy groups in a molecule and isophorone diisocyanate with a compound having active hydrogen.

The polyhydric phenol compound is preferably a compound having a plurality of benzene rings having a phenolic hydroxy group.

The compound having active hydrogen is preferably a polyol compound or a polyamine compound, more preferably a polyol compound, and even more preferably at least one compound selected from the group consisting of propylene glycol, glycerin, and trimethylolpropane.

Preferred examples of the resin particles obtained by the reaction of a polyvalent isocyanate compound that is an adduct of a polyhydric phenol compound having two or more hydroxy groups in a molecule and isophorone diisocyanate, with a compound having active hydrogen include the polymer particles described in paragraphs "0032" to "0095" of JP2012-206495A.

Furthermore, from the viewpoint of printing durability and solvent resistance of the lithographic printing plate to be obtained, the polymer particles preferably have a hydrophobic main chain and include both i) constitutional unit having a pendant cyano group directly bonded to the hydrophobic main chain and ii) constitutional unit having a pendant group including a hydrophilic polyalkylene oxide segment.

Preferred examples of the hydrophobic main chain include an acrylic resin chain.

Preferred examples of the pendant cyano group include $-[CH_2CH(C{\equiv}N-]-$ or - $[CH_2C(CH_3)(C{\equiv}N)]-$.

In addition, the constitutional unit having the pendant cyano group can be easily derived from an ethylenically unsaturated monomer, for example, acrylonitrile or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10

to 100, more preferably 25 to 75, and even more preferably 40 to 50.

As the resin particles having a hydrophobic main chain and including both i) constitutional unit having the pendant cyano group directly bonded to the hydrophobic main chain and ii) constitutional unit having a pendant group including the hydrophilic polyalkylene oxide segment, for example, the particles described in paragraphs "0039" to "0068" of JP2008-503365A are preferable.

From the viewpoints of printing durability and on-press developability, the polymer particles preferably have a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

Among these, from the viewpoints of on-press developability and printing durability, a polyalkylene oxide structure is preferable, and a polyethylene oxide structure, a polypropylene oxide structure, or a poly(ethylene oxide/-propylene oxide) structure is more preferable.

In addition, from the viewpoints of on-press developability and suppressing the residues of development during on-press development, the polyalkylene oxide structure preferably has a polypropylene oxide structure, and more preferably has a polyethylene oxide structure and a polypropylene oxide structure.

From the viewpoints of printing durability, receptivity, and on-press developability, the hydrophilic group preferably has a constitutional unit having a cyano group, or a group represented by Formula Z, more preferably has a constitutional unit represented by Formula (AN) or a group represented by Formula Z, and particularly preferably has a group represented by Formula Z.

*-Q-W-Y Formula Z

In Formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

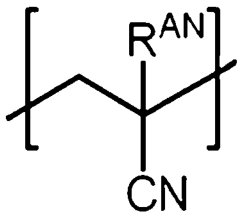

( AN )

In Formula (AN), $R^{AN}$ represents a hydrogen atom or a methyl group.

From the viewpoint of printing durability, the polymer contained in the polymer particles preferably has a constitutional unit formed of a compound having a cyano group.

Generally, it is preferable that a cyano group is introduced as a constitutional unit having a cyano group into a resin by using a compound (monomer) having a cyano group. Examples of the compound having a cyano group include acrylonitrile compounds and suitable examples thereof include (meth)acrylonitrile.

The constitutional unit having a cyano group is preferably a constitutional unit formed of an acrylonitrile compound, and more preferably a constitutional unit formed of (meth)acrylonitrile, that is, a constitutional unit represented by Formula (AN).

In a case where the polymer includes a polymer having a constitutional unit having a cyano group, from the viewpoint of printing durability, the content of the constitutional unit having a cyano group which is preferably a constitutional unit represented by Formula (AN) in the polymer having the constitutional unit having a cyano group with respect to the total mass of the polymer having the constitutional unit having a cyano group is preferably 5% by mass to 90% by mass, more preferably 20% by mass to 80% by mass, and particularly preferably 30% by mass to 60% by mass.

In addition, from the viewpoints of printing durability, receptivity, and on-press developability, the polymer particles preferably include polymer particles having a group represented by Formula Z.

Q in Formula Z is preferably a divalent linking group having 1 to 20 carbon atoms, and more preferably a divalent linking group having 1 to 10 carbon atoms.

In addition, Q in Formula Z is preferably an alkylene group, an arylene group, an ester bond, an amide bond, or a

group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having a carbon number of 6 to 120, a haloalkylene group having a carbon number of 6 to 120, an arylene group having a carbon number of 6 to 120, an alkarylene group having a carbon number of 6 to 120 (divalent group formed by removing one hydrogen atom from an alkylaryl group), or an aralkylene group having a carbon number of 6 to 120.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group (alkylaryl group) having 7 to 120 carbon atoms, an aralkyl group having 7 to 120 carbon atoms, $-OR^{WB}$, $-C(=O)OR^{WB}$, or $-OC(=O)R:^{WB}$. $R^{WB}$ represents an alkyl group having 6 to 20 carbon atoms.

From the viewpoints of printing durability, receptivity, and on-press developability, in the polymer particles having a group represented by formula Z, W is preferably a divalent group having a hydrophilic structure, and it is more preferable that Q is a phenylene group, an ester bond, or an amide bond, W is a polyalkyleneoxy group, and Y is a polyalkyleneoxy group having a hydrogen atom or an alkyl group on a terminal.

From the viewpoints of printing durability and on-press developability, the polymer particles preferably include polymer particles having a polymerizable group, and more preferably include polymer particles having a polymerizable group on the particle surface.

Furthermore, from the viewpoint of printing durability, the polymer particles preferably include polymer particles having a hydrophilic group and a polymerizable group.

The polymerizable group may be a cationically polymerizable group or a radically polymerizable group and, from the viewpoint of reactivity, is preferably a radically polymerizable group.

The polymerizable group is not particularly limited as long as it is a polymerizable group, but from the viewpoint of reactivity, is preferably an ethylenically unsaturated group, more preferably a vinylphenyl group (styryl group), a (meth)acryloxy group, or a (meth)acrylamide group, and particularly preferably a (meth)acryloxy group.

In addition, the polymer in the polymer particles having a polymerizable group preferably has a constitutional unit having a polymerizable group.

The polymerizable group may be introduced into the surface of the polymer particles by a polymer reaction.

In addition, from the viewpoints of printing durability and on-press developability, the image-recording layer preferably contains, as the polymer particles, addition polymerization-type resin particles having a dispersible group which more preferably includes a group represented by Formula Z.

Furthermore, from the viewpoint of printing durability, receptivity, on-press developability, and suppression of the occurrence of development residues during on-press development, the polymer particles preferably contain a resin having a urea bond, more preferably contain a resin having a structure obtained by reacting at least an isocyanate compound represented by Formula (Iso) with water, and particularly preferably contain a resin that has a structure obtained by reacting at least an isocyanate compound represented by Formula (Iso) with water and has a polyethylene oxide structure and a polypropylene oxide structure as polyoxyalkylene structures. Furthermore, the particles containing the resin having a urea bond are preferably a microgel.

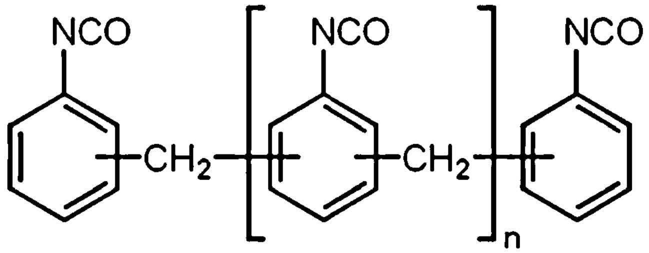

(Iso)

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water, the isocyanate group is partially hydrolyzed by water and generates an amino group. The generated amino group reacts with the isocyanate group and generates a urea bond, and a dimer is consequently formed. Furthermore, the following reaction is repeated to form a resin having a urea bond.

In the following reaction, by adding a compound (compound having active hydrogen) such as an alcohol compound or an amine compound reactive with an isocyanate group, it is possible to introduce the structure of an alcohol compound, an amine compound, or the like to the resin having a urea bond.

As the compound having active hydrogen, for example, the compounds described above regarding the microgel are preferable.

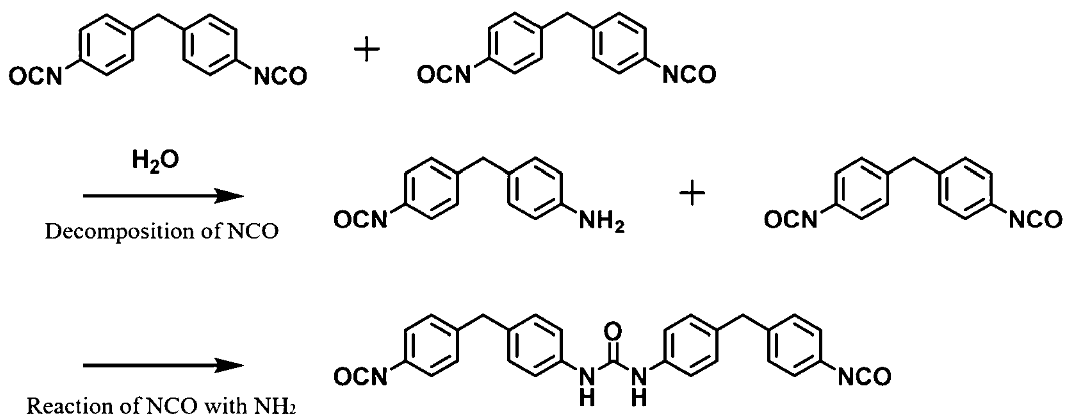


The resin having a urea bond preferably has an ethylenically unsaturated group, and more preferably has a group represented by Formula (PETA).

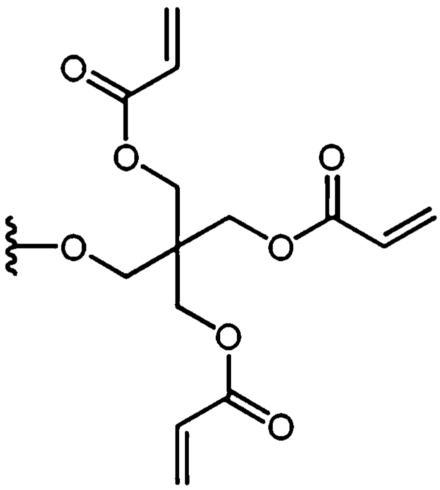

( PETA )

In Formula (PETA), the portion of the wavy line represents a binding position with other structures.

In addition, in a case where the image-recording layer is applied to on-press development type, it is preferable that the image-recording layer contains thermoplastic resin particles from the viewpoints of printing durability and on-press developability.

The thermoplastic resin contained in the thermoplastic resin particles is not particularly limited, and examples thereof include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, copolymers of these, and the like. The thermoplastic resin may be in the state of latex.

The thermoplastic resin according to the present disclosure is preferably a thermoplastic resin which melts or softens by heat generated in an exposure step that will be described later and thus forms a part or the entirety of a hydrophobic film forming the recording layer.

From the viewpoints of ink receptivity and printing durability, the thermoplastic resin preferably contains a resin A having a constitutional unit formed of an aromatic vinyl compound and a constitutional unit having a cyano group.

The resin A contained in the thermoplastic resin preferably has a constitutional unit formed of an aromatic vinyl

compound.

The aromatic vinyl compound may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these, for example, 1-vinylnaphthalene is preferable.

In addition, preferred examples of the constitutional unit formed of an aromatic vinyl compound include a constitutional unit represented by Formula A1.

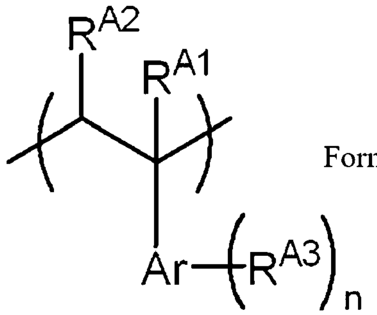

Formula A1

In Formula $A^1$, $R^{A1}$ and $R^{A2}$ each independently represent a hydrogen atom or an alkyl group, Ar represents an aromatic ring group, $R^{A3}$ represents a substituent, and n represents an integer of 0 or greater and equal to or less than the maximum number of substituents of Ar.

In Formula A1, $R^{A1}$ and $R^{A2}$ preferably each independently represent a hydrogen atom or an alkyl group having 1 to 4 carbon atoms, more preferably each independently represent a hydrogen atom or a methyl group, and even more preferably both represent a hydrogen atom.

In Formula $A^1$, Ar is preferably a benzene ring or a naphthalene ring, and more preferably a benzene ring.

In Formula $A^1$, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.

In a case where there is a plurality of $R^{A3}$'s in Formula A1, the plurality of $R^{A3}$'s may be the same as or different from each other.

In Formula $A^1$, n is preferably an integer of 0 to 2, more preferably 0 or 1, and even more preferably 0.

In the resin A contained in the thermoplastic resin, from the viewpoint of ink receptivity, the content of the constitutional unit formed of an aromatic vinyl compound is preferably higher than the content of the cyano group-containing constitutional unit that will be described later. The content of the constitutional unit formed of an aromatic vinyl compound with respect to the total mass of the thermoplastic resin is more preferably 15% by mass to 85% by mass, and even more preferably 30% by mass to 70% by mass.

The resin A contained in the thermoplastic resin particles preferably has a cyano group-containing constitutional unit.

Generally, it is preferable that a cyano group be introduced as a cyano group-containing constitutional unit into the resin A by using a cyano group-containing compound (monomer). Examples of the compound having a cyano group include acrylonitrile compounds and suitable examples thereof include (meth)acrylonitrile.

The cyano group-containing constitutional unit is preferably a constitutional unit formed of an acrylonitrile compound, and more preferably a constitutional unit formed of (meth)acrylonitrile.

As the constitutional unit formed of a cyano group-containing compound, for example, a constitutional unit represented by Formula B1 is preferable.

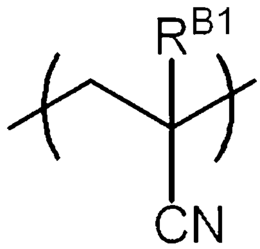

Formula B1

In Formula B1, $R^{B1}$ represents a hydrogen atom or an alkyl group.

In Formula B1, $R^{B1}$ is preferably a hydrogen atom or an alkyl group having 1 to 4 carbon atoms, more preferably a hydrogen atom or a methyl group, and even more preferably a hydrogen atom.

From the viewpoint of ink receptivity, the content of the cyano group-containing constitutional unit in the resin A is preferably less than the content of the constitutional unit formed of an aromatic vinyl compound described above. The content of the cyano group-containing constitutional unit with respect to the total mass of the resin A is preferably 55% by mass to 90% by mass, and more preferably 60% by mass to 85% by mass.

In a case where the resin A included in the thermoplastic resin has the constitutional unit formed of an aromatic vinyl compound and the cyano group-containing constitutional unit, the content ratio between the constitutional unit formed of an aromatic vinyl compound and the cyano group-containing constitutional unit (constitutional unit formed of aromatic vinyl compound:cyano group-containing constitutional unit) is preferably 5:5 to 9:1 and more preferably 6:4 to 8:2 based on mass.

From the viewpoint of printing durability and chemical resistance, the resin A contained in the thermoplastic resin particles preferably further has a constitutional unit formed of an N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

Preferred examples of the constitutional unit formed of an N-vinyl heterocyclic compound include a constitutional unit represented by Formula C1.

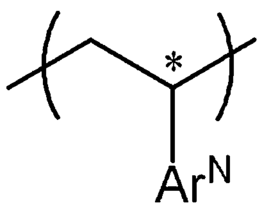

Formula C1

In Formula C1, $Ar^N$ represents a nitrogen atom-containing heterocyclic structure, and the nitrogen atom in $Ar^N$ is bonded to the carbon atom represented by *.

In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.

Furthermore, the heterocyclic structure represented by $Ar^N$ may have a known substituent.

In the resin A, the content of the constitutional unit formed of an N-vinyl heterocyclic compound with respect to the total mass of the resin A is preferably 5% by mass to 50% by mass, and more preferably 10% by mass to 40% by mass.

The resin A contained in the thermoplastic resin particles may contain an acidic group-containing constitutional unit. From the viewpoint of on-press developability and ink receptivity, it is preferable that the resin A does not contain an acidic group-containing constitutional unit.

Specifically, in the thermoplastic resin, the content of the acidic group-containing constitutional unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

In the present disclosure, the acid value is determined by the measurement method based on JIS K0070: 1992.

From the viewpoint of ink receptivity, the resin A contained in the thermoplastic resin particles may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate

compound, an aryl (meth)acrylate compound, or an aralkyl (meth)acrylate compound is preferable, and a constitutional unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth) acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may further have a known substituent. Preferred examples of the aryl (meth) acrylate compound include phenyl (meth)acrylate.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. Preferred examples of the aralkyl (meth)acrylate compound include benzyl (meth)acrylate.

In the resin A contained in the thermoplastic resin particles, the content of the hydrophobic group-containing constitutional unit with respect to the total mass of the resin A is preferably 5% by mass to 50% by mass, and more preferably 10% by mass to 30% by mass.

From the viewpoints of printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

From the viewpoints of printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

In addition, from the viewpoint of on-press developability, among the hydrophilic groups, as a polyalkylene oxide structure, groups having a polypropylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, the hydrophilic group is preferably a group represented by Formula Z.

From the viewpoint of improving printing durability, chemical resistance, and on-press developability, the resin A contained in the thermoplastic resin particles preferably has a hydrophilic group-containing constitutional unit.

Examples of the hydrophilic group include -OH, -CN, $-CONR^1R^2$, $-NR^2COR^1$ ($R^1$ and $R^2$ each independently represent a hydrogen atom, an alkyl group, an alkenyl group, or an aryl group, $R^1$ and $R^2$ may be bonded to each other to form a ring), $-NR^3R^4$, $-N^+R^3R^4R^5X^-$ ($R^3$ to $R^5$ each independently represent an alkyl group of 1 to 8 carbon atoms, and $X^-$ represents a counteranion), a group represented by Formula PO, a hydrophilic group that the thermoplastic resin contained in the thermoplastic resin particles preferably has, and the like.

Among these hydrophilic groups, $-CONR^1R^2$ or a group represented by Formula PO is preferable, and a group represented by Formula PO is more preferable.

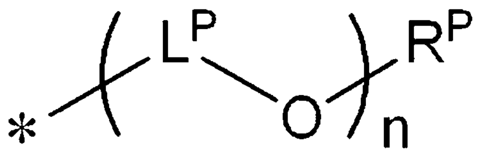

Formula PO

In Formula PO, $L^P$ each independently represent an alkylene group, $R^P$ represents a hydrogen atom or an alkyl group, and n represents an integer of 1 to 100.

In Formula PO, $L^P$ preferably each independently represent an ethylene group, a 1-methylethylene group, or a 2-methylethylene group, and more preferably each independently represent an ethylene group.

In Formula PO, $R^P$ is preferably a hydrogen atom or an alkyl group having a carbon number of 1 to 18, more

preferably a hydrogen atom or an alkyl group having a carbon number of 1 to 10, even more preferably a hydrogen atom or an alkyl group having a carbon number of 1 to 4, and particularly preferably a hydrogen atom or a methyl group.

In Formula PO, n is preferably an integer of 1 to 10, and more preferably an integer of 1 to 4.

In the resin A, the content of the hydrophilic group-containing constitutional unit with respect to the total mass of the resin A is preferably 5% by mass to 60% by mass, and more preferably 10% by mass to 30% by mass.

The resin A contained in the thermoplastic resin particles may further contain other constitutional units. The resin can contain, as those other constitutional units, constitutional units other than the constitutional units described above without particular limitations. Examples thereof include constitutional units formed of an acrylamide compound, a vinyl ether compound, and the like.

Examples of the acrylamide compound include (meth)acrylamide, N-methyl (meth)acrylamide, N-ethyl (meth) acrylamide, N-propyl (meth)acrylamide, N-butyl (meth)acrylamide, N,N'-dimethyl (meth)acrylamide, N,N'-diethyl (meth) acrylamide, N-hydroxyethyl (meth)acrylamide, N-hydroxypropyl (meth)acrylamide, N-hydroxybutyl (meth)acrylamide, and the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, phenoxypolyethylene glycol vinyl ether, and the like.

In the thermoplastic resin, the content of those other constitutional units with respect to the total mass of the thermoplastic resin is preferably 5% by mass to 50% by mass, and more preferably 10% by mass to 30% by mass.

From the viewpoints of printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two kinds of thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). As the glass transition temperature in the present specification, an extrapolated glass transition initiation temperature (hereinafter, may be referred to as Tig) is used.

The method of measuring the glass transition temperature will be described in more detail.

In a case of determining the glass transition temperature, the device is kept at a temperature approximately 50°C lower than the expected Tg of the resin until the device stabilizes. Then, the resin is heated at a heating rate of 20 °C/min to a temperature approximately 30°C higher than the temperature at which the glass transition ends, and a differential thermal analysis (DTA) curve or a DSC curve is created.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition changes stepwisely is maximum.

In a case where the thermoplastic resin particles contain two kinds of thermoplastic resins, Tg of the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents Tg of a second thermoplastic resin, and W2 represents the mass ratio of the second resin to the total mass of thermoplastic resin components in the thermoplastic resin particles, Tg0 (K) of the thermoplastic resin particles can be estimated according to the following FOX equation.

$$\text{FOX equation: } 1/Tg0 = (W1/Tg1) + (W2/Tg2)$$

In addition, in a case where the thermoplastic resin particles contain three or more kinds of resins or in a case where three or more kinds of thermoplastic resin particles each containing different types of thermoplastic resins are contained in a pretreatment liquid, similarly to the case described above, in a case where Tgn (K) represents Tg of nth resin and Wn represents the mass ratio of the nth resin to the total mass of resin components in the thermoplastic resin particles, Tg0 (K) of the thermoplastic resin particles can be estimated according to the following equation.

$$\text{FOX equation: } 1/Tg0 = (W1/Tg1) + (W2/Tg2) + (W3/Tg3) \cdots + (Wn/Tgn)$$

In the present disclosure, Tg is a value measured by a differential scanning calorimetry (DSC). As the differential scanning calorimeter (DSC), for example, EXSTAR 6220 manufactured by SII NanoTechnology Inc. can be used.

From the viewpoint of printing durability, the arithmetic mean particle diameter of the thermoplastic resin particles is preferably 1 nm or more and 200 nm or less, more preferably 3 nm or more and less than 80 nm, and even more preferably 10 nm or more and 49 nm or less.

Unless otherwise specified, the arithmetic mean particle diameter of the thermoplastic resin particles in the present disclosure refers to a value measured by a dynamic light scattering method (DLS). The measurement of the arithmetic mean particle diameter of the thermoplastic resin particles by DLS is carried out using Brookhaven BI-90 (manufactured by Brookhaven Instrument Company) according to the manual of the instrument.

The weight-average molecular weight of the thermoplastic resin contained in the thermoplastic resin particles is preferably 3,000 to 300,000, and more preferably 5,000 to 100,000.

The manufacturing method of the thermoplastic resin contained in the thermoplastic resin particles is not particularly limited, and the thermoplastic resin can be manufactured by known methods.

For example, the polymer is obtained by polymerizing a styrene compound, an acrylonitrile compound, and at least one kind of optional compound selected from the group consisting of the aforementioned N-vinyl heterocyclic compound, a compound used for forming the aforementioned ethylenically unsaturated group-containing constitutional unit, a compound used for forming the aforementioned acidic group-containing constitutional unit, a compound used for forming the aforementioned hydrophobic group-containing constitutional unit, and a compound used for forming the aforementioned other constitutional units by known methods.

Specific examples of the thermoplastic resin contained in the thermoplastic resin particles will be shown as follows, but the thermoplastic resin used in the present disclosure is not limited thereto.

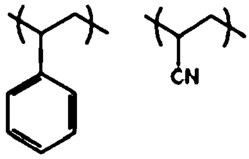
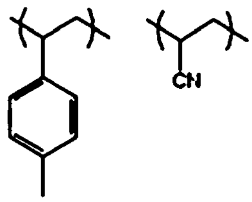

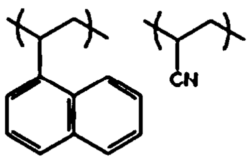
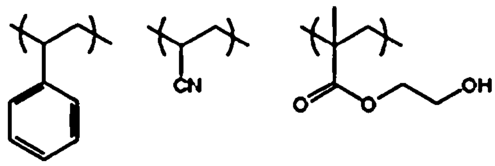

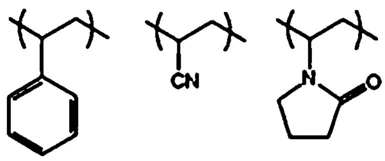

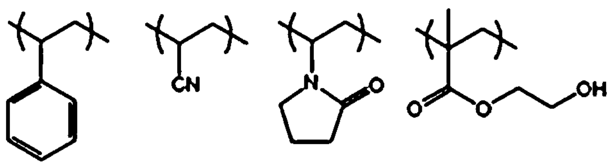

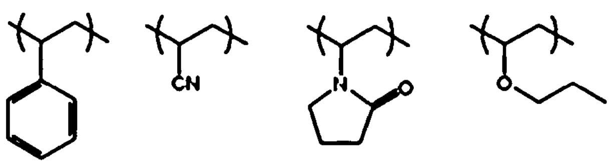

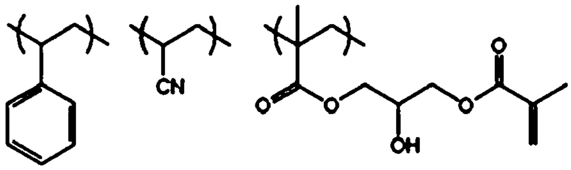

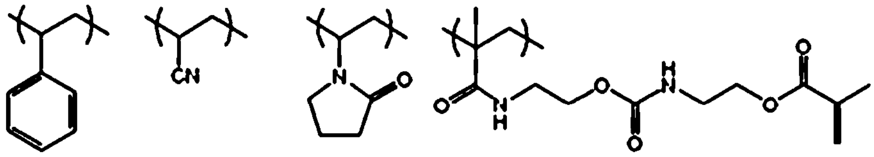

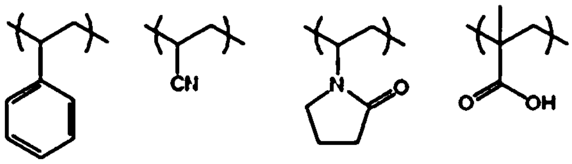

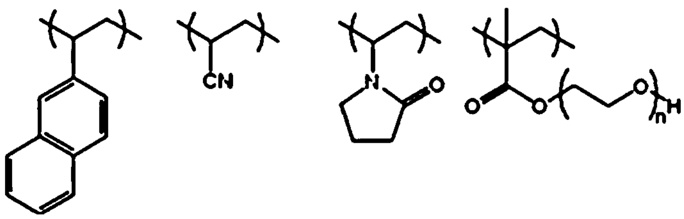

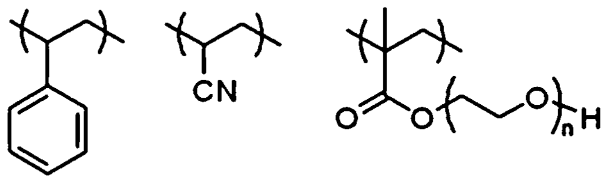

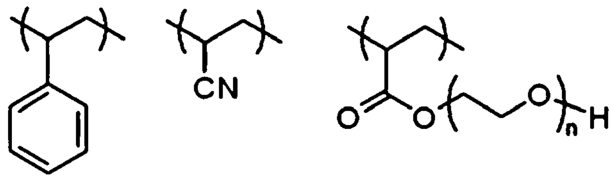

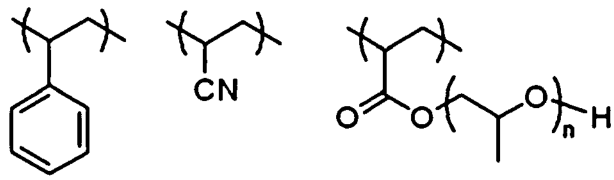

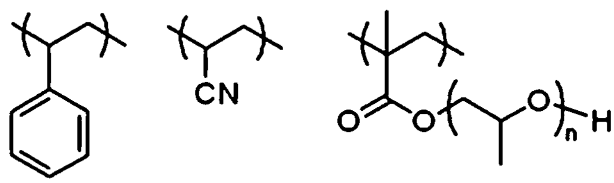

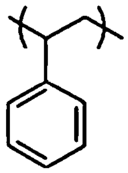 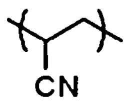 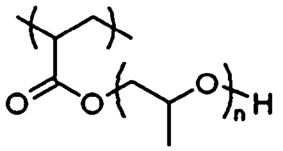 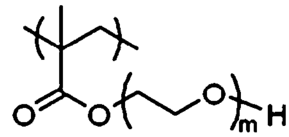

The content ratio of the constitutional units in the above specific examples can be appropriately changed according to the preferred range of the content of each of the constitutional units described above.

Furthermore, the weight-average molecular weight of each of the compounds shown in the above specific examples can be appropriately changed according to the preferred range of the weight-average molecular weight of the thermoplastic resin described above.

The average particle diameter of the particles is preferably 0.01 μm to 3.0 μm, more preferably 0.03 μm to 2.0 μm, and even more preferably 0.10 μm to 1.0 μm. In a case where the average particle diameter is in this range, excellent resolution and excellent temporal stability are obtained.

The average primary particle diameter of the particles in the present disclosure is obtained by measuring with a light scattering method or by imaging an electron micrograph of the particles, measuring the particle diameter of a total of 5,000 particles in the photograph, and calculating the average value thereof. For non-spherical particles, the value of particle diameter of spherical particles having the same area as the area of the particles on the photograph is adopted as the particle diameter.

Unless otherwise specified, the average particle diameter in the present disclosure means a volume average particle diameter.

In a case where the image-recording layer contains polymer particles, the image-recording layer may contain only one kind of polymer particles or may contain two or more kinds of polymer particles.

From the viewpoints of on-press developability and printing durability, the content of particles, particularly, the content of polymer particles in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

In addition, from the viewpoints of on-press developability and printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

Binder polymer

The image-recording layer may contain a binder polymer. As the binder polymer, a binder polymer used in the image-recording layer of the lithographic printing plate precursor can be used. Specifically, as the binder polymer, the binder polymer described in paragraphs "0288" to "0317" of WO2022/019217A can be suitably used.

In the image-recording layer, the binder polymer may be used alone or in combination of two or more kinds thereof.

The content of the binder polymer to be contained in the image-recording layer can be optionally set, and the content of the binder polymer with respect to the total mass of the image-recording layer is preferably 1% by mass to 90% by mass and more preferably 5% by mass to 80% by mass.

In a case where the image-recording layer of the present disclosure contains other binder polymers, the content of those other binder polymers with respect to the total mass of the aforementioned thermoplastic resin particles and those other binder polymers is preferably more than 0% by mass and 99% by mass or less, more preferably 20% by mass to 95% by mass, and even more preferably 40% by mass to 90% by mass.

Oil agent

It is also preferable that the image-recording layer contains an oil agent.

In the present disclosure, an oil agent refers to a hydrophobic compound that is in a liquid state at 80°C and is not mixed with water and separates in a case where the compound is mixed with water of the same mass.

In a case where two or more oil agents are used, the oil agents may include a compound having a melting point of 80°C or higher as long as the two or more oil agents are in a liquid state at 80°C in a mixed state.

In addition, from the viewpoint of on-press developability and dampening water turbidity suppressing property, the oil agent is preferably a compound having a molecular weight less than 1,000, more preferably a compound having a molecular weight of 200 to 800, and particularly preferably a compound having a molecular weight of 300 to 500.

Furthermore, from the viewpoint of on-press developability and dampening water turbidity suppressing property, the oil agent is preferably a compound having a boiling point of 200°C or higher at 1 atm, more preferably a compound having a boiling point of 250°C or higher at 1 atm, even more preferably a compound having a boiling point of 300°C or higher at 1 atm, and particularly preferably a compound having a boiling point of 400°C or higher and 500°C or lower at 1 atm.

In the present disclosure, unless otherwise specified, "boiling point" means a boiling point at 1 atm.

In addition, from the viewpoint of on-press developability and dampening water turbidity suppressing property, the melting point of the oil agent at 1 atm is preferably 50°C or lower, more preferably 30°C or lower, and particularly preferably -200°C or higher and 25°C or lower.

In the present disclosure, unless otherwise specified, "melting point" means a melting point at 1 atm.

Examples of the oil agent include a phosphoric acid ester compound, an aromatic hydrocarbon compound, a glyceride compound, a fatty acid compound, an aromatic ester compound, and the like.

Among the above, from the viewpoints of printing durability, receptivity, on-press developability, and dampening water turbidity suppressing property, at least one compound selected from the group consisting of a phosphoric acid ester compound, an aromatic hydrocarbon compound, a glyceride compound, and an aromatic ester compound is preferable, at least one compound selected from the group consisting of a phosphoric acid ester compound, an aromatic hydrocarbon compound, and a glyceride compound is more preferable, at least one compound selected from the group consisting of a phosphoric acid ester compound and an aromatic hydrocarbon compound is even more preferable, and a phosphoric acid ester compound is particularly preferable.

As the phosphoric acid ester compound, from the viewpoints of printing durability, receptivity, on-press developability, and dampening water turbidity suppressing property, a phosphoric acid triester compound is preferable, a phosphoric acid triaryl ester compound is more preferable, tricresyl phosphate is even more preferable, and a mixture of two or more isomers among three kinds of ortho, meta, and para isomers of tricresyl phosphate is particularly preferable.

As the aromatic hydrocarbon compound, from the viewpoint of on-press developability and dampening water turbidity suppressing property, a compound having two or more aromatic rings is preferable, and a compound having two or more unfused benzene rings is more preferable.

As the glyceride compound, from the viewpoint of on-press developability and dampening water turbidity suppressing property, a triglyceride compound is preferable, a fatty oil is more preferable, and a fatty oil which is a liquid at 25°C, such as castor oil, is particularly preferable.

As the fatty acid compound, from the viewpoint of on-press developability and dampening water turbidity suppressing property, an unsaturated fatty acid is preferable, an unsaturated fatty acid having a carbon number of 8 to 30 is more preferable, and an unsaturated fatty acid having a carbon number of 12 to 24 is particularly preferable.

As the aromatic ester compound, from the viewpoint of on-press developability and dampening water turbidity suppressing property, an aromatic diester compound is preferable, and an aromatic diester compound having an aliphatic ring is more preferable.

As the aliphatic ester compound, from the viewpoint of on-press developability and dampening water turbidity suppressing property, an aliphatic ester compound having a branched alkyl group is preferable, and an aliphatic ester compound having a branched alkyl group and a carbon number of 10 to 24 is more preferable.

From the viewpoints of printing durability, receptivity, on-press developability, and dampening water turbidity suppressing property, the oil agent preferably includes an oil agent having a phosphorus atom, and is more preferably an oil agent having a phosphorus atom.

In addition, from the viewpoint of on-press developability and dampening water turbidity suppressing property, the oil agent preferably includes an oil agent having an aromatic ring, more preferably includes an oil agent having two or more aromatic rings, and particularly preferably includes an oil agent having two or more unfused benzene rings.

From the viewpoints of printing durability, receptivity, on-press developability, and dampening water turbidity suppressing property, a ClogP value of the oil agent is preferably 5.0 or more, more preferably 5.50 or more, even more preferably 5.50 or more and 10.0 or less, and particularly preferably 5.60 or more and 7.00 or less.

The ClogP value is a value obtained by calculating the common logarithm logP of the 1-octanol/water partition coefficient P. For calculating the ClogP value, known methods and software can be used. In the present disclosure, unless otherwise specified, the ClogP program incorporated into ChemBioDraw Ultra 12.0 from CambridgeSoft is used.

Specific examples of the oil agent include tricresyl phosphate, dimethyl(1-phenylethyl) benzene, 2,4-diphenyl-4-methyl-1-pentene, dicyclohexylphthalate, castor oil, α-linolenic acid, tri(2-ethylhexyl) phosphate, and the like.

One oil agent may be used alone, or two or more oil agents may be used in combination. From the viewpoint of on-press developability and dampening water turbidity suppressing property, it is preferable that the image-recording layer contain two or more oil agents having different structures.

The content of the oil agent with respect to the total mass of the image-recording layer is preferably 0.0001% by mass to 10.0% by mass, more preferably 0.0002% by mass to 1.0% by mass, even more preferably 0.0005% by mass to 0.5% by mass, and particularly preferably 0.001% by mass to 0.05% by mass.

Chain transfer agent

The image-recording layer may contain a chain transfer agent. As the chain transfer agent, a chain transfer agent used in the image-recording layer of a lithographic printing plate precursor can be used. Specifically, as the chain transfer agent, the chain transfer agents described in paragraphs "0388" to "0393" of WO2022/019217A can be suitably used.
The chain transfer agent may be used alone or in combination of two or more kinds thereof.
The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

Sensitization agent

In order to improve the ink receptivity, the image-recording layer may contain an oil sensitizing agent. As the oil sensitizing agent, an oil sensitizing agent used in the image-recording layer of a lithographic printing plate precursor can be used. Specifically, as the oil sensitizing agent, the oil sensitizing agents described in paragraphs "0395" to "0404" of WO2022/019217A can be suitably used.
The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.
The image-recording layer may contain only one oil sensitizing agent, or two or more oil sensitizing agents may be used in combination.
One of the preferred aspects of the image-recording layer used in the present disclosure is an aspect in which the image-recording layer contains two or more compounds as an oil sensitizing agent.
Specifically, from the viewpoint of satisfying both the on-press developability and receptivity, the image-recording layer used in the present disclosure preferably uses all the phosphonium compound, the nitrogen-containing low-molecular-weight compound, and the ammonium group-containing polymer as an oil sensitizing agent, and more preferably uses all the phosphonium compound, the quaternary ammonium salts, and the ammonium group-containing polymer as an oil sensitizing agent.

Development accelerator

The image-recording layer preferably further contains a development accelerator.
The value of polarity element as an SP value of the development accelerator is preferably 6.0 to 26.0, more preferably 6.2 to 24.0, even more preferably 6.3 to 23.5, and particularly preferably 6.4 to 22.0.
In the present disclosure, as the value of polarity element as an SP value (solubility parameter, unit: $(cal/cm^3)^{1/2}$), the value of polarity element δp in the Hansen solubility parameters is used. The Hansen solubility parameters are obtained by dividing the solubility parameters introduced by Hildebrand into three components, a dispersion element δd, a polarity element δp, and a hydrogen bond element δh, and expressing the parameters in a three-dimensional space. In the present disclosure, the polarity element δp is used.
δp [$cal/cm^3$] is a dipole-dipole force element in the Hansen solubility parameters, V [$cal/cm^3$] is a molar volume, and μ [D] is a dipole moment. As δp, the following expression simplified by Hansen and Beerbower is generally used.

Expression 1

$$\delta_p = \frac{37.4\mu}{V^{1/2}}$$

The development accelerator is preferably a hydrophilic polymer compound or a hydrophilic low-molecular-weight compound.
In the present disclosure, "hydrophilic" means that the value of polarity element as an SP value is 6.0 to 26.0, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.
Examples of the hydrophilic polymer compound include a cellulose compound and the like. Among these, a

cellulose compound is preferable.

Examples of the cellulose compound include cellulose or a compound obtained by modifying at least a part of cellulose (modified cellulose compound). Among these, a modified cellulose compound is preferable.

Preferred examples of the modified cellulose compound include a compound which is obtained by substituting at least some of hydroxy groups of cellulose with at least one kind of group selected from the group consisting of an alkyl group and a hydroxyalkyl group.

The degree of substitution of the compound, which is obtained by substituting at least some of hydroxy groups of cellulose with at least one kind of group selected from the group consisting of an alkyl group and a hydroxyalkyl group, is preferably 0.1 to 6.0, and more preferably 1 to 4.

As the modified cellulose compound, an alkyl cellulose compound or a hydroxyalkyl cellulose compound is preferable, and a hydroxyalkyl cellulose compound is more preferable.

Preferred examples of the alkyl cellulose compound include methyl cellulose.

Preferred examples of the hydroxyalkyl cellulose compound include hydroxypropyl cellulose.

The molecular weight of the hydrophilic polymer compound (weight-average molecular weight in a case where the compound has molecular weight distribution) is preferably 3,000 to 5,000,000, and more preferably 5,000 to 200,000.

Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.

Examples of the glycol compound include glycols such as ethylene glycol, diethylene glycol, triethylene glycol, propylene glycol, dipropylene glycol, and tripropylene glycol, and ether or ester derivatives of these compounds.

Examples of the polyol compound include glycerin, pentaerythritol, tris(2-hydroxyethyl) isocyanurate, and the like.

Examples of the organic amine compound include triethanolamine, diethanolamine, monoethanolamine, salts of these, and the like.

Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.

Examples of the organic sulfuric acid compound include alkyl sulfate, alkyl ether sulfuric acid, salts of these, and the like.

Examples of the organic phosphonic acid compound include phenylphosphonic acid, salts thereof, and the like.

Examples of the organic carboxylic acid compound include tartaric acid, oxalic acid, citric acid, malic acid, lactic acid, gluconic acid, salts of these, and the like.

Examples of the betaine compound include a phosphobetaine compound, a sulfobetaine compound, a carboxybetaine compound, and the like. Among these, for example, trimethylglycine is preferable.

The molecular weight of the hydrophilic low-molecular-weight compound (weight-average molecular weight in a case where the compound has molecular weight distribution) is preferably 100 or more and less than 3,000, and more preferably 300 to 2,500.

The development accelerator is preferably a compound having a cyclic structure.

The cyclic structure is not particularly limited. Examples thereof include a glucose ring in which at least some of hydroxy groups may be substituted, an isocyanuric ring, an aromatic ring which may have a heteroatom, an aliphatic ring which may have a heteroatom, and the like. Among these, for example, a glucose ring or an isocyanuric ring is preferable.

Examples of the compound having a glucose ring include the aforementioned cellulose compound.

Examples of the compound having an isocyanuric ring include the aforementioned tris(2-hydroxyethyl) isocyanurate and the like.

Examples of the compound having an aromatic ring include the toluene sulfonic acid and benzene sulfonic acid described above, and the like.

Examples of the compound having an aliphatic ring include a compound which is the aforementioned alkyl sulfate and has an alkyl group having a ring structure, and the like.

The compound having a cyclic structure preferably has a hydroxy group.

Preferred examples of the compound having a hydroxy group and a cyclic structure include the aforementioned cellulose compound and the aforementioned tris(2-hydroxyethyl) isocyanurate.

The development accelerator is preferably an onium salt compound.

Examples of the onium salt compound include an ammonium compound, a sulfonium compound, and the like. Among these, an ammonium compound is preferable.

Examples of the development accelerator which is an onium salt compound include trimethylglycine and the like.

The value of polarity element as an SP value of the onium salt compound in the electron-accepting polymerization

initiator is not in a range of 6.0 to 26.0. This onium salt compound is not included in the development accelerator.

The image-recording layer may contain only one kind of development accelerator, or two or more kinds of development accelerators may be used in combination.

In the present disclosure, one of the preferred aspects of the image-recording layer is an aspect in which the image-recording layer contains two or more kinds of compounds as the development accelerator.

Specifically, from the viewpoint of on-press developability and receptivity, the image-recording layer preferably contains, as a development accelerator, the polyol compound and the betaine compound described above, the betaine compound and the organic sulfonic acid compound described above, or the polyol compound and the organic sulfonic acid compound described above.

The content of the development accelerator with respect to the total mass of the image-recording layer is preferably 0.1% by mass or more and 20% by mass or less, more preferably 0.5% by mass or more and 15% by mass or less, and even more preferably 1% by mass or more and 10% by mass or less.

Other components

As other components, a surfactant, a polymerization inhibitor, a higher fatty acid derivative, a plasticizer, inorganic particles, an inorganic lamellar compound, and the like can be incorporated into the image-recording layer. Specifically, the description in paragraphs "0114" to "0159" of JP2008-284817A can be referred to.

Formation of image-recording layer

In a case where the image-recording layer in the lithographic printing plate precursor according to the present disclosure is a negative tone image-recording layer, for example, as described in paragraphs 0142 and 0143 of JP2008-195018A, the image-recording layer can be formed by preparing a coating liquid by dispersing or dissolving the necessary components in a known solvent, coating a support with the coating liquid by a known method such as bar coating, and drying the coating liquid. The coating amount (solid content) of the image-recording layer after coating and drying varies with uses, but is preferably 0.3 $g/m^2$ to 3.0 $g/m^2$. In a case where the coating amount is in this range, excellent sensitivity and excellent film characteristics of the image-recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, ethyl lactate, and the like.

Only one solvent may be used, or two or more solvents may be used in combination. The concentration of solid contents in the coating liquid is preferably 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

The film thickness of the image-recording layer in the lithographic printing plate precursor according to the present disclosure is preferably 0.1 $\mu m$ to 3.0 $\mu m$, and more preferably 0.3 $\mu m$ to 2.0 $\mu m$.

In the present disclosure, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

Positive tone image-recording layer

The image-recording layer in the lithographic printing plate precursor according to the present disclosure may be a positive tone image-recording layer.

The positive tone image-recording layer contains at least a water-insoluble and alkali-soluble resin and an infrared absorber (for example, an IR dye) that absorbs light and generates heat.

Alkali-soluble resin

The positive tone image-recording layer contains an alkali-soluble resin.

In the present disclosure, the expression that the resin is "alkali-soluble" means that 0.01 g of the resin dissolves in 5 g of a sodium hydroxide aqueous solution at 30°C and a pH of 13.0 within 200 seconds. The dissolution refers to a state in which no remaining dissolved matter is visually confirmed.
Examples of the alkali-soluble resin include an acrylic resin, a novolac resin, a polyurea, a polyurethane, and a polycarbonate.
From the viewpoint of further improving development discrimination and printing durability, the alkali-soluble resin is preferably an acrylic resin or a novolac resin.
Hereinafter, preferred aspects of the alkali-soluble resin according to the present disclosure will be described.

Acrylic resin

As the alkali-soluble resin, for example, any compound known in the field of positive tone lithographic printing plate precursors can be used without particular limitation. Preferred examples of the alkali-soluble resin include the water-insoluble, alkali-soluble resins described in paragraphs [0025] to [0062] of JP2008-151929A.
Above all, an acrylic resin having a sulfonamide group in a side chain or an acrylic resin having a phenolic hydroxy group in a side chain is preferable.

Polyurea, polyurethane, and polycarbonate

In addition, a polyurea, a polyurethane, or a polycarbonate can also be suitably used as the alkali-soluble resin.
The polyurea, the polyurethane, or the polycarbonate preferably has an acid group, and from the viewpoint of printing durability and developability, the polyurea, the polyurethane, or the polycarbonate more preferably has a sulfonamide group in a main chain.
It is preferable that the polyurea, the polyurethane, or the polycarbonate has other acid groups in a side chain. The acid group in a side chain is preferably a phenolic hydroxyl group, a sulfonamide group, or a carboxy group.
Examples of these alkali-soluble resins include the compounds described in paragraphs [0083] to [0114] of JP2018-165797A, and the description thereof can be referred to in the present disclosure.

Novolac resin

Preferred examples of the alkali-soluble resin also include a novolac resin.
Preferred examples of the novolac resin that can be used in the positive tone photosensitive resin composition according to the present disclosure include a novolac resin such as a phenol formaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, and a pyrogallol acetone resin.
Furthermore, examples of the novolac resin also include a phenol-formaldehyde condensation polymer having an alkyl group having 3 to 8 carbon atoms as a substituent, such as a t-butylphenol formaldehyde resin and an octylphenol formaldehyde resin, as described in US4123279A.
The alkali-soluble resin is not particularly limited as long as it has a characteristic of being dissolved in an alkaline developer upon contact with the alkaline developer, and is preferably a resin having an acidic functional group such as a sulfonic acid group, a phosphoric acid group, a sulfonamide group, or an active imide group in at least one of a main chain or a side chain in a polymer, examples of which include a resin containing 10% by mole or more of such a monomer having an acidic functional group that imparts alkali solubility, with a resin containing 20% by mole or more of such a monomer having an acidic functional group that imparts alkali solubility being more preferred. In a case where the copolymerization component of the monomer that imparts alkali solubility is 10% by mole or more, alkali solubility is sufficiently obtained and developability is excellent.
The alkali-soluble resin is not particularly limited as long as it has a characteristic of being dissolved in an alkaline developer upon contact with the alkaline developer, and is preferably a resin having an acidic functional group such as a sulfonic acid group, a phosphoric acid group, a sulfonamide group, or an active imide group in at least one of a main chain or a side chain in a polymer, examples of which include a resin containing 10% by mole or more of such a monomer having an acidic functional group that imparts alkali solubility, with a resin containing 20% by mole or more of such a monomer having an acidic functional group that imparts alkali solubility being more preferred. In a case where the copolymerization component of the monomer that imparts alkali solubility is 10% by mole or more, alkali solubility is sufficiently obtained and developability is excellent.

Infrared absorber

The positive tone photosensitive resin composition contains an infrared absorber.

The infrared absorber is not particularly limited as long as it is a dye that absorbs infrared light to generate heat, and various dyes known as the infrared absorber can be used. Specific examples of the infrared absorber include the same ones as the infrared absorber in the negative tone image-recording layer.

Configuration of positive tone image-recording layer

In a case where the lithographic printing plate precursor according to the embodiment of the present disclosure has a positive tone image-recording layer, the positive tone image-recording layer can be formed by applying a positive tone photosensitive resin composition onto a support having a hydrophilic surface.
The image-recording layer may be of a single layer or may be an image-recording layer having a multi-layer structure with a lower layer and an upper layer in the vicinity of the support.
Further, it is preferable that the image-recording layer is an image-recording layer having a lower layer and an upper layer in this order from the support side, and at least one of the lower layer or the upper layer uses the positive tone photosensitive resin composition, and it is more preferable that the lower layer or the upper layer uses the positive tone photosensitive resin composition.
The image-recording layer in the positive tone lithographic printing plate precursor according to the present disclosure can be formed by dissolving each component of the above-mentioned positive tone photosensitive resin composition in a solvent, applying the solution onto an appropriate support, and curing the applied solution.
Examples of the solvent to be used herein include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, and toluene. These solvents may be used alone or in combination.

Formation of lower layer and upper layer

In a case of forming a positive tone image-recording layer, it is preferable to have an image-recording layer having an underlayer and an upper layer in this order on the support.
For example, a composition for forming an upper layer, which improves ink receptivity, printing durability, and the like, can be used for forming the upper layer, and a composition for forming a layer, which improves alkali solubility, can be used for forming the lower layer.
In principle, it is preferable that the lower layer and the upper layer are formed as two separate layers.
Examples of the method for forming the two layers separately include a method that utilizes a difference in solubility in a solvent between the components contained in the lower layer and the components contained in the upper layer, and a method in which the upper layer is applied and then the solvent is quickly dried and removed.

Support

The lithographic printing plate precursor according to the present disclosure has a support.
The support to be used can be appropriately selected from known supports for a lithographic printing plate precursor.
The support is preferably a support having a hydrophilic surface (hereinafter, also called "hydrophilic support").
As the support in the present disclosure, an aluminum plate is preferable which has been roughened using a known method and has undergone an anodization treatment. That is, the support in the present disclosure preferably has an aluminum plate and an aluminum anodic oxide film disposed on the aluminum plate.
In addition, it is preferable that the support has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, and the average diameter of the micropores within the surface of the anodic oxide film is more than 10 nm and 100 nm or less.
Furthermore, the micropores are preferably each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 15 nm or less.
In addition, it is preferable that the support has an anodic oxide film, the micropores in the anodic oxide film are composed of small diameter portions extending to a position at a depth of 10 nm to 1,000 nm from a surface of the anodic

oxide film and large diameter portions communicating with bottom portions of the small diameter portions and extending to a position at a depth of 20 nm to 2,000 nm from the communicate positions, an average diameter of the small diameter portions in the surface of the anodic oxide film is 35 nm or less, and an average maximum diameter of the large diameter portions is 40 nm to 300 nm or less.

Furthermore, it is preferable that the support has an anodic oxide film, and the anodic oxide film has, in order from a surface of the anodic oxide film in a depth direction, an upper layer having micropores with an average diameter of 20 nm to 100 nm and a thickness of 30 nm to 500 nm, a middle layer having micropores with an average diameter of 1/2 times to 5 times the average diameter of the micropores in the upper layer of the anodic oxide film and a thickness of 100 nm to 300 nm, and a lower layer having micropores with an average diameter of 15 nm or less and a thickness of 300 nm to 2,000 nm.

FIG. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image-recording layer side than the aluminum plate 18. That is, it is preferable that the lithographic printing plate precursor according to the present disclosure have at least an anodic oxide film, an image-recording layer, and a water-soluble resin layer in this order on an aluminum plate.

Anodic oxide film

Hereinafter, preferred aspects of the anodic oxide film 20a will be described.

The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18 side) along the thickness direction (toward the aluminum plate 18 side).

The average diameter (average opening diameter) of the micropores 22a on the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.

In a case where the average diameter is more than 10 nm, printing durability and image visibility are excellent. In addition, in a case where the average diameter is 100 nm or less, printing durability is excellent.

The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm $\times$ 600 nm in the obtained 4 images, and averaging the measured sizes.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The shape of the micropores 22a is not particularly limited. In FIG. 1, the micropores 22a have a substantially straight tubular shape (substantially cylindrical shape). However, the micropores 22a may have a conical shape that tapers along the depth direction (thickness direction). In addition, the shape of the bottom portion of the micropores 22a is not particularly limited, and may be a curved (convex) or flat surface shape.

In the support, the micropores may be each composed of a large diameter portion that extends to a position at a certain depth from the surface of the anodic oxide film and a small diameter portion that is in communication with a bottom portion of the large diameter portion and extends to a position at a certain depth from the communicate position.

For example, as shown in FIG. 2, an aspect may be adopted in which an aluminum support 12b includes an aluminum plate 18 and an anodic oxide film 20b having micropores 22b each composed of a large diameter portion 24 and a small diameter portion 26.

For example, the micropores 22b in the anodic oxide film 20b are each composed of the large diameter portion 24 that extends to a position at a depth of 10 nm to 1,000 nm (depth D: see FIG. 2) from the surface of the anodic oxide film and the small diameter portion 26 that is in communication with the bottom portion of the large diameter portion 24 and further extends from the communicate position to a position at a depth of 20 nm to 2,000 nm. Specifically, for example, it is possible to use the aspect described in paragraphs "0107" to "0114" of JP2019-162855A.

The depth of the micropores is not particularly limited, but from the viewpoint of achieving both on-press developability and printing durability, the depth of the micropores is preferably 0.01 $\mu$m to 1 $\mu$m, more preferably 0.05 $\mu$m to 0.6 $\mu$m, and still more preferably 0.07 $\mu$m to 0.25 $\mu$m. The depth of the micropores means a distance in a depth direction from the surface of the coating film of the micropores to the deepest portion of the bottom portion of the micropores.

The density of the micropores on the surface of the coating film is not particularly limited, but from the viewpoint of achieving both on-press developability and printing durability, is preferably 200 pores/$\mu m^2$ to 2,000 pores/$\mu m^2$ and more preferably 400 pores/$\mu m^2$ to 1,500 pores/$\mu m^2$.

The density of the micropores is a value obtained by observing the surface of the coating film with a field emission scanning electron microscope (FE-SEM) at a magnification of 150,000 times, by randomly selecting a measurement region of 400 nm × 600 nm in four images obtained by observing different four locations, by measuring the number of micropores present in the measurement region, by calculating the number of micropores per area of the measurement region for each image, and by arithmetically averaging the calculated values.

From the viewpoint of achieving both on-press developability and printing durability, the opening ratio due to the micropores on the surface of the coating film is preferably in a range of 10% to 90% and more preferably in a range of 30% to 85%.

The opening ratio is a value obtained by converting, into a percentage, a value obtained by multiplying an average area of the opening portion by the large-diameter pores of the micropores on the surface of the coating film, which is calculated by dividing the average diameter of the large-diameter pores of the micropores on the surface of the coating film by 2, by the density (number density) of the micropores on the surface of the coating film.

Method of producing support

As a manufacturing method of the support used in the present disclosure, for example, a manufacturing method is preferable in which the following steps are sequentially performed.

· Roughening treatment step: step of performing roughening treatment on aluminum plate
· Anodization treatment step: step of subjecting aluminum plate having undergone roughening treatment to anodic oxidation
· Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedure of each step will be specifically described.

Roughening treatment step

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed. This step can be carried out by the method described in paragraphs "0086" to "0101" of JP2019-162855A.

Anodization treatment step

The procedure of the anodization treatment step is not particularly limited as long as the aforementioned micropores can be obtained. Examples thereof include known methods.

In the anodization treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodization treatment are appropriately set depending on the electrolytic solution used. For example, the liquid temperature is 5°C to 70°C (preferably 10°C to 60°C), the current density is 0.5 A/$dm^2$ to 60 A/$dm^2$ (preferably 1 A/$dm^2$ to 60 A/$dm^2$), the voltage is 1 V to 100 V (preferably 5 V to 50 V), the electrolysis time is 1 second to 100 seconds (preferably 5 seconds to 60 seconds), and the film amount is 0.1 g/$m^2$ to 5 g/$m^2$ (preferably 0.2 g/$m^2$ to 3 g/$m^2$).

Pore widening treatment

The pore widening treatment is a treatment of enlarging the diameter of micropores (pore diameter) present in the anodic oxide film formed by the aforementioned anodization treatment step (pore diameter enlarging treatment).

The pore widening treatment can be carried out by bringing the aluminum plate obtained by the aforementioned anodization treatment step into contact with an aqueous acid solution or an aqueous alkali solution. The contact method is not particularly limited, and examples thereof include a dipping method and a spraying method.

Silicate treatment step

It is preferable that the method of producing the support has a silicate treatment step of subjecting the aluminum plate on which the anodic oxide film is formed by the treatment such as the anodization treatment and the pore widening treatment to a silicate treatment. This is because the support in which the specific Si atomic amount described later is within a predetermined range can be easily manufactured by the silicate treatment step.

The silicate treatment is a treatment in which an aqueous solution (hereinafter, also referred to as a "treatment liquid") containing an alkali metal silicate such as sodium silicate and potassium silicate is brought into contact with an anodic oxide film formed on an aluminum plate. In the silicate treatment, it is preferable that the aluminum plate having an anodic oxide film is immersed in the treatment liquid.

For the silicate treatment, the methods and procedures described in US2714066A and US3181461A can be referred to, the descriptions of which are incorporated in the present specification by reference.

Examples of the alkali metal silicate used for the silicate treatment include sodium silicate, potassium silicate, and lithium silicate. The treatment liquid may further contain an appropriate amount of a hydroxide of an alkali metal such as sodium hydroxide, potassium hydroxide, and lithium hydroxide, in addition to the alkali metal silicate.

In addition, the treatment liquid may further contain an alkaline earth metal salt or a group 4 (group IVA) metal salt. Examples of the alkaline earth metal salt include nitrates such as calcium nitrate, strontium nitrate, magnesium nitrate, and barium nitrate; sulfates; hydrochlorides; phosphates; acetates; oxalates; and borates. Examples of the tetravalent (IVA group) metal salt include titanium tetrachloride, titanium trichloride, potassium titanium fluoride, potassium titanium oxalate, titanium sulfate, titanium tetrachloride, zirconium oxychloride, zirconium dioxide, zirconium oxychloride, and zirconium tetrachloride. These alkaline earth metal salts and Group 4 (Group IVA) metal salts are used alone or in combination of two or more kinds thereof.

The treatment conditions of the silicate treatment, the concentration of the treatment liquid, and the like are appropriately adjusted depending on the size of the aluminum plate to be treated and the anodic oxide film, the structure (specific structure) of the micropores, the density, and the like.

The content of the alkali metal silicate in the treatment liquid is, for example, 3% by mass to 30% by mass with respect to the total mass of the treatment liquid, and is preferably 3% by mass to 10% by mass.

The temperature of the treatment liquid used for the silicate treatment is, for example, 30°C to 80°C, and more preferably 40°C to 70°C.

The treatment time of the silicate treatment is, for example, 1 second to 15 seconds, and more preferably 3 seconds to 10 seconds.

The amount of the silicate adsorbed on the surface of the support by the silicate treatment can be alternatively expressed by an average value of Si atomic amounts (hereinafter, also referred to as "specific Si atomic amount") calculated in a case where a circular region having a diameter of 30 mm is measured by the fluorescence X-ray analysis. The Si atomic amount is obtained by performing the fluorescence X-ray analysis on a circular region having a diameter of 30 mm on the surface of the support, measuring the intensity of the K$\alpha$ ray of the Si element, and then quantifying the Si atomic amount present on the surface of the coating film using a calibration curve. Here, the "average value of Si atomic weights" means a numerical value obtained by selecting three or more circular regions that do not overlap each other on the surface of the anodic oxide film on the image-recording layer side, obtaining the Si atomic weight for each region, and arithmetically averaging the obtained Si atomic weights of each of the regions.

Method for measuring Si atomic weight

The Si atomic weight in the anodic oxide film was measured based on a fluorescence X-ray analysis method and a calibration curve method. As a standard sample for creating a calibration curve, an aqueous solution containing a known amount of silicon atoms was uniformly added dropwise to an area of 30 mm$\varphi$ on an aluminum plate and then dried. The measurement conditions for the fluorescence X-ray analysis are shown below.

Fluorescence X-ray analyzer: RIX3000 manufactured by RIGAKU Corporation, X-ray tube: Rh, measurement spectrum: Si-K$\alpha$, tube voltage: 50 kV, tube current: 50 mA, slit: COARSE, spectral crystal: RX4, detector: F-PC, analysis area: 30 mm$\varphi$, peak position (20): 144.75 deg., background (2$\theta$): 140.70 deg. and 146.85 deg., integration time: 80 seconds/sample

From the viewpoint of temporal on-press developability, printing durability, and antifouling property, the Si atomic weight is preferably 0.001 g/$m^2$ to 0.2 g/$m^2$ and more preferably 0.05 g/$m^2$ to 0.1 g/$m^2$.

As necessary, the support may have a backcoat layer on the side opposite to the image-recording layer, the backcoat layer containing the organic polymer compound described in JP1993-045885A (JP-H5-45885A) or the alkoxy compound of silicon described in JP1994-035174A (JP-H6-35174A).

Undercoat layer

The lithographic printing plate precursor according to the present disclosure preferably has an undercoat layer (also called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer inhibits the deterioration of printing durability and contributes to the improvement of developability. In addition, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, it is preferable that polymers having adsorbent groups and hydrophilic groups further have crosslinkable groups. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinkable group is preferable.

As the adsorbent group that can be adsorbed onto the surface of the support, a phenolic hydroxy group, a carboxy group, $-PO_3H_2$, $-OPO_3H_2$, $-CONHSO_2-$, $-SO_2NHSO_2-$, and-$COCH_2COCH_3$ are preferable. As the hydrophilic groups, a sulfo group or salts thereof and salts of a carboxy group are preferable. As the crosslinking groups, an acryl group, a methacryl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinkable groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer is formed by known coating methods. The coating amount (solid content) of the undercoat layer is preferably 0.1 $mg/m^2$ to 100 $mg/m^2$ and more preferably 1 $mg/m^2$ to 30 $mg/m^2$.

Outermost layer

The lithographic printing plate precursor according to the present disclosure may have an outermost layer (also called "protective layer" or "overcoat layer" in some cases) on a surface of the image-recording layer that is opposite to the support side.

It is preferable that the lithographic printing plate precursor according to the present disclosure have a support, an image-recording layer, and an outermost layer in this order.

The outermost layer may have a function of suppressing the reaction inhibiting image formation by blocking oxygen, a function of preventing the damage of the image-recording layer, and a function of preventing ablation during exposure to high-illuminance lasers.

As the outermost layer, a known outermost layer ("protective layer" or "overcoat layer") in a lithographic printing

plate precursor can be used. Specifically, as the outermost layer, the outermost layer described in paragraphs "0444" to "0462" of WO2022/019217A can be suitably used.

The lithographic printing plate precursor according to the present disclosure may have other layers in addition to those mentioned above.

Known layers can be adopted as those other layers without particular limitations. For example, as necessary, a backcoat layer may be provided on a surface of the support that is opposite to the image-recording layer side.

Method of preparing lithographic printing plate and lithographic printing method

It is possible to prepare a lithographic printing plate by performing image exposure and a development treatment on the lithographic printing plate precursor according to the present disclosure. The method of preparing a lithographic printing plate using the lithographic printing plate precursor of the present disclosure is not particularly limited, and a known method of preparing a lithographic printing plate can be applied.

Among these, as the method of preparing a lithographic printing plate, the method of preparing a lithographic printing plate according to the embodiment of the present disclosure described below is preferable.

It is preferable that the method of preparing a lithographic printing plate according to the embodiment of the present disclosure includes a step of imagewise-exposing the lithographic printing plate precursor according to the embodiment of the present disclosure (hereinafter, also referred to as an "exposure step"), and a step of supplying at least one selected from the group consisting of printing ink and dampening water to remove the image-recording layer in the non-image area on the printer (hereinafter, also referred to as an "on-press development step").

It is preferable that the planographic printing method according to the embodiment of the present disclosure includes a step of imagewise-exposing the lithographic printing plate precursor according to the embodiment of the present disclosure (an exposure step), a step of supplying at least one selected from the group consisting of printing ink and dampening water to remove the image-recording layer in the non-image area on the printer and preparing a lithographic printing plate (an on-press development step), and a step of performing printing using the obtained lithographic printing plate (a printing step).

Hereinafter, regarding the method of preparing a lithographic printing plate according to the present disclosure and the lithographic printing method according to the present disclosure, preferred aspects of each step will be described in order.

The method of preparing a lithographic printing plate using the lithographic printing plate precursor according to the embodiment of the present disclosure is not particularly limited as described above, and the development step is not limited to the on-press development step, and a development step of performing development with a developer can also be applied.

Hereinafter, the exposure step and the on-press development step in the method of preparing a lithographic printing plate will be described. The exposure step in the method of preparing a lithographic printing plate according to the present disclosure is the same step as the exposure step in the lithographic printing method described later. Furthermore, the on-press development step in the method of preparing a lithographic printing plate according to the present disclosure is the same step as the on-press development step in the lithographic printing method described later.

Exposure step

The method of preparing a lithographic printing plate according to the present disclosure preferably includes an exposure step of exposing the lithographic printing plate precursor according to the present disclosure in the shape of an image such that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data, or the like.

The wavelength of a light source to be used is preferably 750 nm to 1,400 nm. As the light source having a wavelength of 750 nm to 1,400 nm, a solid-state laser or a semiconductor laser that radiates infrared rays is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any of an inner surface drum method, an external surface drum method, a flat head method, or the like.

The image exposure can be carried out by a common method using a plate setter or the like. In the case of on-press development, image exposure may be carried out on a printer after the lithographic printing plate precursor is mounted on the printer.

Development step

On-press development step

In a case where the lithographic printing plate according to the present disclosure is a negative tone image-recording layer of an on-press development type, it is preferable that the method of preparing a lithographic printing plate includes an on-press development step of supplying at least one selected from the group consisting of a printing ink and dampening water on a printer to remove the image-recording layer in a non-image area.
Hereinafter, the on-press development method will be described.

On-press development method

In the on-press development method, the lithographic printing plate precursor having undergone image exposure is preferably supplied with an oil-based ink and an aqueous component on a printer such that the image-recording layer in a non-image area is removed and a lithographic printing plate is prepared.
That is, in a case where the lithographic printing plate precursor is subjected to image exposure and then mounted as it is on a printer without being subjected to any development treatment, or the lithographic printing plate precursor is mounted on a printer and then subjected to image exposure on the printer, and then an oil-based ink and an aqueous component are supplied to perform printing, at the initial stage in the middle of printing, in a non-image area, by either or both of the supplied oil-based ink and the aqueous component, a non-cured image-recording layer is dissolved or dispersed to remove, and the hydrophilic surface is exposed in the non-image area. Meanwhile, the image-recording layer cured by exposure forms an oil-based ink-receiving area having a lipophilic surface in the exposed portion. What is supplied first to the precursor surface may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.
As the laser used for performing image exposure on the lithographic printing plate precursor according to the present disclosure, a light source having a wavelength of 300 nm to 450 nm or 750 nm to 1,400 nm is preferably used. A light source of 300 nm to 450 nm is preferable for a lithographic printing plate precursor including an image-recording layer containing sensitizing dye having maximum absorption in such a wavelength range. As the light source of 750 nm to 1,400 nm, those described above are preferably used. As the light source of 300 nm to 450 nm, a semiconductor laser is suitable.

Developing step with developer

Developer development method

An aspect in which a development step of supplying a developer to remove a non-exposed portion in the exposure step, that is, a developer development method is performed after the above-described exposure step of image-exposing the lithographic printing plate precursor can also be applied to the lithographic printing plate precursor according to the present disclosure.
In the developer development method, the above-described unexposed portion is dissolved and removed with an alkaline developer or an organic solvent to expose the surface of the hydrophilic support to form a non-image area.
As the developer treatment method, a known method of performing a development treatment using a known developer can be applied according to the lithographic printing plate precursor to be applied.
A recording medium can be printed by supplying printing ink to the lithographic printing plate obtained by the method of preparing a lithographic printing plate (printing step).

Printing step

The lithographic printing method includes a printing step of supplying a printing ink to a lithographic printing plate prepared from the lithographic printing plate precursor according to the present disclosure to print a recording medium.
The printing ink is not particularly limited, and various known inks can be used as desired. In addition, preferred examples of the printing ink include oil-based ink or ultraviolet-curable ink (UV ink).
In the printing step, as necessary, dampening water may be supplied.
In addition, the printing step may be continuously performed after the on-press development step or the development step using a developer without stopping the printer.
The recording medium is not particularly limited, and a known recording medium can be used as desired.
In the method of preparing a lithographic printing plate from the lithographic printing plate precursor according to

the present disclosure and in the lithographic printing method, as necessary, the entire surface of the lithographic printing plate precursor may be heated before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Laminate

The lithographic printing plate precursor according to the embodiment of the present disclosure may be used as a laminate.

Protective material

It is preferable that the laminate of the lithographic printing plate precursors according to the present disclosure has a protective material that is disposed at least at an uppermost portion of the laminated lithographic printing plate precursor and protects the lithographic printing plate precursor.

From the viewpoint of the suppressing property of development defect over time, the value of (Y - X)/Y of the protective material is preferably 0.06 or less, more preferably 0.03 or less, and particularly preferably 0.01 or less. In addition, the lower limit value of the value of (Y - X)/Y is 0.

The value of (Y - X)/Y of the protective material is measured as follows.

The protective material was cut into a size of 10 cm × 20 cm and dried in an oven at 100°C for 1 hour.

The dried protective material is conditioned in an environment of 25°C and 30% RH to obtain a saturation mass X. Specifically, the mass is measured every hour, and it is determined that the saturation mass is reached at a time when the mass $X_n$ at the time of each measurement and the mass $X_{n-1}$ one hour before the measurement have a relationship of the following expression.

$$X_n - X_{n-1} \leq 0.005 \text{ g}$$

The saturation mass X (g/m$^2$) is determined by the following expression.

$$X = X_n/0.02$$

The protective material was conditioned in an environment of 25°C and 80% RH to obtain a saturation mass Y. Specifically, the mass is measured every hour, and it is determined that the saturation mass is reached at a time when the mass $Y_n$ at the time of each measurement and the mass $Y_{n-1}$ one hour before the measurement have a relationship of the following expression.

$$Y_n - Y_{n-1} \leq 0.005 \text{ g}$$

The saturation mass Y (g/m$^2$) is determined by the following expression.

$$Y = Y_n/0.02$$

From X and Y obtained as described above, the water absorption rate of the protective material is calculated as follows.

$$\text{Water absorption rate} = (Y - X)/Y$$

Examples of the material of the protective material include thick paper, cardboard, plastic, foamed plastic, and rubber. Among these, from the viewpoint of the suppressing property of the development defect over time, at least one selected from the group consisting of thick paper, cardboard, laminated paper, a plastic sheet, a foamed plastic sheet, and a rubber sheet is preferable, a cardboard or a plastic sheet is more preferable, and a plastic sheet is particularly preferable.

As the plastic, a known polymer can be used, and examples thereof include polyester, polycarbonate, and polyolefin. Among these, polyester is preferable.

The surface of the cardboard may be coated with a plastic material, and examples of the plastic material used for the coating include polypropylene and low-density polyethylene. In addition, the surface of the cardboard may be subjected to metal vapor deposition, and aluminum is preferable as the metal used from the viewpoint of workability and price.

· The size (length × width) of the protective material is not particularly limited and can be appropriately selected depending on the lithographic printing plate precursor to be used. For example, the size of the protective material is the same as or slightly larger than the size of the lithographic printing plate precursor.

The thickness of the protective material is not particularly limited. From the viewpoint of strength, moisture permeability, and suppressing property of development defect over time, the thickness of the protective material is preferably 10 μm to 10 mm and more preferably 100 μm to 5 mm.

Furthermore, from the viewpoint of strength, moisture permeability, and suppressing property of temporal development defects, the thickness of the protective material is preferably 100 μm or more.

In addition, it is preferable that the protective material be disposed not only in the uppermost portion of the laminate but also in the lowermost portion.

Interleaving paper

The laminate of the lithographic printing plate precursors according to the present disclosure may have interleaving paper between the two laminated lithographic printing plate precursors.

In addition, the interleaving paper may be between the lithographic printing plate precursor and the protective material.

Furthermore, the interleaving paper may be in the lowermost portion of the laminate.

In order to reduce the material cost, it is preferable to select low-cost raw materials as the material of the interleaving paper used in the present disclosure. For example, it is possible to use paper using wood pulp 100% by mass, paper using wood pulp together with synthetic pulp, paper composed of the above paper and a low-density or high-density polyethylene layer provided on the surface of the paper, and the like.

Specifically, examples thereof include acidic paper made of paper stock prepared by adding a sizing agent and a paper strengthening agent to paper stock obtained by beating bleached kraft pulp and then diluting the beaten pulp to a concentration of 4% by mass such that the amounts of the sizing agent and paper strengthening agent are 0.1% by mass and 0.2% by mass respectively with respect to the mass of the paper stock and then adding aluminum sulfate thereto until the pH reaches 5.0. It is preferable to use alkaline paper having a pH of 7 to 8 in which a neutral sizing agent, such as an alkyl ketene dimer (AKD) or an alkenyl succinic anhydride (ASA), is used as a sizing agent and calcium carbonate is used as a filler instead of aluminum sulfate.

As the interleaving paper, among these, paper is preferable, paper containing aluminum sulfate or calcium carbonate is more preferable, and paper containing calcium carbonate is particularly preferable.

The material of the interleaving paper is preferably paper containing 50% by mass or more of pulp, more preferably paper containing 70% by mass or more of pulp, and particularly preferably paper containing 80% by mass or more of pulp.

In the interleaving paper, the calcium content with respect to the total mass of the interleaving paper is preferably 0.15% by mass to 0.5% by mass, more preferably 0.2% by mass to 0.45% by mass, and particularly preferably 0.25% by mass to 0.4% by mass.

The calcium content of the interleaving paper is obtained by performing X-ray fluorescence spectrometry on the interleaving paper.

The calcium contained in paper is mainly calcium carbonate which is widely used as a filler for alkaline paper, and performs an action of increasing whiteness of the paper.

The basis weight of the interleaving paper (determined by measuring method specified in JIS P8124 (2011)) is not particularly limited, but from the viewpoints of printing durability and on-press developability, is preferably 29 g/m$^2$ to 80 g/m$^2$, more preferably 35 g/m$^2$ to 70 g/m$^2$, and particularly preferably 51 g/m$^2$ to 65 g/m$^2$.

From the viewpoints of UV printing durability and on-press developability, the basis weight of the interleaving paper is preferably 51 g/m$^2$ or more.

The thickness of the interleaving paper (determined by the measuring method specified in JIS P8118 (2014)) is not particularly limited, but is preferably 20 μm to 100 μm, more preferably 42 μm to 80 μm, even more preferably 45 μm to 65 μm, and particularly preferably 45 μm to 55 μm.

From the viewpoint of dot-like color defect suppressing property, the moisture amount of the interleaving paper

(moisture amount of the interleaving paper stored at 25°C/50% RH until the moisture amount of the interleaving paper is stabilized) with respect to the total mass of the interleaving paper is preferably 0% by mass to 20% by mass, more preferably 0% by mass to 15% by mass, and particularly preferably 0% by mass to 10% by mass.

As the interleaving paper, the interleaving paper described in JP2010-76336A can be suitably used.

The shape of the interleaving paper is not particularly limited, and examples thereof include a shape which is the same as or larger than the shape of the lithographic printing plate precursor in the plane direction.

In addition, the entire laminate of the lithographic printing plate precursors may be packaged by a known method.

## Examples

Hereinafter, the present disclosure will be described in detail with reference to examples, but the present disclosure is not limited thereto. In the present examples, unless otherwise specified, "%" and "part" mean "% by mass" and "part by mass" respectively.

In the following compositional formula or structural formula, Me represents a methyl group, and a $Me_3SiO$ group (or a $Me_3SiO$ group) may be denoted as "M", a $Me_2SiO$ group may be denoted as "D", and a MeHSiO group may be denoted as "DH".

Unless otherwise described, the molecular weight of a polymer compound is a weight-average molecular weight (Mw), and the ratio of repeating constitutional units of a polymer compound is expressed as molar percentage. In addition, the weight-average molecular weight (Mw) is a polystyrene-equivalent molecular weight measured by gel permeation chromatography (GPC).

### Examples 1 to 9 and Comparative Examples 1 to 4

The undercoat layer described in Table 1 was formed on the support described in Table 1, the image-recording layer described in Table 1 was formed on the undercoat layer, and the protective layer described in Table 1 was formed on the image-recording layer or not formed, thereby obtaining each lithographic printing plate precursor. In Example 9, as shown in Table 1 below, the image-recording layer was formed on the support without providing an undercoat layer. The details of the method of forming each layer will be described later.

### Preparation of support A

The following treatment was performed on an aluminum plate (aluminum alloy plate) having a thickness of 0.3 mm and a material 1S to produce a support A. A rinsing treatment was performed between all the treatment steps. After the rinsing treatment, water was drained using a nip roller.

### Alkaline etching treatment (1)

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 $g/m^2$.

### Desmutting treatment (1) using acidic aqueous solution

Next, a desmutting treatment was performed using an acidic aqueous solution. Specifically, the desmutting treatment was performed for 3 seconds by spraying the aqueous acidic solution onto the aluminum plate. In the desmutting treatment, a 150 g/L aqueous sulfuric acid solution was used as the aqueous acidic solution. The liquid temperature was 30°C.

### Electrochemical roughening treatment

Next, a hydrochloric acid electrolytic treatment was performed using an alternating current with an electrolytic solution having a hydrochloric acid concentration of 13 g/L and an aluminum ion concentration of 15 g/L. The liquid temperature of the electrolytic solution was 25°C. The aluminum ion concentration was adjusted by adding aluminum chloride.

The waveform of the alternating current was a sine wave in which the positive and negative waveforms were symmetrical, the frequency was 50 Hz, the ratio between the anodic reaction time and the cathodic reaction time in one cycle of the alternating current was 1:1, and the current density was 35 $A/dm^2$ in terms of the peak current value of the

alternating current waveform. Further, the sum of the electricity quantity for the anodic reaction of the aluminum plate was 320 C/dm$^2$, and the electrolytic treatment was performed four times at energization intervals of 2.5 seconds for each electric quantity of 80 C/dm$^2$. A carbon electrode was used as the counter electrode of the aluminum plate. Then, a water washing treatment was performed.

Alkaline etching treatment (2)

The aluminum plate after being subjected to the electrochemical roughening treatment was subjected to an etching treatment by spraying a caustic soda aqueous solution in which the concentration of caustic soda was 5% by mass and the concentration of aluminum ions was 0.5% by mass using a spray at a temperature of 45°C. An amount of aluminum dissolved in the surface subjected to the hydrochloric acid electrolytic treatment was 0.2 g/m$^2$. Then, a water washing treatment was performed.

Desmutting treatment (2) using acidic aqueous solution

Next, a desmutting treatment was performed using an acidic aqueous solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 35°C.

First-stage anodization treatment

By using the anodization treatment device for direct current electrolysis having the structure shown in FIG. 6, a first-stage anodization treatment was performed. By using a 150 g/L aqueous sulfuric acid solution as an electrolytic solution, an anodization treatment was performed under the conditions of a liquid temperature of 50°C and a current density of 15 A/dm$^2$, thereby forming an anodic oxide film having a film amount of 0.25 g/m$^2$.

In an anodization treatment device 610 illustrated in FIG. 6, an aluminum plate 616 is transported as indicated by the arrow in FIG. 6. In a power supply tank 612 storing an electrolytic solution 618, the aluminum plate 616 is positively (+) charged by a power supply electrode 620. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Next, the aluminum plate 616 is negatively (-) charged by an electrolysis electrode 630 so that an anodic oxide film is formed on the surface thereof, and the aluminum plate 616 coming out of the electrolytic treatment tank 614 is transported to the next step. In the anodization treatment device 610, direction changing means is formed of the roller 622, the nip roller 624, and the roller 628. The aluminum plate 616 is transported in a mountain shape and an inverted U shape by the roller 622, the nip roller 624, and the roller 628 in an inter-tank portion between the power supply tank 612 and the electrolytic treatment tank 614. The power supply electrode 620 and the electrolysis electrode 630 are connected to a direct current power source 634. A cell wall 632 is disposed between the power supply tank 612 and the electrolytic treatment tank 614.

Pore widening treatment

The aluminum plate after being subjected to the anodization treatment was subjected to a pore widening treatment by being immersed in a caustic soda aqueous solution in which the concentration of caustic soda was 5% by mass and the concentration of aluminum ions was 0.5% by mass at a liquid temperature of 40°C. Then, rinsing was performed by means of spraying.

Second-stage anodization treatment

By using the anodization treatment device for direct current electrolysis having the structure shown in FIG. 6, a second-stage anodization treatment was performed. By using a 150 g/L aqueous sulfuric acid solution as an electrolytic solution, an anodization treatment was performed under the conditions of a liquid temperature of 50°C and a current density of 30 A/dm$^2$, thereby forming an anodic oxide film having a film amount of 3.5 g/m$^2$.

Formation of back coating

The back surface of the support subjected to the surface treatment as described above was coated with the following back coating liquid using a bar coater, dried at 100°C for 1 minute, and a back coating having a coating amount of 50 mg/m$^2$ after drying was provided, thereby obtaining an aluminum support A.

Sol-gel reaction solution

- Tetraethyl silicate: 50.0 parts
- Water: 86.4 parts
- Methanol: 10.8 parts
- Phosphoric acid (85 mass% aqueous solution): 0.08 parts

In a case where the respective components described in the sol-gel reaction solution were mixed and stirred, heat was generated in about 35 minutes. After stirring and reacting for 40 minutes, the mixture was further mixed with the following diluent to prepare a back coating solution.

Diluent solution

- Pyrogallol acetone condensation resin: 15.0 parts
- Dibutyl maleate: 5.0 parts
- Methanol silica sol manufactured by Nissan Chemical Corporation: 70.0 parts
- DOWSIL FZ-2123 manufactured by Dow Toray Co., Ltd.: 0.1 parts
- Methanol: 650 parts
- 1-Methoxy-2-propanol: 200 parts

Production of undercoat layer A

The support was coated with the undercoat layer coating liquid A having the following composition such that the dry coating amount was 0.1 g/m$^2$. In this way, an undercoat layer was formed.

Undercoat layer coating liquid A

- Compound for undercoat layer (following U-1, 11% aqueous solution): 0.0788 parts
- Chelest 400 (chelating agent; manufactured by Chelest Co., Ltd.): 0.0280 parts
- Chelest 3EAF (chelating agent; manufactured by Chelest Co., Ltd.): 0.0499 parts
- Surfactant (EMALEX (registered trademark) 710, manufactured by NIHON EMULSION Co., Ltd.): 0.00159 parts
- Preservative (BIOHOPE L, manufactured by K·I Chemical Industry Co., Ltd.): 0.00149 parts
- Water: 2.8219 parts

(U - 1)

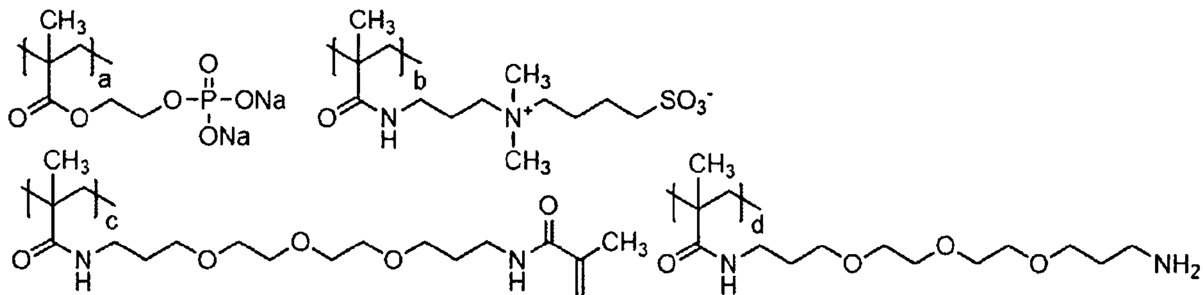

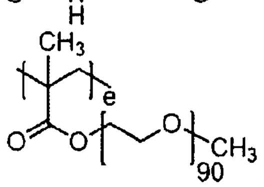

a / b / c / d / e = 14.2 / 71.8 / 8.9 / 0.1 / 5.0 (% by mass)

a / b / c / d / e = 19.0 / 72.8 / 7.7 / 0.1 / 0.4 (mol%)

Weight-average molecular weight = 200,000

Production of image-recording layer A

The undercoat layer was bar-coated with the following image-recording layer coating liquid A and dried in an oven at 120°C for 40 seconds, thereby forming an image-recording layer having a dry coating amount of 1.0 g/m$^2$ and thus preparing a lithographic printing plate precursor.

Image-recording layer coating liquid A
Infrared absorber (the following IR-1): 0.0207 parts
Infrared absorber (the following IR-2): 0.0069 parts
Color developing agent (the following S-1): 0.0300 parts
Color developing agent (the following S-2): 0.0120 parts
Onium-based polymerization initiator (the following I-1): 0.0981 parts
Borate compound (the following B-1): 0.0270 parts
Polymerizable compound (the following M-4): 0.3536 parts
Anionic surfactant (the following A-1): 0.0162 parts
Polymer A or comparative polymer CA (compound shown in Table 1): 0.0042 parts
2-Butanone: 5.3155 parts
1-Methoxy-2-propanol: 2.9361 parts
Methanol: 2.3212 parts
The following microgel liquid 1: 2.8000 parts

The structures of the respective compounds contained in the coating liquid for an image-recording layer will be described below.

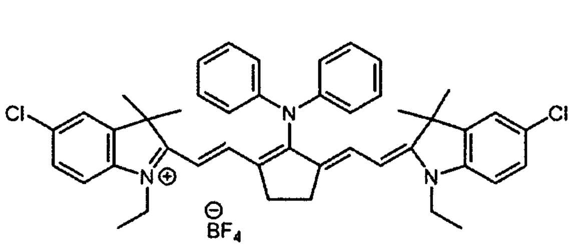

IR-1

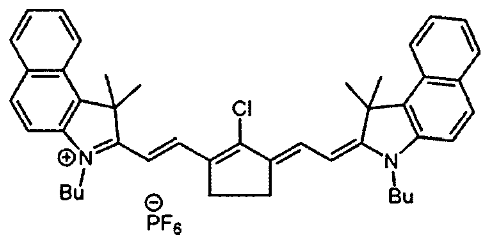

IR-2

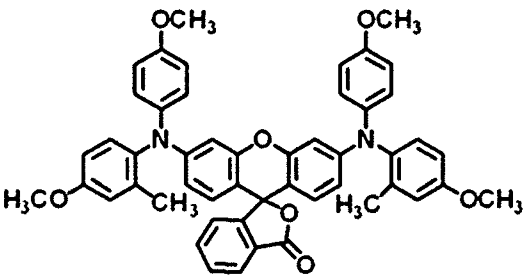

S-1

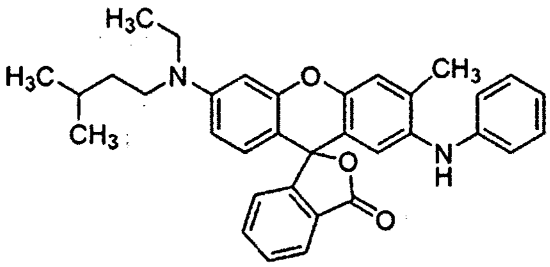

S-2

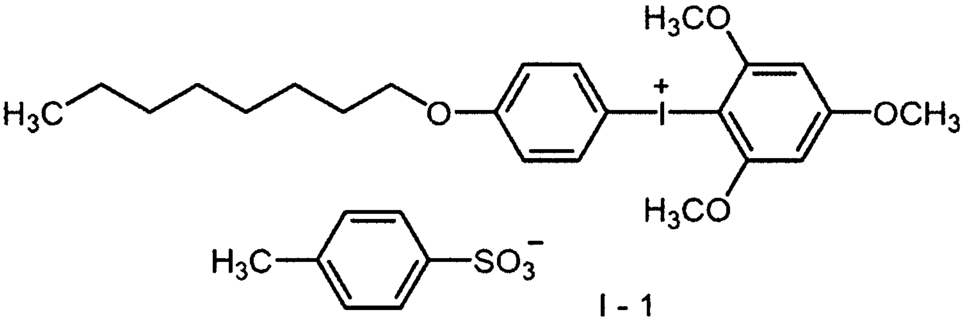

I - 1

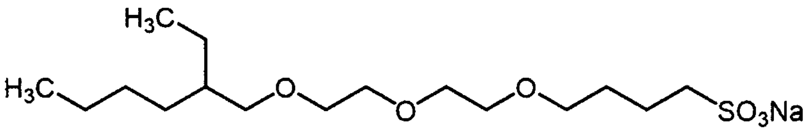

A - 1

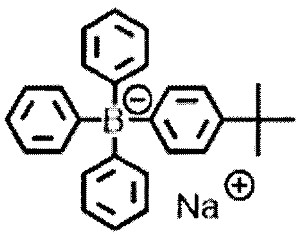

(B-1)

The details of the polymer A and the comparative polymer CA described in Table 1, which are used in the coating liquid for an image-recording layer, are as follows.

Synthesis of polymer (A-1)

380.43 g of methylhydrogen polysiloxane represented by an average compositional formula $MD_{24}DH_6M$, 468.29 g of allyl polyether represented by an average structural formula $CH_2$=CH-CH2-O($C_2H_4O)_9CH_3$, 278 g of isopropyl alcohol (hereinafter, abbreviated as IPA), and 1.88 g of a 1.5% by mass sodium acetate/methanol solution were charged into a reactor, and the mixture was heated to 60°C under a nitrogen stream while stirring. 3.25 g of a 1 mass% IPA solution of chloroplatinic acid was added thereto, and the reaction was carried out at 80°C for 3 hours. Next, 2 g of the reaction solution was sampled, and the completion of the reaction was confirmed by an alkali decomposition gas generation method (the residual Si-H group was decomposed by an ethanol/aqueous solution of KOH, and the reaction rate was calculated from the volume of the generated hydrogen gas). Further, the mixture was heated under reduced pressure to distill off low boiling point components, thereby obtaining A-1 having the following structure.

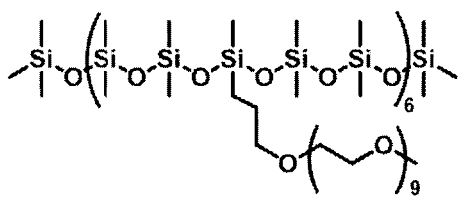

(A−1)

Synthesis of polymer (A-6)

A polymer (A-6) having the following structure was obtained by performing synthesis under the same conditions as those for the synthesis of the polymer (A-1), except that the average compositional formula of the methylhydrogen polysiloxane used for the synthesis of the polymer (A-1) was changed to $MD_{40}DH_{10}M$, the amount of the raw material was changed to 370.69 g, and the amount of the raw material of the allyl polyether was changed to 468.29 g.

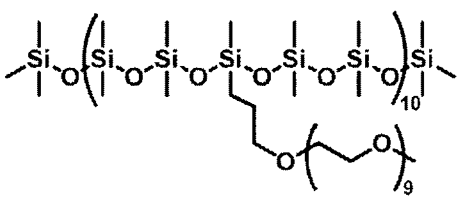

(A−6)

· Polymer (A-2): DOWSIL (registered trademark) SF-8427 Fluid, manufactured by Dow Toray Co., Ltd., both-terminal carbinol-modified dimethyl polysiloxane

· Polymer (A-3): DOWSIL (registered trademark) FZ-2123, side chain polyether-modified dimethyl polysiloxane,

manufactured by Dow Toray Co., Ltd.

· Polymer (A-4): KF-6104, manufactured by Shin-Etsu Chemical Co., Ltd., side chain polyglycerin-modified dimethyl polysiloxane

· Polymer (A-5): BYK-3760, manufactured by BYK-Chemie GmbH, polyester-modified polydimethylsiloxane

· Polymer (A-7): KF-6123, manufactured by Shin-Etsu Chemical Co., Ltd., both-terminal polyether-modified dimethyl polysiloxane

· Comparative polymer CA-1 (the following structure)

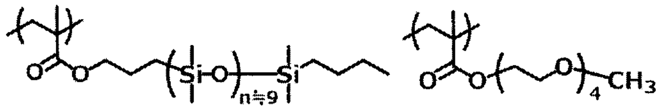

(CA-1)

· Comparative polymer CA-2 (the following structure)

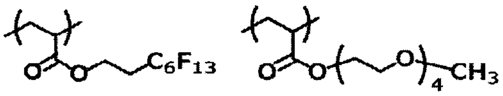

(CA-2)

Synthesis of polymerizable compound (M-4)

A mixed solution of TAKENATE D-160N (polyisocyanate trimethylolpropane adduct, manufactured by Mitsui Chemicals, Inc., 4.7 parts), ARONIX M-403 (manufactured by TOAGOSEI Co., Ltd., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTAN U-600 (bismuth-based polycondensation catalyst, manufactured by NITTO KASEI Co., Ltd., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-4) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight of the obtained urethane acrylate (M-4) was 20,000.

Synthesis of microgel liquid 1

Preparation of polyvalent isocyanate compound (1)

43 mg of bismuth tris(2-ethylhexanoate) (NEOSTANN U-600, manufactured by NITTO KASEI Co., Ltd.) was added to an ethyl acetate (25.31 g) suspension solution of 17.78 g (80 mmol) of isophorone diisocyanate and 7.35 g (20 mmol) of the following polyhydric phenol compound (1), and the resulting solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

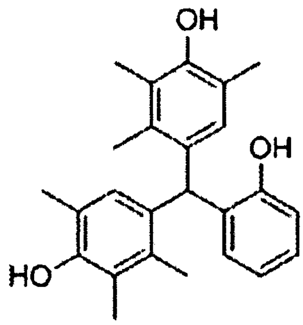

Polyhydric phenol compound (1)

Preparation of microgel liquid 1

The following oil-phase components and water-phase components were mixed together and emulsified at 12000 rpm for 10 minutes by using a homogenizer. The obtained emulsion was stirred at 45°C for 4 hours, 5.20 g of a 10% by mass aqueous solution of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of a microgel (1). The average particle diameter thereof measured by a light scattering method was 0.28 μm.

Oil-phase components

(Component 1) ethyl acetate: 12.0 g
(Component 2) adduct (50 mass% ethyl acetate solution, manufactured by Mitsui Chemicals, Inc.) obtained by adding trimethylolpropane (6 mol) and xylene diisocyanate (18 mol) and adding methyl side-terminal polyoxyethylene (1 mol, number of repeating oxyethylene units: 90) thereto: 3.76 g
(Component 3) polyvalent isocyanate compound (1) (as 50% by mass ethyl acetate solution): 15.0 g
(Component 4) 65% by mass ethyl acetate solution of dipentaerythritol pentaacrylate (SR-399, manufactured by Sartomer Company Inc.): 11.54 g
(Component 5) 10% ethyl acetate solution of sulfonate type surfactant (PIONIN A-41-C, manufactured by TAKEMOTO OIL & FAT Co., Ltd.): 4.42 g

Water-phase component

Distilled water: 46.87 g

Production of protective layer A

The image-recording layer A was bar-coated with the following coating liquid A for a protective layer and dried in an oven at 120°C for 60 seconds, thereby forming a protective layer A having a dry coating amount of 0.41 $g/m^2$. In this way, a lithographic printing plate precursor was prepared. As shown in Table 1, the lithographic printing plate precursor of Example 8 did not have the protective layer A.

Protective layer coating liquid A

The following components were mixed to prepare a protective layer coating liquid A.

Water: 1.0161 parts
METOLOSE SM04 (methyl cellulose, manufactured by Shin-Etsu Chemical Co., Ltd., methoxy substitution degree = 1.8): 0.0600 parts
FS-102 (styrene-acrylic resin, manufactured by Nippon paint Industrial Coatings Co., Ltd., Tg = 103°C, 17% aqueous dispersion): 0.1177 parts
RAPISOL A-80 (anionic surfactant, manufactured by NOF CORPORATION, 80% aqueous solution): 0.0063 parts

Example 10

The lithographic printing plate precursor of Example 10 has the following undercoat layer B, the following image-recording layer B, and the following protective layer B with respect to the following support B.

Production of support B

The following treatment was performed on an aluminum plate (aluminum alloy plate) of a material 1050 material having a thickness of 0.3 mm to produce a support B. A rinsing treatment was performed between all the treatment steps. After the rinsing treatment, water was drained using a nip roller.

Alkaline etching treatment

The aluminum plate obtained in the above-described manner was subjected to an etching treatment by spraying a caustic soda aqueous solution in which the concentration of caustic soda was 26% by mass and the concentration of aluminum ions was 6.5% by mass using a spray at a temperature of 70°C. Then, rinsing was performed by means of spraying. The amount of dissolved aluminum was 5 g/$m^2$.

Desmutting treatment using acidic aqueous solution

Next, a desmutting treatment was performed using an aqueous nitric acid solution. Specifically, the desmutting treatment was performed for 3 seconds by spraying the aqueous nitric acid solution onto the aluminum plate. As the aqueous nitric acid solution used for the desmutting treatment, a waste liquid of nitric acid used for the subsequent electrochemical roughening treatment step was used. The liquid temperature was 35°C.

Electrochemical roughening treatment

An electrochemical roughening treatment was continuously performed using an AC voltage of 60 Hz in nitric acid electrolysis. As an electrolytic solution at this time, an electrolytic solution which had been adjusted to have a concentration of aluminum ions of 4.5 g/L by adding aluminum nitrate to a nitric acid aqueous solution having a concentration of 10.4 g/L at a liquid temperature of 50°C was used. The AC power source waveform is a waveform illustrated in FIG. 4. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. An electrolytic cell illustrated in FIG. 5 was used as the electrolytic cell. The current density was 71 A/$dm^2$ in terms of the peak current value of the alternating current waveform. 5% of the current from the power source was separately flowed to the auxiliary anode. The electricity quantity (C/$dm^2$) was 205 C/$dm^2$, which is the total quantity of electricity used during the anodic reaction of the aluminum plate. Then, rinsing was performed by means of spraying.

Alkaline etching treatment

The aluminum plate obtained in the above-described manner was subjected to an etching treatment by spraying a caustic soda aqueous solution in which the concentration of caustic soda was 5% by mass and the concentration of aluminum ions was 0.5% by mass using a spray at a temperature of 35°C. Then, rinsing was performed by means of spraying. The amount of dissolved aluminum was 0.2 g/$m^2$.

Desmutting treatment using acidic aqueous solution

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, an aqueous solution having a sulfuric acid concentration of 170 g/L and an aluminum ion concentration of 5 g/L was used. The liquid temperature was 30°C.

Electrochemical roughening treatment

An electrochemical roughening treatment was continuously performed using an AC voltage of 60 Hz in hydrochloric acid electrolysis. An electrolytic solution at a liquid temperature of 35°C was used which was prepared by adding aluminum chloride to 5.0 g/L aqueous hydrochloric acid solution such that the aluminum ion concentration was

adjusted to 4.5 g/L. The AC power source waveform is a waveform illustrated in FIG. 4. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. An electrolytic cell illustrated in FIG. 5 was used as the electrolytic cell. The current density was 71 A/dm$^2$ in terms of the peak current value of the alternating current waveform. 5% of the current from the power source was separately flowed to the auxiliary anode. The electric quantity (C/dm$^2$) in the hydrochloric acid electrolysis was 75 C/dm$^2$ in total in terms of the electric quantity of the aluminum plate at the time of the anodic reaction. Then, rinsing was performed by means of spraying.

Alkaline etching treatment

The aluminum plate obtained in the above-described manner was subjected to an etching treatment by spraying a caustic soda aqueous solution in which the concentration of caustic soda was 5% by mass and the concentration of aluminum ions was 0.5% by mass using a spray at a temperature of 35°C. Then, rinsing was performed by means of spraying. The amount of dissolved aluminum was 0.05 g/m$^2$.

Desmutting treatment using acidic aqueous solution

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, a waste liquid generated in the anodization treatment step (an aqueous solution having a sulfuric acid concentration of 170 g/L and an aluminum ion concentration of 5 g/L) was used. The liquid temperature was 35°C.

First-stage anodization treatment

By using the anodization treatment device for direct current electrolysis having the structure shown in FIG. 6, a first-stage anodization treatment was performed. As the electrolytic solution, an electrolytic solution having a sulfuric acid concentration of 170 g/L and an aluminum ion concentration of 7.5 g/L and having a liquid temperature of 43°C was used. The treatment was performed at a current density of 30 A/dm$^2$ to form an anodic oxide film having a film amount of 0.2 g/m$^2$.

Pore widening treatment

The aluminum plate after being subjected to the anodization treatment was subjected to a pore widening treatment by being immersed in a caustic soda aqueous solution having a caustic soda concentration of 5% by mass and an aluminum ion concentration of 0.5% by mass at a temperature of 35°C. Then, rinsing was performed by means of spraying.

Second-stage anodization treatment

By using the anodization treatment device for direct current electrolysis having the structure shown in FIG. 6, a second-stage anodization treatment was performed. As the electrolytic solution, an electrolytic solution having a sulfuric acid concentration of 170 g/L and an aluminum ion concentration of 7.5 g/L and having a liquid temperature of 52°C was used. The treatment was performed at a current density of 13 A/dm$^2$ to form an anodic oxide film having a film amount of 2.3 g/m$^2$.

Formation of back coating

The back surface of the support subjected to the surface treatment as described above was coated with the following back coating liquid using a bar coater, dried at 100°C for 1 minute, and a back coating having a coating amount of 50 mg/m$^2$ after drying was provided, thereby obtaining an aluminum support B.

Sol-gel reaction solution

· Tetraethyl silicate: 50.0 parts
· Water: 86.4 parts

· Methanol: 10.8 parts
· Phosphoric acid (85 mass% aqueous solution): 0.08 parts

In a case where the respective components described in the sol-gel reaction solution were mixed and stirred, heat was generated in about 35 minutes. After stirring and reacting for 40 minutes, the mixture was further mixed with the following diluent to prepare a back coating solution.

Diluent solution

· Pyrogallol acetone condensation resin: 15.0 parts
· Dibutyl maleate: 5.0 parts
· Methanol silica sol manufactured by Nissan Chemical Corporation: 70.0 parts
· DOWSIL FZ-2123 manufactured by Dow Toray Co., Ltd.: 0.1 parts
· Methanol: 650 parts
· 1-Methoxy-2-propanol: 200 parts

Production of undercoat layer B

The above-described support B was coated with the undercoat layer coating liquid having the following composition such that the dry coating amount was 0.1 g/m$^2$. In this way, an undercoat layer was formed.

Undercoat layer coating liquid B

· Compound for undercoat layer (the following U-1, 11% aqueous solution): 0.10502 parts
· Sodium gluconate: 0.0700 parts
· Surfactant (EMALEX (registered trademark) 710, manufactured by NIHON EMULSION Co., Ltd.): 0.00159 parts
· Preservative (BIOHOPE L, manufactured by K·I Chemical Industry Co., Ltd.): 0.00149 parts
· Water: 2.8719 parts

(U-1)

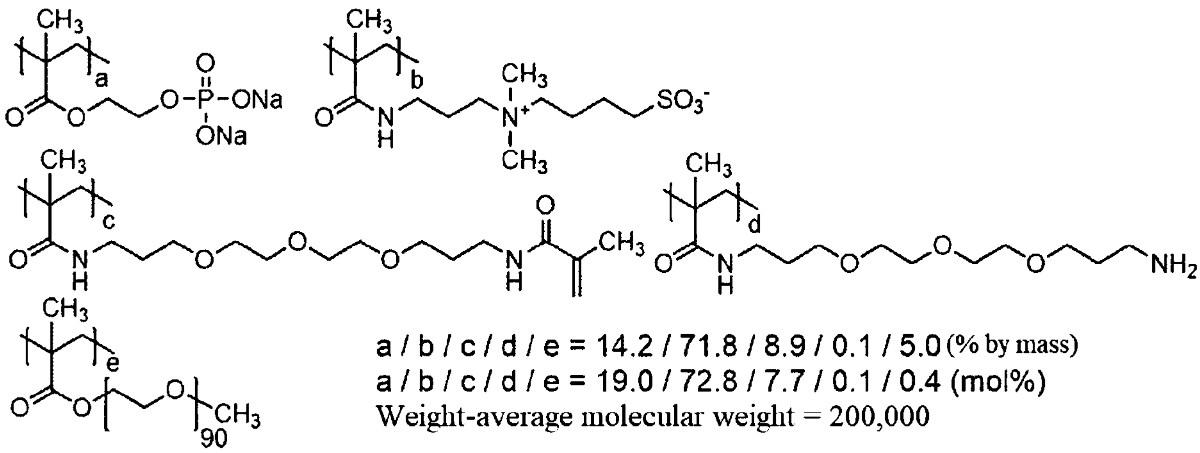

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200,000

Formation of image-recording layer B

The above-described undercoat layer B was bar-coated with the following image-recording layer coating liquid and dried in an oven at 120°C for 40 seconds, thereby forming an image-recording layer B having a dry coating amount of 1.0 g/m$^2$ and thus preparing a lithographic printing plate precursor.

Image-recording layer coating liquid B
Infrared absorber (IR-1, structure as above): 0.0270 parts

Infrared absorber (IR-2, structure as described above): 0.0080 parts
Color developing agent (S-1, structure as above): 0.0300 parts
Color developing agent (S-2, structure shown above): 0.0120 parts
Onium-based polymerization initiator (I-1, structure shown above): 0.0981 parts
Borate compound (sodium tetraphenylborate (TPB)): 0.0200 parts
Polymerizable compound (M-4, 70%): 0.2726 parts
Polymer (A-3): 0.0042 parts
Anionic surfactant (A-1, structure as above, 30%): 0.0200 parts
2-Butanone: 5.6432 parts
· 1-Methoxy-2-propanol: 3.1009 parts
Methanol: 2.4645 parts
The above-described microgel liquid 1: 2.3256 parts

Production of protective layer B

The image-recording layer B was bar-coated with the following protective layer coating solution B and dried in an oven at 120°C for 60 seconds to form a protective layer B having a dry coating amount of 0.1 g/m$^2$, thereby preparing a lithographic printing plate precursor of Example 9.

Image-recording layer coating liquid B
Inorganic lamellar compound dispersion (1): 0.5625 parts
Hydrophilic polymer (1) (20% aqueous solution of the following compound): 0.0825 parts
METOLOSE SM04 (methyl cellulose, manufactured by Shin-Etsu Chemical Co., Ltd., methoxy substitution degree = 1.8): 0.0250 parts
RAPISOL A-80 (anionic surfactant, manufactured by NOF CORPORATION, 80% aqueous solution): 0.0007 parts
Deionized water: 4.3300 parts

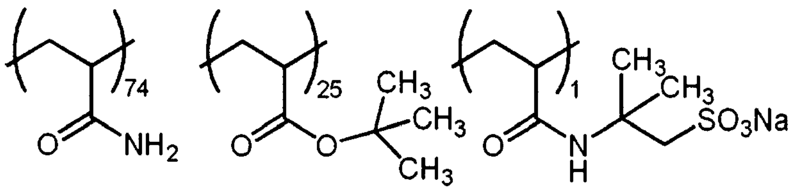

Hydrophilic polymer (1)

Example 11

The lithographic printing plate precursor of Example 11 has the following undercoat layer C, the following image-recording layer C, and the following protective layer C with respect to the following support C.

Preparation of support C

The following treatment was performed on an aluminum plate (aluminum alloy plate) of a material 1S having a thickness of 0.3 mm to produce a support C. A rinsing treatment was performed between all the treatment steps. After the rinsing treatment, water was drained using a nip roller.

Mechanical roughening treatment (brush graining method)

By using the device shown in FIG. 3, a pumice suspension (specific gravity: 1.1 g/cm$^3$) as an abrasive slurry was supplied to the surface of an aluminum plate, and in this state, a mechanical roughening treatment is performed using a rotating bundled brush. In FIG. 3, 1 represents an aluminum plate, 2 and 4 represent roller-shaped brushes (bundled brushes in the present example), 3 represents an abrasive slurry, and 5, 6, 7, and 8 represent support rollers.

In the mechanical roughening treatment, the median diameter (μm) of the abrasive was set to 30 μm, the number of brushes was set to 4, and the rotation speed (rpm: rotation/min, the same applies hereinafter) of the brush was set to 250 rpm. The bundled brush was made of 6·10 nylon and consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush

was pressed until the load of the drive motor for rotating the brush was 10 kW higher than the load applied before the bundled brush was pressed on the aluminum plate. The rotation direction of the brush was the same as the moving direction of the aluminum plate.

Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 10 g/$m^2$.

Desmutting treatment using acidic aqueous solution

As an acidic aqueous solution, the waste liquid of nitric acid used in the following step, an electrochemical roughening treatment, at a liquid temperature of 35°C was sprayed on the aluminum plate for 3 seconds. In this way, a desmutting treatment was performed.

Electrochemical roughening treatment using aqueous nitric acid solution

An electrochemical roughening treatment was continuously performed using alternating current voltage of 60 Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. The AC power source waveform is a waveform illustrated in FIG. 4. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. An electrolytic cell illustrated in FIG. 5 was used as the electrolytic cell. The peak current density was 30 A/$dm^2$, and 5% of the current coming from the power source was allowed to flow into the auxiliary anode. The electricity quantity (C/$dm^2$) was 185 C/$dm^2$, which is the total quantity of electricity used during the anodic reaction of the aluminum plate.

Alkaline etching treatment

An aqueous solution of caustic soda having a caustic soda concentration of 27% by mass and an aluminum ion concentration of 2.5% by mass was sprayed onto the aluminum plate at a temperature of 50°C, thereby performing an etching treatment. The amount of dissolved aluminum was 3.5 g/$m^2$.

Desmutting treatment using acidic aqueous solution

As an acidic aqueous solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

Electrochemical roughening treatment using aqueous hydrochloric acid solution

An electrochemical roughening treatment was continuously performed using alternating current voltage of 60 Hz. An electrolytic solution at a liquid temperature of 35°C was used which was prepared by adding aluminum chloride to 6.2 g/L aqueous hydrochloric acid solution such that the aluminum ion concentration was adjusted to 4.5 g/L. The AC power source waveform is a waveform illustrated in FIG. 4. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. An electrolytic cell illustrated in FIG. 5 was used as the electrolytic cell. The peak current density was 25 A/$dm^2$, and the electricity quantity (C/$dm^2$) during the hydrochloric acid electrolysis was 63 C/$dm^2$ which is the total quantity of electricity used during the anodic reaction of the aluminum plate.

Alkaline etching treatment

An aqueous solution of caustic soda having a caustic soda concentration of 5% by mass and an aluminum ion concentration of 0.5% by mass was sprayed onto the aluminum plate at a temperature of 60°C, thereby performing an

etching treatment. The amount of dissolved aluminum was 0.2 g/m$^2$.

Desmutting treatment using acidic aqueous solution

As an acidic aqueous solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

First-stage anodization treatment

By using the anodization treatment device for direct current electrolysis having the structure shown in FIG. 6, a first-stage anodization treatment was performed. By using a 170 g/L aqueous sulfuric acid solution as an electrolytic solution, an anodization treatment was performed under the conditions of a liquid temperature of 50°C and a current density of 30 A/dm$^2$, thereby forming an anodic oxide film having a film amount of 0.3 g/m$^2$.

Pore widening treatment

The aluminum plate having undergone the anodization treatment was immersed in an aqueous solution of caustic soda having a caustic soda concentration of 5% by mass and an aluminum ion concentration of 0.5% by mass for 3 seconds at 40°C, thereby performing a pore widening treatment.

Second-stage anodization treatment

By using the anodization treatment device for direct current electrolysis having the structure shown in FIG. 6, a second-stage anodization treatment was performed. By using a 170 g/L aqueous sulfuric acid solution as an electrolytic solution, an anodization treatment was performed under the conditions of a liquid temperature of 50°C and a current density of 13 A/dm$^2$, thereby forming an anodic oxide film having a film amount of 2.6 g/m$^2$.

Hydrophilic treatment

In order to ensure the hydrophilicity of the non-image area, the aluminum plate was immersed in a 2.5% by mass No. 3 aqueous sodium silicate solution at 50°C for 7 seconds, thereby performing a silicate treatment. The amount of Si adhered was 8.5 mg/m$^2$. The average diameter of the micropores was 30 nm.

Formation of back coating

The back surface of the support subjected to the surface treatment as described above was coated with the following back coating liquid using a bar coater, dried at 100°C for 1 minute, and a back coating having a coating amount of 50 mg/m$^2$ after drying was provided, thereby obtaining an aluminum support C.

Sol-gel reaction solution

· Tetraethyl silicate: 50.0 parts
· Water: 86.4 parts
· Methanol: 10.8 parts
· Phosphoric acid (85 mass% aqueous solution): 0.08 parts

In a case where the respective components described in the sol-gel reaction solution were mixed and stirred, heat was generated in about 35 minutes. After stirring and reacting for 40 minutes, the mixture was further mixed with the following diluent to prepare a back coating solution.

Diluent solution

· Pyrogallol acetone condensation resin: 15.0 parts

- · Dibutyl maleate: 5.0 parts
- · Methanol silica sol manufactured by Nissan Chemical Corporation: 70.0 parts
- · DOWSIL FZ-2123 manufactured by Dow Toray Co., Ltd.: 0.1 parts
- · Methanol: 650 parts
- · 1-Methoxy-2-propanol: 200 parts

Production of undercoat layer C

The support C obtained above was coated with an undercoat layer coating liquid C having the following composition such that the dry coating amount was 26 mg/m$^2$, thereby forming an undercoat layer C.

Undercoat layer coating liquid C

- · Compound for undercoat layer (2) (the following structure): 0.13 parts
- · Hydroxyethyl iminodiacetic acid: 0.05 parts
- · Tetrasodium ethylenediaminetetraacetate: 0.05 parts
- · Polyoxyethylene lauryl ether: 0.03 parts
- · Water: 61.39 parts

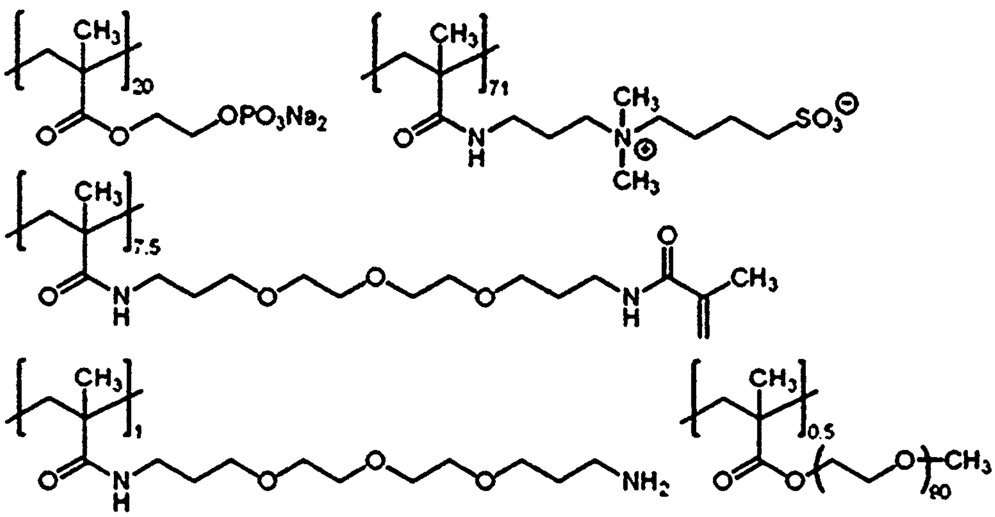

Compound for undercoat layer (2) Mw 100,000

Production of image-recording layer C

The undercoat layer C was bar-coated with an image-recording layer coating solution C having the following composition and dried in an oven at 100°C for 60 seconds, thereby forming an image-recording layer C having a thickness of 1.2 μm.

Image-recording layer coating liquid C

- · 23% by mass 1-methoxy-2-propanol solution of binder polymer (1) (the following structure): 0.3750 parts
- · 23% by mass 1-methoxy-2-propanol solution of binder polymer (2) (the following structure): 0.3834 parts
- · Infrared absorber (1) (the following structure): 0.0185 parts
- · Borate compound (1) (sodium tetraphenylborate): 0.0040 parts
- · Polymerization initiator (1) (the following structure): 0.1250 parts
- · Polymerizable compound (1) (tris(acryloyloxyethyl)isocyanurate, NK ESTER A-9300 40% 2-butanone solution, manufactured by SHIN-NAKAMURA CHEMICAL Co., Ltd.): 0.2050 parts

Low-molecular-weight hydrophilic compound (1) (tris(2-hydroxyethyl)isocyanurate): 0.0287 parts

- Low-molecular-weight hydrophilic compound (2) (trimethylglycine): 0.0147 parts
- Anionic surfactant 1: 30% by mass aqueous solution (the following structure): 0.240 parts
- Ultraviolet absorber (1) (TINUVIN405, manufactured by BASF SE) (the following structure): 0.040 parts
- Polymer (A-3): 0.0042 parts
- Phosphonium compound (1) (the following structure): 0.025 parts
- Ammonium group-containing polymer (1) (the following structure, reduced specific viscosity: 44 ml/g): 0.030 parts
- Benzyldimethyloctylammonium·$PF_6$ salt: 0.023 parts
- 2-Butanone: 5.391 parts
- 1-Methoxy-2-propanol: 3.154 parts
- Methanol: 1.117 parts
- The above-described microgel liquid 1: 2.843 parts

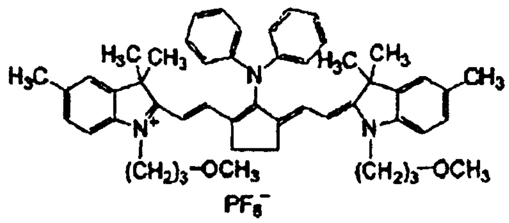

Infrared absorber (1)

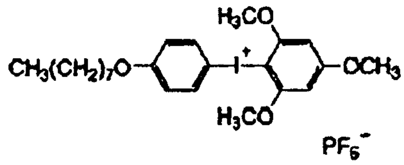

Polymerization initiator (1)

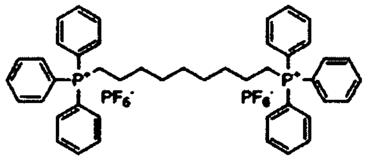

Phosphonium compound (1)

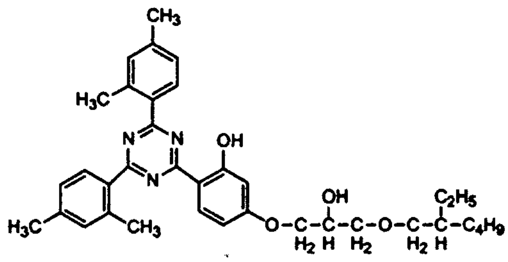

Ultraviolet absorber (1)

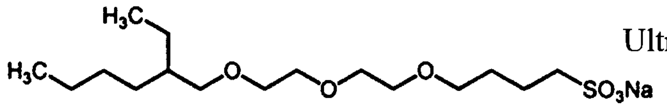

Anionic surfactant 1

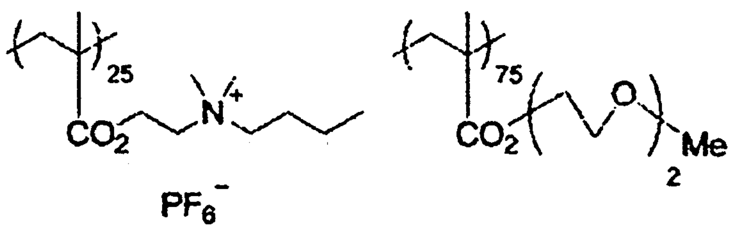

Ammonium group-containing polymer

Synthesis of binder polymer (1)

78.0 g of 1-methoxy-2-propanol was weighed in a three-neck flask and heated to 70°C in a nitrogen stream. A mixed solution consisting of 52.1 g of BLEMMER PME-100 (methoxy diethylene glycol monomethacrylate, manufactured by NOF Corporation), 21.8 g of methyl methacrylate, 14.2 g of methacrylic acid, 2.15 g of hexakis(3-mercaptopropionic acid) dipentaerythritol, 0.38 g of V-601 (2,2'-azobis(isobutyric acid) dimethyl, manufactured by FUJIFILM Wako Pure Chemical Corporation), and 54 g of 1-methoxy-2-propanol was added dropwise to this reaction container over 2 hours and 30 minutes. After dropwise addition ended, the solution was heated to 80°C, and the reaction was continued for 2 more hours. A mixed solution consisting of 0.04 g of V-601 and 4 g of 1-methoxy-2-propanol was added thereto, the solution was heated to 90°C, and the reaction was continued for 2.5 hours. After the reaction ended, the reaction solution was cooled to room temperature.

137.2 g of 1-methoxy-2-propanol, 0.24 g of 4-hydroxy tetramethylpiperidine-N-oxide, 26.0 g of glycidyl methacrylate, and 3.0 g of tetraethylammonium bromide were added to the reaction solution, and the resulting solution was stirred thoroughly and heated to 90°C.

After 18 hours, the reaction solution was cooled to room temperature (25°C) and diluted by adding 99.4 g of 1-methoxy-2-propanol thereto.

The concentration of solid contents in the binder polymer (1) which had been obtained in the above-described manner was 23% by mass, and the weight-average molecular weight thereof in terms of polystyrene which had been measured by GPC was 35,000.

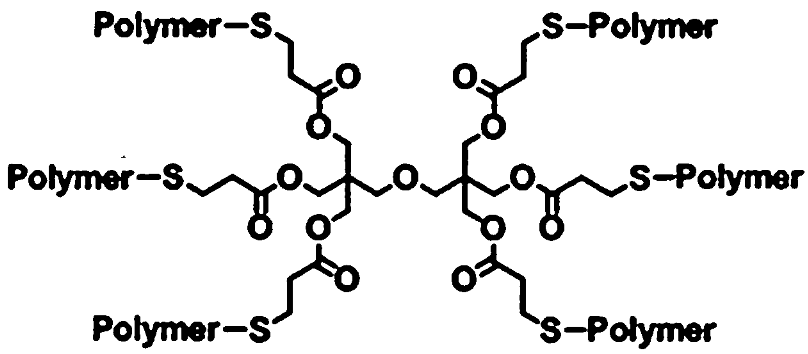

Polymer site

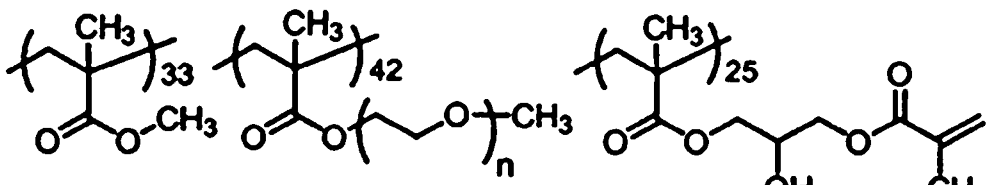

Binder polymer (1)

n = 2

Synthesis of binder polymer (2)

78.00 g of 1-methoxy-2-propanol was weighed in a three-neck flask and heated to 70°C in a nitrogen stream. A mixed solution consisting of 65.8 g of BLEMMER PME-100 (methoxy diethylene glycol monomethacrylate, manufactured by NOF Corporation), 28.4 g of methyl methacrylate, 2.8 g of methacrylic acid, 6.4 g of hexakis(3-mercaptopropionic acid) dipentaerythritol, 1.1 g of V-601 (2,2'-azobis(isobutyric acid) dimethyl, manufactured by FUJIFILM Wako Pure Chemical Corporation), and 55 g of 1-methoxy-2-propanol was added dropwise to this reaction container over 2 hours and 30 minutes. After dropwise addition ended, the solution was heated to 80°C, and the reaction was continued for 2 more hours. 2 hours later, a mixed solution consisting of 0.11 g of V-601 and 1 g of 1-methoxy-2-propanol was added thereto, the solution was heated to 90°C, and the reaction was continued for 2.5 hours. After the reaction ended, the reaction solution was cooled to room temperature.

177.2 g of 1-methoxy-2-propanol, 0.28 g of 4-hydroxy tetramethylpiperidine-N-oxide, 46.0 g of glycidyl methacrylate, and 3.4 g of tetrabutylammonium bromide were added to the reaction solution, and the resulting solution was stirred thoroughly and heated to 90°C.

After 18 hours, the reaction solution was cooled to room temperature (25°C) and diluted by adding 0.06 g of 4-methoxyphenol and 114.5 g of 1-methoxy-2-propanol thereto.

The concentration of solid contents in the binder polymer (2) which had been obtained in the above-described manner was 23% by mass, and the weight-average molecular weight thereof in terms of polystyrene which had been measured by GPC was 50,000.

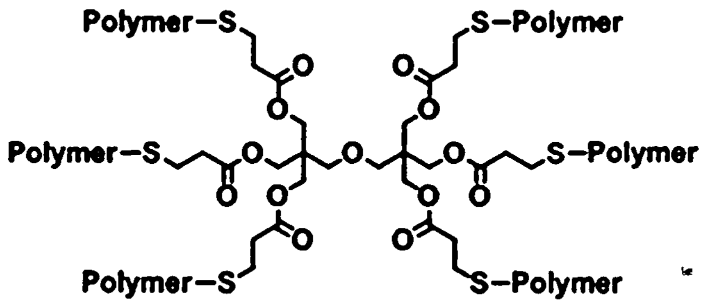

Polymer site

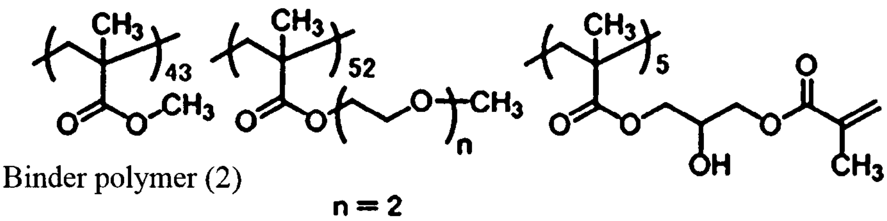

Binder polymer (2)

n = 2

Production of protective layer C

The image-recording layer C was bar-coated with a protective layer coating solution C having the following composition and dried in an oven at 120°C for 60 seconds to form a protective layer C having a thickness of 0.15 μm.

Protective layer coating liquid C
Inorganic lamellar compound dispersion (1): 1.799 parts
Hydrophilic polymer (1) (20% aqueous solution of the following compound): 0.264 parts
· Polyvinyl alcohol (CKS50 manufactured by Nippon Synthetic Chemical Industry Co., Ltd., sulfonic acid-modified, saponification degree: 99 mol% or more, degree of polymerization: 300) 6% by mass of aqueous solution 0.012 parts
Polyvinyl alcohol (PVA-405 manufactured by KURARAY Co., Ltd., saponification degree: 81.5 mol%, degree of polymerization: 500), 6% by mass of aqueous solution 0.001 parts
RAPISOL A-80 (anionic surfactant, manufactured by NOF CORPORATION, 80% aqueous solution): 0.145 parts
Deionized water: 5.3379 parts

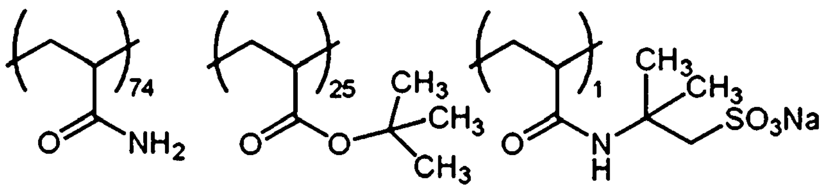

Hydrophilic polymer (1)

Preparation of inorganic lamellar compound dispersion (1)

6.4 parts of synthetic mica Somasif ME-100 (manufactured by CO-OP CHEMICAL Co., Ltd.) was added to 193.6 parts of deionized water and dispersed such that the volume average particle diameter (laser scattering method) was set to 3 μm using a homogenizer, thereby preparing an inorganic lamellar compound dispersion (1). The aspect ratio of the dispersed particles was 100 or more.

Example 12

The lithographic printing plate precursor of Example 12 has the following image-recording layer D and the following protective layer D on the same surface of the support C and the undercoat layer C as in Example 11.

Production of image-recording layer D

The undercoat layer C was bar-coated with a coating liquid D for an image-recording layer having the following composition and dried in an oven at 100°C for 60 seconds, thereby forming an image-recording layer D having a thickness of 1.2 μm, in the same manner as in Example 10.

Coating liquid D for image-recording layer

· Binder polymer (1) 23% by mass 1-methoxy-2-propanol solution (the above-described structure): 0.2891 parts
· Binder polymer (3) 23% by mass 1-methoxy-2-propanol solution (the following structure): 0.4574 parts
· Infrared absorber (1) (the following structure): 0.0278 parts
· Borate compound (1) (sodium tetraphenylborate): 0.015 parts
· Polymerization initiator (1) (the following structure): 0.2348 parts
· Polymerizable compound (1) (tris(acryloyloxyethyl)isocyanurate, NK ESTER A-9300 40% 2-butanone solution, manufactured by SHIN-NAKAMURA CHEMICAL Co., Ltd.): 0.2875 parts
Low-molecular-weight hydrophilic compound (1) (tris(2-hydroxyethyl)isocyanurate): 0.0287 parts
· Low-molecular-weight hydrophilic compound (2) (trimethylglycine): 0.0147 parts
· Anionic surfactant 1: 30% by mass aqueous solution (the following structure): 0.25 parts
· Ultraviolet absorbing agent (1) (TINUVIN405, manufactured by BASF SE) (the following structure): 0.04 parts
· Polymer (A-3): 0.0042 parts
· Phosphonium compound (1) (the following structure): 0.020 parts
· 2-Butanone: 5.346 parts
· 1-Methoxy-2-propanol: 3.128 parts
· Methanol: 0.964 parts
· Pure water: 0.036 parts
· The above microgel liquid 1: 2.8000 parts

Synthesis of binder polymer (3)

78.00 g of 1-methoxy-2-propanol was weighed in a three-neck flask and heated to 70°C in a nitrogen stream. A mixed solution consisting of 52.8 g of BLEMMER PME-100 (methoxy diethylene glycol monomethacrylate, manufactured by NOF Corporation), 2.8 g of methyl methacrylate, 25.0 g of methacrylic acid, 6.4 g of hexakis(3-mercaptopropionic acid) dipentaerythritol, 1.1 g of V-601 (2,2'-azobis(isobutyric acid) dimethyl, manufactured by Wako Pure Chemical Industries, Ltd.), and 55 g of 1-methoxy-2-propanol was added dropwise to the reaction container for 2 hours and 30 minutes. After dropwise addition ended, the solution was heated to 80°C, and the reaction was continued for 2 more hours. 2 hours later, a mixed solution consisting of 0.11 g of V-601 and 1 g of 1-methoxy-2-propanol was added thereto, the solution was heated to 90°C, and the reaction was continued for 2.5 hours. After the reaction ended, the reaction solution was cooled to room temperature.

177.2 g of 1-methoxy-2-propanol, 0.28 g of 4-hydroxy tetramethylpiperidine-N-oxide, 46.0 g of glycidyl methacrylate, and 3.4 g of tetrabutylammonium bromide were added to the reaction solution, and the resulting solution was stirred thoroughly and heated to 90°C.

After 18 hours, the reaction solution was cooled to room temperature (25°C) and diluted by adding 0.06 g of 4-methoxyphenol and 114.5 g of 1-methoxy-2-propanol thereto.

The concentration of solid contents in the binder polymer (3) which had been obtained in the above-described manner was 23% by mass, and the weight-average molecular weight thereof in terms of polystyrene which had been measured by GPC was 15,000.

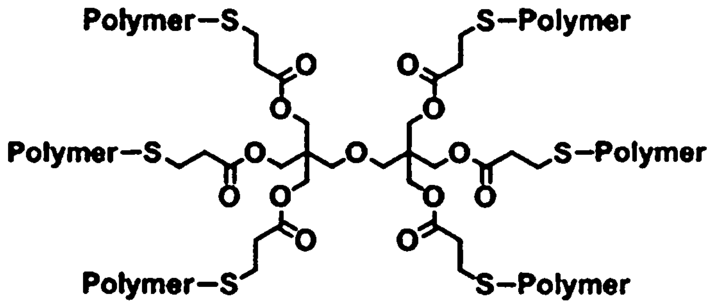

Polymer site

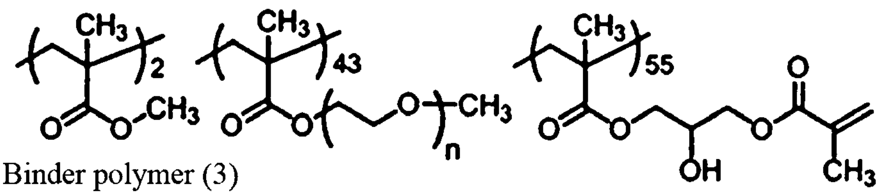

Binder polymer (3)

n = 2

Formation of protective layer D

The image-recording layer D was bar-coated with a protective layer coating solution D having the following composition and dried in an oven at 120°C for 60 seconds to form a protective layer D having a thickness of 0.18 μm.

Coating liquid D for protective layer

· Inorganic lamellar compound dispersion (1) (the above-described dispersion liquid): 2.212 parts
· Polyvinyl alcohol (GOSERAN (registered trademark) L-3266, manufactured by Nippon Synthetic Chemical Industry Co., Ltd., sulfonic acid-modified, saponification degree: 85 mol%) 6% by mass of aqueous solution: 1.440 parts · Phosphoric acid: 0.020 parts
· Diammonium phosphate: 0.032 parts
· Surfactant (PIONINE A-32-B, manufactured by TAKEMOTO OIL & FAT Co., Ltd., 40 mass% aqueous solution): 0.014 parts
· Surfactant (SURFYNOL 465 (registered trademark), manufactured by Nissin Chemical Co., Ltd.): 0.006 parts
· Pure water: 3.955 parts

Evaluation of lithographic printing plate precursor

1. Evaluation of transfer suppression property of image-recording layer

The prepared lithographic printing plate was processed into a size of 5 cm × 30 cm.

The sheet was passed through a metal nip roll in which a surface of a SUS plate having a size of 7 cm × 30 cm was brought into contact with a surface of the lithographic printing plate on the image-recording layer side and the surface was plated with hard chrome and polished smoothly under a pressurization condition of 40 MPa. After repeating this operation 5 times, the components attached to the contact surface with the image-recording layer on the SUS plate were extracted with a mixed solution of acetone/methanol = 1/1, and the amount of the attached components was quantified by high performance liquid chromatography (extraction area: 60 $cm^2$, amount of extraction solution: 5 mL). As a column, MightySil RP-18GP 250-3.0 (5 μm) manufactured by Kanto Chemical Co., Inc. was used, as a detector, SPD-M20A manufactured by Shimadzu Corporation was used, and as an eluent, a mixed solution of pure water and methanol was used. 0.1% acetic acid and 0.1% triethylamine were added to the eluent as a buffering material. The analysis was carried out under the conditions of a column temperature of 40°C and a flow rate of 0.5 mL/min.

Evaluation criteria

5: The total of the adhering components was less than 0.5 mg/m$^2$.
4: The total of the adhesion components is 0.5 mg/m$^2$ or more and less than 1.0 mg/m$^2$.
3: The total amount of the adhesion components is 1.0 mg/m$^2$ or more and less than 2.0 mg/m$^2$.
2: The total amount of the adhesion components is 2.0 mg/m$^2$ or more and less than 5.0 mg/m$^2$.
1: The total amount of the adhesion components was 5.0 mg/m$^2$ or more.

The results are shown in Table 1 below. In the evaluation standard, 3 or more is a level at which there is no practical problem, and 4 or 5 is a preferable level.
In Table 1, the item name is described as "recording layer transfer suppression property".

2. Evaluation of on-press developability

By using Magnus 800 Quantum manufactured by Kodak Japan Ltd. that was equipped with an infrared semiconductor laser, the prepared lithographic printing plate precursor was exposed (equivalent to irradiation energy of 110 mJ/cm$^2$) under the conditions of output of 27 W, an outer drum rotation speed of 450 rpm, and a resolution of 2,400 dots per inch (dpi, 1 inch is equal to 2.54 cm). The exposure image included a solid image and an amplitude modulation screen (AM screen) as a 50% halftone dot chart.
The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a nonwoven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA Co., Ltd.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing speed of 10,000 sheets/hour.
During the on-press development described above, the number of printing papers used until no ink was transferred to a non-image area was measured (hereinafter, also called number of sheets of on-press development). It can be said that the smaller the number of sheets of on-press development, the better the on-press developability. During the on-press development described above, the number of printing papers used until no ink was transferred to a non-image area was obtained as the on-press developability. It can be said that the smaller the number of printing papers, the better the on-press developability.

Evaluation criteria

5: The number of sheets of on-press development is less than 10.
4: The number of sheets of on-press development is 10 or more and less than 15.
3: The number of sheets of on-press development is 15 or more and less than 20.
2: The number of sheets of on-press development is 20 or more and less than 30.
1: The number of sheets of on-press development is 30 or more.

The results are shown in Table 1 below. In the evaluation standard, 4 or 5 is a level at which there is no practical problem.
The layer configuration of each lithographic printing plate and the evaluation results are shown in Table 1 below.

[Table 1]

| | Support | Undercoat layer | Image-recording layer | | | Protective layer | Evaluation | |
|---|---|---|---|---|---|---|---|---|
| | | | Type | Polymer A or comparative polymer | Additive amount | | Transfer suppression property of recording layer | On-press developability |
| Example 1 | A | A | A | (A-1) | 0.0042 parts | A | 5 | 5 |
| Example 2 | A | A | A | (A-2) | 0.0042 parts | A | 4 | 4 |
| Example 3 | A | A | A | (A-3) | 0.0042 parts | A | 5 | 5 |
| Example 4 | A | A | A | (A-4) | 0.0042 parts | A | 4 | 4 |
| Example 5 | A | A | A | (A-5) | 0.0042 parts | A | 3 | 4 |
| Example 6 | A | A | A | (A-6) | 0.0042 parts | A | 4 | 4 |
| Example 7 | A | A | A | (A-7) | 0.0042 parts | A | 4 | 4 |
| Example 8 | A | A | A | (A-1) | 0.0042 parts | None | 4 | 4 |
| Example 9 | A | None | A | (A-1) | 0.0042 parts | A | 4 | 3 |
| Example 10 | B | B | B | (A-3) | 0.0042 parts | B | 5 | 4 |
| Example 11 | C | C | C | (A-3) | 0.0042 parts | C | 4 | 4 |
| Example 12 | C | C | D | (A-3) | 0.0042 parts | D | 4 | 4 |
| Comparative Example 1 | A | A | A | (CA-1) | 0.0042 parts | A | 1 | 4 |
| Comparative Example 2 | A | A | A | (CA-2) | 0.0042 parts | A | 4 | 1 |
| Comparative Example 3 | A | A | A | (CA-1) | 0.0042 parts | None | 1 | 2 |
| Comparative Example 4 | A | A | A | (CA-2) | 0.0042 parts | None | 2 | 1 |

As is clear from Table 1, the lithographic printing plate precursors of Examples had both the transfer suppression property of the image-recording layer and the on-press developability, which were more favorable than those of the lithographic printing plate precursors of Comparative Examples.

Examples 13 to 15 and Comparative Examples 5 and 6

lithographic printing plate precursors of Examples 13 to 15 and Comparative Examples 5 and 6 were prepared with the layer configuration shown in Table 2.

Preparation of support E

A 0.3 mm thick aluminum alloy plate made of material 1S was subjected to the treatments shown in the following (E-a) to (E-k) to produce a support for a lithographic printing plate. A rinsing treatment was performed between all the treatment steps. After the rinsing treatment, water was drained using a nip roller.

(E-a) Mechanical roughening treatment (brush graining method)

While supplying a suspension of pumice (specific gravity of 1.1 g/cm$^3$) as an abrasive slurry to the surface of the aluminum plate, a mechanical roughening treatment was carried out using a rotating bundle brush.

The median diameter (μm) of the abrasive material was set to 30 μm, the number of brushes was set to 4, and the rotation speed (rpm: rotation/min) of the brushes was set to 250 rpm. The bundle brush was made of 6·10 nylon, with bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

(E-b) Alkaline etching treatment

An aqueous solution of caustic soda having a caustic soda concentration of 26% by mass and an aluminum ion concentration of 6.5% by mass was sprayed from a spray tube onto the aluminum plate obtained above at a temperature of 70°C, thereby performing an etching treatment. Then, rinsing was performed by means of spraying. The amount of dissolved aluminum was 10 g/m$^2$.

(E-c) Desmutting treatment in acidic aqueous solution

Next, a desmutting treatment was performed in an aqueous nitric acid solution. As the aqueous nitric acid solution used in the desmutting treatment, the waste liquid of nitric acid used in the next step, electrochemical roughening, was used. The liquid temperature was 35°C. The desmutting treatment was performed for 3 seconds by spraying the desmutting liquid.

(E-d) Electrochemical roughening treatment

An electrochemical roughening treatment was continuously performed using nitric acid as an electrolyte at an alternating current voltage of 60 Hz. In this treatment, an electrolytic solution was used which was prepared by adding aluminum nitrate to an aqueous solution of 10.4 g/L nitric acid at a temperature of 35°C such that the aluminum ion concentration was adjusted to 4.5 g/L. Using a trapezoidal rectangular waveform AC having a time tp, until the current value reached a peak from zero, of 0.8 msec and a duty ratio of 1:1 as the AC power source waveform, the electrochemical roughening treatment was carried out using a carbon electrode as a counter electrode. As an auxiliary anode, ferrite was used. The current density was 30 A/dm$^2$ in terms of the peak value of current, and 5% of the current coming from the power source was allowed to flow into the auxiliary anode. The electricity quantity (C/dm$^2$) was 185 C/dm$^2$, which is the total quantity of electricity used during the anodic reaction of the aluminum plate. Then, rinsing was performed by means of spraying.

(E-e) Alkaline etching treatment

An aqueous solution of caustic soda having a caustic soda concentration of 5% by mass and an aluminum ion concentration of 0.5% by mass was sprayed from a spray tube onto the aluminum plate obtained above at a temperature of 50°C, thereby performing an etching treatment. Then, rinsing was performed by means of spraying. The amount of dissolved aluminum was 0.5 g/m$^2$.

(E-f) Desmutting treatment in acidic aqueous solution

Next, a desmutting treatment was performed in an aqueous sulfuric acid solution. In the desmutting treatment, an aqueous sulfuric acid solution having a sulfuric acid concentration of 170 g/L and an aluminum ion concentration of 5 g/L was used. The liquid temperature was 30°C. The desmutting treatment was performed for 3 seconds by spraying the desmutting liquid.

(E-g) Electrochemical roughening treatment

An electrochemical roughening treatment was continuously performed using hydrochloric acid as an electrolyte at an alternating current voltage of 60 Hz. An electrolytic solution was used which was prepared by adding aluminum chloride to an aqueous solution of 6.2 g/L hydrochloric acid at a liquid temperature of 35°C such that the aluminum ion concentration was adjusted to 4.5 g/L. Using a trapezoidal rectangular waveform AC having a time tp, until the current value reached a peak from zero, of 0.8 msec and a duty ratio of 1:1, the electrochemical roughening treatment was carried out using a carbon electrode as a counter electrode. As an auxiliary anode, ferrite was used.

The current density was 25 A/dm$^2$ in terms of peak value of current, and the electricity quantity (C/dm$^2$) during the hydrochloric acid electrolysis was 63 C/dm$^2$ which is the total quantity of electricity used during the anodic reaction of the aluminum plate. Then, rinsing was performed by means of spraying.

(E-h) Alkaline etching treatment

An aqueous solution of caustic soda having a caustic soda concentration of 5% by mass and an aluminum ion concentration of 0.5% by mass was sprayed from a spray tube onto the aluminum plate obtained above at a temperature of 50°C, thereby performing an etching treatment. Then, rinsing was performed by means of spraying. The amount of dissolved aluminum was 0.1 g/m$^2$.

(E-i) Desmutting treatment in acidic aqueous solution

Next, a desmutting treatment was performed in an aqueous sulfuric acid solution. Specifically, by using a waste liquid generated in the anodization treatment step (170 g/L aqueous sulfuric acid solution containing dissolved aluminum ions at 5 g/L), the desmutting treatment was performed for 4 seconds at a liquid temperature of 35°C. The desmutting treatment was performed for 3 seconds by spraying the desmutting liquid.

(E-j) Anodization treatment

An anodization treatment was performed using an anodization treatment device for a two-stage power supply electrolytic treatment method (6 m of length for each of first and second electrolytic units, 3 m of length for each of first and second power supply units, and 2.4 m of length for each of first and second power supply electrodes). Sulfuric acid was used as the electrolytic solution supplied to the first and second electrolytic units. All the electrolytic solutions had a sulfuric acid concentration of 50 g/L (containing 0.5% by mass of aluminum ions) and a temperature of 20°C. Then, rinsing was performed by means of spraying.

(E-k) Silicate treatment

In order to ensure hydrophilicity of a non-image area, the non-image area was subjected to a silicate treatment by dipping the non-image area in 2.5% by mass of a sodium silicate aqueous solution No. 3 at 50°C for 7 seconds. An attachment amount of Si was 10 mg/m$^2$. Then, rinsing was performed by means of spraying.

Production of undercoat layer E

An undercoat layer coating liquid E shown below was applied onto the support E prepared as described above and then dried at 80°C for 15 seconds to provide an undercoat layer to obtain a support. The coating amount after drying was 15 mg/m$^2$.

Undercoat layer coating liquid E

- · Copolymer having a weight-average molecular weight of 28000 given below: 0.3 parts
- · Methanol: 100 parts
- · Water: 1 part

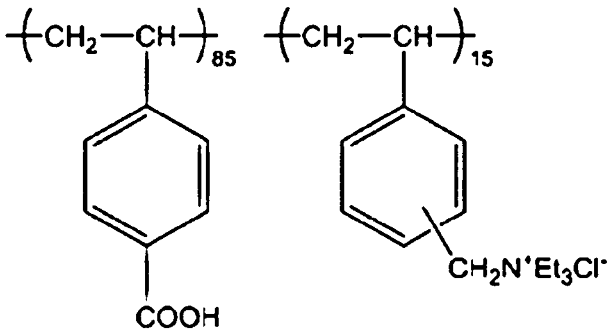

Production of image-recording layer E

The undercoat layer E is coated with a coating liquid composition E for forming an underlayer having the following composition using a wire bar, and dried in a drying oven at 150°C for 40 seconds so that the coating amount is 1.0 g/$m^2$, thereby providing an underlayer. The lower layer is coated with a coating liquid composition E for forming an upper layer having the following composition using a wire bar, thereby providing an upper layer. After the application of the upper layer, the resulting structure is dried at 150°C for 40 seconds to obtain a lithographic printing plate precursor in which a combined coating amount of the lower layer and the upper layer is 1.2 g/$m^2$.

Coating liquid composition E for forming underlayer

- N-(4-aminosulfonylphenyl) methacrylamide/acrylonitrile/methyl methacrylate copolymer (copolymerization ratio: 32/36/32, weight-average molecular weight: 50000): 0.568 parts
- m,p-cresol novolac: 0.077 parts
- Infrared absorber (IR dye (I): the structure given below): 0.041 parts
- Tetrahydrophthalic anhydride (THPA): 0.057 parts
- p-toluenesulfonic acid (p-TsO): 0.002 parts
- Propyl gallate: 0.038 parts
- 3-Methoxy-4-diazodiphenylamine hexafluorophosphate: 0.010 parts
- Ethyl violet with the counterion changed to 6-hydroxynaphthalene sulfonic acid: 0.024 parts
- Polymer ((A-1) or comparative polymer: shown in Table 2): 0.002 parts
- Methyl ethyl ketone: 7.3 parts
- 1-Methoxy-2-butyrolactone: 4.0 parts
- γ-Butyrolactone: 2.0 parts

Coating liquid composition E for forming upper layer

- Novolac resin (m-cresol/p-cresol/phenol = 3/2/5, Mw 8,000): 0.14 parts
- Ethyl methacrylate/isobutyl methacrylate/methacrylate copolymer (copolymerization ratio: 50/20/30: weight-average molecular weight: 42000): 0.03 parts
- Infrared absorber (IR dye (I): the structure given above): 0.01 parts
- Sulfonate A (the structure given below: b-1): 0.04 parts
- Methyl ethyl ketone: 3.2 parts
- 1-Methoxy-2-propanol: 6.4 parts
- The following polymer (d-2): 0.01 parts
- Polymer ((A-1) or comparative polymer: shown in Table 2): 0.002 parts

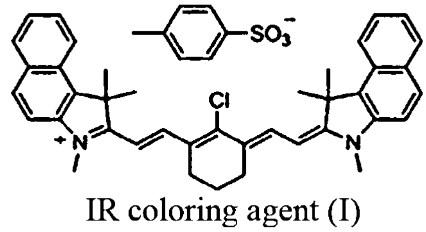

IR coloring agent (I)

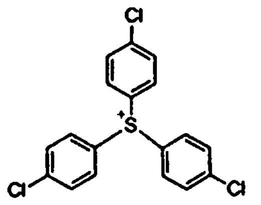 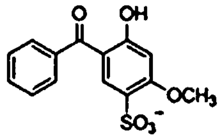

(b-1)

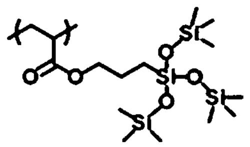 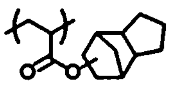 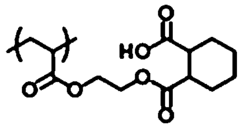

(d-2)

Production of support F

The aluminum alloy plate of the material 1S having a thickness of 0.3 mm was subjected to the treatments shown in (E-d) to (E-k) described above to produce a support for a lithographic printing plate. A rinsing treatment was performed between all the treatment steps. After the rinsing treatment, water was drained using a nip roller.

Production of undercoat layer F

An undercoat layer coating liquid F shown below was applied onto the support F prepared as described above and then dried at 80°C for 15 seconds to provide an undercoat layer to obtain a support. The coating amount after drying was 15 mg/m$^2$.

Undercoat layer coating liquid F

- · Copolymer having a weight-average molecular weight of 28000 given below: 0.3 parts
- · Methanol: 100 parts
- · Water: 1 part

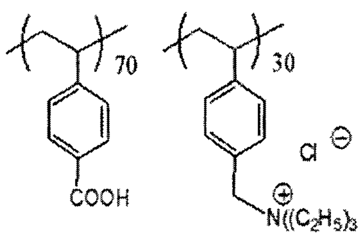

Production of image-recording layer F

The undercoat layer E or the undercoat layer F is coated with a coating liquid composition F for forming an underlayer having the following composition using a wire bar, and dried in a drying oven at 150°C for 40 seconds so that the coating amount is 1.3 g/m$^2$, thereby providing an underlayer. The lower layer is coated with a coating liquid composition F for forming an upper layer having the following composition using a wire bar, thereby providing an upper layer. After the

application of the upper layer, the resulting structure is dried at 150°C for 40 seconds to obtain a lithographic printing plate precursor in which a combined coating amount of the lower layer and the upper layer is 1.6 g/m$^2$.

Coating liquid composition F for forming underlayer

· N-(4-aminosulfonylphenyl) methacrylamide/acrylonitrile/methyl methacrylate copolymer (copolymerization ratio: 32/36/32, weight-average molecular weight: 50000): 0.858 parts
· m,p-cresol novolac: 0.184 parts
· Infrared absorber (IR dye (I): the structure given above): 0.064 parts
· Tetrahydrophthalic anhydride (THPA): 0.091 parts
· p-toluenesulfonic acid (p-TsO): 0.004 parts
· Propyl gallate: 0.06 parts
· 3-Methoxy-4-diazodiphenylamine hexafluorophosphate: 0.015 parts
· Ethyl violet with the counterion changed to 6-hydroxynaphthalene sulfonic acid: 0.019 parts
· Polymer ((A-1) or comparative polymer: shown in Table 2): 0.003 parts
· Methyl ethyl ketone: 8.0 parts
· 1-Methoxy-2-butyrolactone: 4.1 parts
· $\gamma$-Butyrolactone: 3.8 parts

Coating liquid composition F for forming upper layer

· Novolac resin (m-cresol/p-cresol/phenol = 3/2/5, Mw 8,000): 0.23 parts
· Ethyl methacrylate/isobutyl methacrylate/methacrylate copolymer (copolymerization ratio: 35/35/30: weight-average molecular weight: 50000): 0.12 parts
· Infrared absorber (IR dye (I): the structure given above): 0.02 parts
· Sulfonate (structure: b-1): 0.05 parts
· Sulfonate (the following structure: b-2): 0.004 parts
· Propyl gallate: 0.003 parts
· Methyl ethyl ketone: 3.1 parts
· 1-Methoxy-2-propanol: 6.3 parts
· The following polymer (d-2): 0.056 parts
· Polymer ((A-1) or comparative polymer: shown in Table 2): 0.002 parts

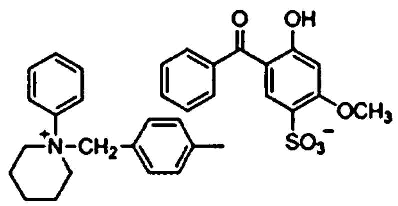

(b-2)

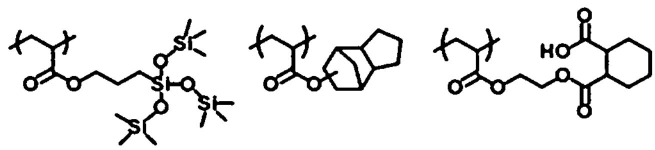

(d-2)

Production of image-recording layer G

The undercoat layer E was coated with the following composition G for forming an underlayer using a wire bar, and then dried in a drying oven at 150°C for 40 seconds so that the coating amount was 1.3 g/m$^2$, thereby providing an underlayer. The surface of the lower layer is coated with a coating liquid composition G for forming an upper layer having the following composition using a wire bar so that the amount thereof is 0.5 g/m$^2$, thereby providing an upper layer. After the application of the upper layer, the resulting structure is dried at 150°C for 40 seconds to obtain a lithographic printing plate

precursor in which a combined coating amount of the lower layer and the upper layer is 1.8 $g/m^2$.

Coating liquid composition G for forming underlayer

- Binder polymer (4): 1.0 part
- Novolac resin (m-cresol/p-cresol/phenol = 3/2/5, Mw 8,000): 0.18 parts
- Infrared absorber (IR dye (I): the structure given above): 0.031 parts
- 3-Methoxy-4-diazodiphenylamine hexafluorophosphate: 0.02 parts
- Ethyl violet with the counterion changed to 6-hydroxynaphthalene sulfonic acid: 0.03 parts
- p-toluenesulfonic acid (p-TsO): 0.01 parts
- Polymer (A-1): 0.004 parts
- Methyl ethyl ketone: 5.87 parts
- Methanol: 4.75 parts

Coating liquid composition G for forming upper layer

- Novolac resin (m-cresol/p-cresol/phenol = 3/2/5, Mw 8,000): 0.14 parts
- Isobutyl methacrylate/methacrylic acid copolymer (copolymerization ratio: 95/5, Mw: 50,000): 0.01 parts
- Infrared absorber (IR dye (I): the structure given above): 0.01 parts
- Sulfonate (structure: b-1): 0.005 parts
- Propyl gallate: 0.007 parts
- The following polymer (d-2): 0.01 parts
- Polymer (A-1): 0.002 parts
- 3-Pentanone: 1.8 parts
- Methanol: 0.1 parts

The binder polymer (4) used in the undercoat layer was synthesized with reference to the method described in WO2016/133072A, and a binder polymer (4) having the constitutional units shown below was obtained.

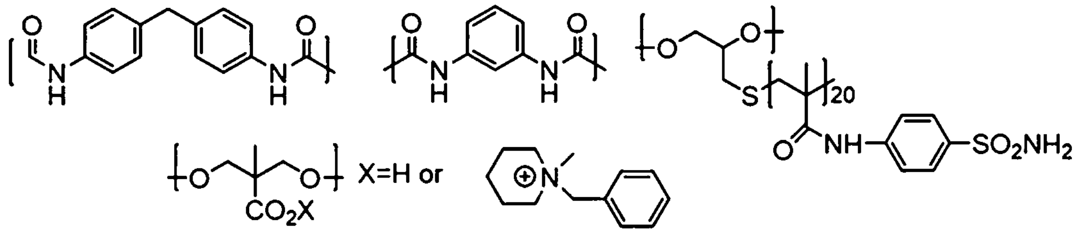

X=H or

Binder polymer (4)

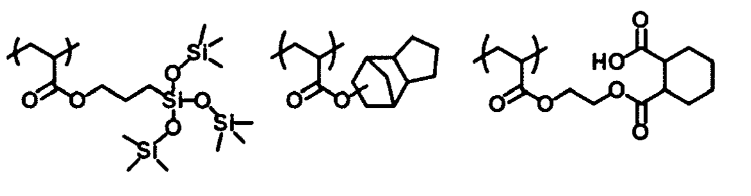

(d-2)

Evaluation of lithographic printing plate precursor

1. Transfer suppression property of image-recording layer

The transfer suppression property of the film of the image-recording layer was evaluated in the same manner as in Example 1.

The results are shown in Table 2.

2. Evaluation of developability

The positive tone lithographic printing plate precursor in each of Examples and Comparative Examples is subjected to imagewise drawing of a test pattern using Trendsetter VX manufactured by Creo Company at a beam intensity of 9 W and a drum rotation speed of 150 rpm.

Then, for Example 12, Example 13, Comparative Example 5, and Comparative Example 6, the precursor is immersed in a development bath containing a developer XP-D (diluted to have a conductivity of 42 mS/cm) manufactured by FUJIFILM Corporation, and the time until the image area is dissolved at a development temperature of 28°C and the time required for the development of the non-image area are measured.

In addition, in Example 14, the sample is immersed in a development bath containing a developer XL-D (diluted to have a conductivity of 50 mS/cm) manufactured by FUJIFILM Corporation, and the time until the image area is dissolved at a development temperature of 30°C and the time required for the development of the non-image area are measured.

The time until the image area starts to dissolve is defined as the time until the measured value of the optical density (OD value) in the image area decreases by 0.05 from the measured value of the optical density in the image area before the development treatment. In addition, the immersion time in a case where the difference between the measured value of the optical density in the non-image area and the measured value of the optical density of the aluminum support is 0.02 or less is defined as the non-image area development time. In both cases, the optical density is measured using a spectrophotometer SpectroEye manufactured by GretagMacbeth Company.

The longer the time until the image area starts to dissolve, the better the resistance to the alkali aqueous solution. Furthermore, the shorter the non-image area development time, the better the solubility in an alkali aqueous solution in the non-image area, and the better the alkali aqueous solution developability (highlight reproducibility). Therefore, in the positive tone lithographic printing plate precursor, it is evaluated that the longer the image area dissolution start time, the shorter the non-image area development time, and the greater the difference between the image area dissolution start time and the non-image area development time, the more excellent the developability.

The difference is referred to as "development discrimination".

Evaluation criteria

5: development discrimination was more than 18 seconds.
4: development discrimination was more than 15 seconds and 18 seconds or less.
3: development discrimination was more than 12 seconds and 15 seconds or less.
2: development discrimination was more than 9 seconds and 12 seconds or less.
1: Development discrimination was less than 9 seconds. The results are shown in Table 2.

[Table 2]

| | Support | Under coat layer | Image-recording layer | | | | Evaluation | |
|---|---|---|---|---|---|---|---|---|
| | | | Type | Polymer | Additive amount | | Transfer suppression property of recording layer | On-press developability |
| | | | | | Upper layer | Lower layer | | |
| Example 13 | E | E | E | (A-1) | 0.002 parts | 0.002 parts | 5 | 5 |
| Example 14 | F | F | F | (A-1) | 0.002 parts | 0.003 parts | 5 | 5 |
| Example 15 | F | E | G | (A-1) | 0.002 parts | 0.004 parts | 5 | 5 |
| Comparative Example 5 | E | E | E | (CA-1) | 0.002 parts | 0.002 parts | 3 | 4 |
| Comparative Example 6 | E | E | E | (CA-2) | 0.002 parts | 0.002 parts | 4 | 2 |

It can be seen that even in the case of the positive tone image-recording layer, the lithographic printing plate precursors of Examples have higher transfer suppression property of the image-recording layer and are more excellent in development discrimination than the lithographic printing plate precursors of Comparative Examples.

Example 16, Example 17, Comparative Example 7, and Comparative Example 8

lithographic printing plate precursors of Example 16, Example 17, Comparative Example 7, and Comparative Example 8 were prepared with the layer configurations shown in Table 3.

Production of support H

The following surface treatment was performed using an aluminum plate (JIS A1050) having a thickness of 0.03 mm.

Electrochemical roughening treatment

An electrochemical roughening treatment was continuously performed using an alternating current voltage of 60 Hz. As an electrolytic solution of this case, an aqueous solution containing 10.5 g/L of nitric acid (containing 5 g/L of aluminum ions and 0.007% by mass of ammonium ions) was used, and the liquid temperature was 50°C. Using a trapezoidal rectangular waveform AC having a time TP, until the current value reached a peak from zero, of 0.8 msec and the duty ratio of 1: 1, the electrochemical roughening treatment was performed using a carbon electrode as a counter electrode. As an auxiliary anode, ferrite was used. As the electrolytic cell, a radial cell type electrolytic cell was used. The current density was 30 A/dm$^2$ in terms of the peak value of the current, and the electric quantity was 220 C/dm$^2$ as the sum total of electric quantity in a case of anodization of the aluminum plate. 5% of the current from the power source was separately flowed to the auxiliary anode. Then, rinsing was performed by means of spraying.

Alkaline etching treatment

The aluminum plate was subjected to an etching treatment by spraying an aqueous solution in which the concentration of caustic soda was 26% by mass and the concentration of aluminum ions was 6.5% by mass at a temperature of 32°C so that 0.50 g/m$^2$ of the aluminum plate was dissolved. Further, a smut component mainly containing aluminum hydroxide generated in a case of the electrochemical roughening treatment using the alternating current at the former step was removed, and an edge portion of a generated pit was dissolved to smooth the edge portion. Then, rinsing was performed by means of spraying.

Desmutting treatment

A desmutting treatment was performed by spraying an aqueous solution (containing 4.5% by mass of aluminum ions) having a sulfuric acid concentration of 15% by mass at a temperature of 30°C, and then the material was washed with water by spraying.

Electrochemical roughening treatment

An electrochemical roughening treatment was continuously performed using an alternating current voltage of 60 Hz. As an electrolyte in this case, an aqueous solution containing 5.0 g/L of hydrochloric acid (containing 5 g/L of aluminum ions) was used, and the temperature was 35°C. Using a trapezoidal rectangular waveform AC having a time TP, until the current value reached a peak from zero, of 0.8 msec and the duty ratio of 1:1, the electrochemical roughening treatment was performed using a carbon electrode as a counter electrode. As an auxiliary anode, ferrite was used. As the electrolytic cell, a radial cell type electrolytic cell was used. The current density was 25 A/dm$^2$ as the peak current value, and the electric quantity was 50 C/dm$^2$ as the sum total of electric quantity in a case of anodization of the aluminum plate. Then, rinsing was performed by means of spraying.

Anodization treatment

An anodization treatment was performed using an anodization treatment device for a two-stage power supply electrolytic treatment method (6 m of length for each of first and second electrolytic units, 3 m of length for each of first and second power supply units, and 2.4 m of length for each of first and second power supply electrodes). The electrolytic solution supplied to the first and second electrolytic units had a sulfuric acid concentration of 50 g/L (containing 0.5% by

mass of aluminum ions) and a temperature of 20°C. Then, rinsing was performed by means of spraying. The final amount of the oxide film was 2.7 g/m2.

Hydrophilic treatment

The plate was immersed in a treatment liquid at 53°C obtained by dissolving 0.4% by mass of polyvinylphosphonic acid (manufactured by PCAS) in pure water for 10 seconds, and the excess treatment liquid was removed with a nip roller. Thereafter, the plate was washed for 4 seconds with well water at 60°C containing a calcium ion concentration of 20 to 400 ppm, and further washed for 4 seconds with pure water at 25°C, and excess pure water was removed with nip rolls. The moisture on the aluminum plate was completely removed in a subsequent drying step.

In a case where a center line average roughness (Ra in accordance with JIS B0601) of the obtained support H was measured using a needle having a diameter of 2 μm, it was 0.28 μm.

Production of image-recording layer H

The support H was coated with a coating liquid for an image-recording layer H having the following composition such that the dry coating mass was 1.4 g/m2, and dried at 100°C for 1 minute to form an image-recording layer H.

Coating liquid for image-recording layer H

· Polymerizable compound (compound A): 0.16 parts
· Binder polymer (binder A) (Mw = 50,000): 0.35 parts
· Sensitizing dye (C-1): 0.05 parts
· Polymerization initiator (D-1): 0.13 parts
· Chain transfer agent (E-1): 0.05 parts
· N-nitrosophenylhydroxylamine aluminum salt: 0.003 parts
· ε-phthalocyanine pigment (F1) dispersion: 0.12 parts
(pigment: 15 parts, dispersant: the following polymer (1): 10 parts)
· Solvent: cyclohexanone/methoxypropyl acetate/1-methoxy-2-propanol = 15 parts/20 parts/40 parts
· Polymer ((A-1) or comparative polymer: shown in Table 3): 0.003 parts
· Methyl ethyl ketone: 7.2 parts
· Propylene glycol monomethyl ether: 6.5 parts

Compound A

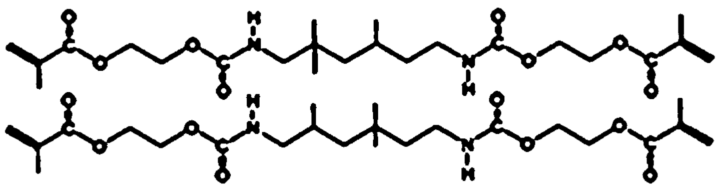

Mixture of isomer described above

Binder A

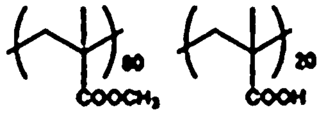

Sensitizing dye C-1

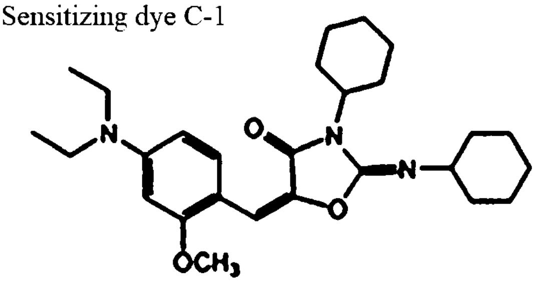

Polymerization initiator (D-1)

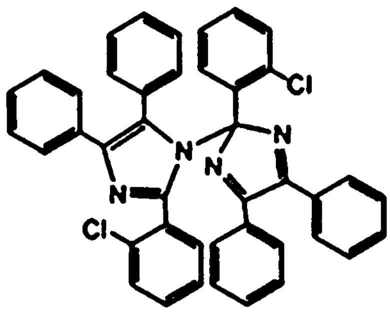

Chain transfer agent (E-1)

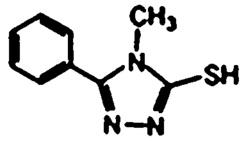

Production of protective layer H

The image-recording layer H was bar-coated with a protective layer coating liquid H having the following composition such that the coating amount after drying was 25 g/$m^2$, and dried in an oven at 125°C for 70 seconds, thereby forming a protective layer H.

Protective layer coating liquid H

- · Mica dispersion liquid shown below: 0.6 g
- · Sulfonic acid-modified polyvinyl alcohol (GOSERAN CKS-50, manufactured by Nippon Synthetic Chemical Industry Co., Ltd.(saponification degree: 99 mol%, average degree of polymerization: 300, degree of modification: about 0.4 mol%)): 0.8 g
- · Poly(vinylpyrrolidone/vinyl acetate (1/1)) (molecular weight: 70,000): 0.001 g
- · Surfactant (EMALEX (registered trademark) 710, manufactured by NIHON EMULSION Co., Ltd.): 0.002 g
- · Water: 13 g

Mica dispersion liquid

32 g of synthetic mica (SOMASIF ME-100, manufactured by CO-OP CHEMICAL Co., Ltd., aspect ratio: 1000 or more) was added to 368 g of water, and the mixture was dispersed using a homogenizer until the average particle diameter (laser scattering method) reached 0.5 μm, thereby obtaining a mica dispersion liquid.

Production of support I

An aluminum plate of a material 1S having a thickness of 0.30 mm was treated with a No. 8 nylon brush and an 800 mesh aqueous suspension of pumice stone, and the surface thereof was sanded and then thoroughly washed with water. The sample was immersed in 10% sodium hydroxide at 70°C for 60 seconds for etching, washed with running water, neutralized and washed with 20% $HNO_3$, and then washed with running water. An electrolytic roughening treatment was performed in a 1% aqueous nitric acid solution using a sinusoidal alternating waveform current at an anodic electric quantity of 300 coulombs/$dm^2$ under the condition of VA = 12.7 V. The surface roughness thereof was measured and found to be 0.45 μm (Ra display). Subsequently, the aluminum plate was immersed in a 30% $H_2SO_4$ aqueous solution, desmutting was carried out at 55°C for 2 minutes, and then the cathode was disposed on the grained surface in a 20% $H_2SO_4$ aqueous solution at 33°C, and anodization was carried out at a current density of 5 A/$dm^2$ for 50 seconds, and the thickness was 2.6 g/$m^2$. This was used as a support I.

Production of undercoat layer I

The support I was coated with the following undercoat layer coating liquid I using a bar coater such that the coating amount after drying was 2 mg/$m^2$, and dried at 80°C for 20 seconds to form an undercoat layer I.

Undercoat layer coating liquid I

· Polymer (the following structure): 0.3 parts
· Pure water: 60.0 parts
· Methanol: 939.7 parts

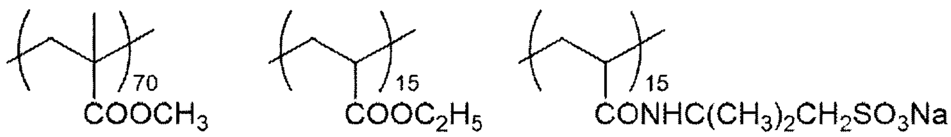

Production of image-recording layer I

The undercoat layer I was coated with a coating solution for an image-recording layer I having the following composition using a bar coater so that the coating amount after drying was 1.35 g/$m^2$, and dried at 90°C for 1 minute, thereby forming an image-recording layer I.

Coating liquid for image-recording layer I

· PLEX6661-O manufactured by Degussa: 0.12 parts
· Binder polymer PP-3 (the following structure): 0.51 parts
· Sensitizing dye D40 (the following structure): 0.03 parts
· BIMD (hexaarylbisimidazole manufactured by Kurogane Kasei Co., Ltd.): 0.09 parts
· ε-phthalocyanine (the following F-1) dispersion (25% MEK dispersion liquid): 0.12 parts
· Mercapto group-containing heterocyclic compound SH-8 (the following structure): 0.05 parts
· Polymer ((A-1) or comparative polymer: shown in Table 3): 0.005 parts
· 10% solution of Cupferron AL (manufactured by Wako Pure Chemical Industries, Ltd.) tricresyl phosphate: 0.033 parts
· Methyl ethyl ketone: 7.8 parts
· Propylene glycol monomethyl ether: 7.8 parts
· S-2358 Yellow (manufactured by Dainichiseika Color & Chemicals Mfg. Co., Ltd.): 0.04 parts

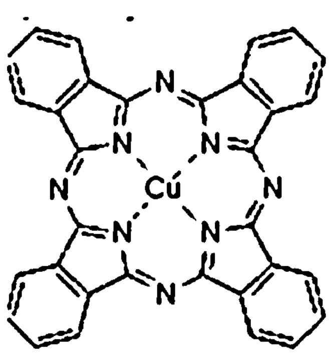

F-1

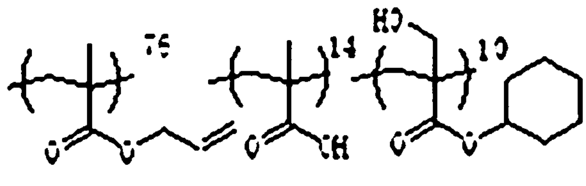

PP-3

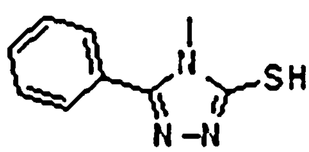

SH-8

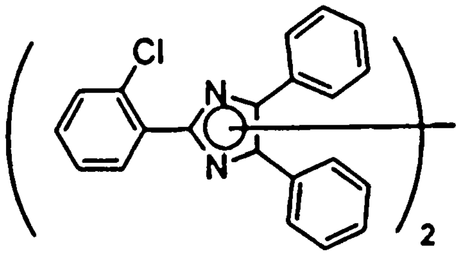

D40

Production of protective layer I

The image-recording layer I was coated with the following aqueous solution I for a protective layer using a bar coater such that the coating amount after drying was 2.5 g/$m^2$, and dried at 120°C for 1 minute, thereby forming a protective layer I.

Aqueous solution I for protective layer

· PVA105 (saponification degree: 98 mol%, manufactured by Kuraray Co., Ltd.): 1.80 parts
· Polyvinylpyrrolidone: 0.40 parts
· EMALEX 710 (nonionic surfactant manufactured by NIPPON NYUKAZAI Co., Ltd.): 0.04 parts
· PIONIN D230 (manufactured by TAKEMOTO OIL & FAT Co., Ltd., surfactant): 0.05 parts
· Luviskol V64W (manufactured by BASF SE): 0.06 parts
· 13% aqueous solution of sulfonic acid group-containing polymer having the following structure: 0.36 parts
· Pure water: 36.0 parts

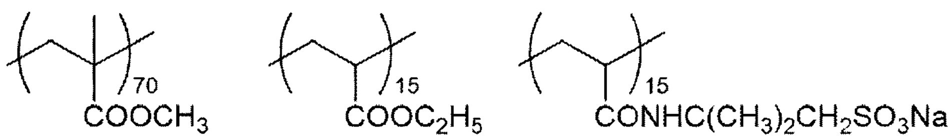

Evaluation of lithographic printing plate precursor

1. Transfer suppression property of image-recording layer

The transfer suppression property of the film of the image-recording layer was evaluated in the same manner as in Example 1.

The results are shown in Table 3.

2. Evaluation of developability

Among the negative tone lithographic printing plate precursors in each of Examples and Comparative Examples, for Examples 16, Comparative Example 7, and Comparative Example 8, the negative tone lithographic printing plate precursor is immersed in a development bath containing a developer LC-VN manufactured by FUJIFILM Corporation, and the time required for development is measured at a development temperature of 25°C. In addition, in Example 16, the time until the dissolution starts at a development temperature of 28°C and the time required for the development of the non-image area are measured by immersing the film in a development bath containing a developer LP-DS manufactured by FUJIFILM Corporation. The time required for development is defined as an immersion time at which a difference between a measured value of the optical density (OD value) in the image area and a measured value of the optical density of the aluminum support is 0.02 or less. In both cases, the optical density is measured using a spectrophotometer SpectroEye manufactured by GretagMacbeth Company.

The shorter the development time, the better the solubility in an aqueous alkali solution.

Evaluation criteria

5: development time was shorter than 6 seconds
4: development time was 6 seconds or more and less than 12 seconds.
3: development time was 12 seconds or longer and shorter than 18 seconds.
2: development time was 18 seconds or longer and shorter than 24 seconds.
1: development time was longer than 24 seconds.

The results are shown in Table 3.

[Table 3]

| | Support | Undercoat layer | Image-recording layer | | | Protective layer | Evaluation | |
|---|---|---|---|---|---|---|---|---|
| | | | Type | Polymer | Additive amount | | Film hardness of recording layer | Developability |
| Example 16 | H | None | H | (A-1) | 0.016 parts | H | 5 | 5 |
| Example 17 | I | I | I | (A-1) | 0.016 parts | I | 5 | 5 |
| Comparative Example 7 | H | None | H | (CA-1) | 0.016 parts | H | 2 | 3 |
| Comparative Example 8 | H | None | H | (CA-2) | 0.016 parts | H | 4 | 2 |

In the image-recording layer of the negative tone image-recording layer, the lithographic printing plate precursors of Examples have higher transfer suppression property of the image-recording layer and better developability than the lithographic printing plate precursors of Comparative Examples.

From the results shown in Tables 1, 2, and 3, it was found that the lithographic printing plate precursors according to Examples had excellent transfer suppression property of the image area and good developability of the non-image area in both the negative tone image-recording layer and the positive tone image-recording layer. Further, it can be seen that the lithographic printing plate precursor having the negative tone image-recording layer according to Examples has excellent on-press developability and is suitable as an on-press development type lithographic printing plate precursor.

Explanation of References

## Claims

**1.** A lithographic printing plate precursor comprising:

a support; and
an image-recording layer on the support,
wherein the image-recording layer contains a polymer A having a main chain containing two or more silicon atoms, and a hydrophilic group.

**2.** The lithographic printing plate precursor according to claim 1,
wherein the polymer A has the hydrophilic group in at least any of a side chain or a main chain terminal.

**3.** The lithographic printing plate precursor according to claim 2,
wherein the polymer A has the hydrophilic group in the side chain.

**4.** The lithographic printing plate precursor according to any one of claims 1 to 3, wherein the hydrophilic group contained in the polymer A is at least one selected from the group consisting of a hydroxy group, an amine group, a carboxy group, a carbinol group, an alkylamino group, a (poly)ether group, a (poly) glycerol group, a (poly)ester group, and a (poly)amide group.

**5.** The lithographic printing plate precursor according to any one of claims 1 to 4,

wherein the polymer A is a polymer represented by Formula (A),

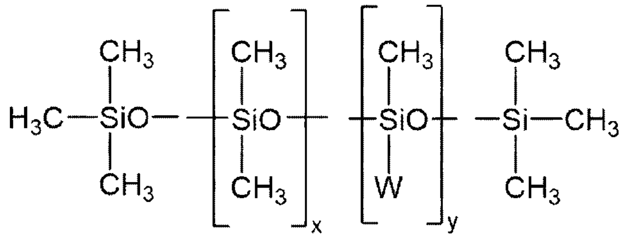

(A)

in Formula (A), W represents a hydrophilic group, x represents the number of bonds of a dimethylsiloxane structural unit and is in a range of 0 or more, and y represents the number of bonds of a siloxane structural unit having a hydrophilic group in a side chain and is in a range of 1 or more, where a bonding order between the dimethylsiloxane structural unit and the siloxane structural unit having a hydrophilic group in a side chain in Formula (A) may be either block-shaped or random-shaped.

**6.** The lithographic printing plate precursor according to any one of claims 1 to 5, wherein the image-recording layer is a negative tone photosensitive image-recording layer containing a polymerizable compound and a polymerization initiator.

**7.** The lithographic printing plate precursor according to claim 6, wherein the negative tone photosensitive image-recording layer contains an infrared absorber and an onium salt polymerization initiator as the polymerization initiator, and is an on-press development type.

**8.** The lithographic printing plate precursor according to claim 6 or claim 7, wherein the negative tone photosensitive image-recording layer further contains polymer particles, and is an on-press development type.

**9.** The lithographic printing plate precursor according to any one of claims 6 to 8, wherein the negative tone photosensitive image-recording layer further contains a color forming substance precursor, and is an on-press development type.

**10.** The lithographic printing plate precursor according to any one of claims 6 to 9, wherein the negative tone photosensitive image-recording layer contains a polyfunctional polymerizable compound, and is an on-press development type.

**11.** The lithographic printing plate precursor according to any one of claims 6 to 10,

wherein the negative tone photosensitive image-recording layer contains a borate compound represented by Formula (B1), and is an on-press development type,

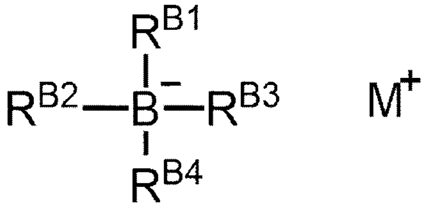

( B1 )

in Formula (B1), $R^{B1}$ to $R^{B4}$ each independently represent an unsubstituted or substituted alkyl group, an

unsubstituted or substituted aryl group, an unsubstituted or substituted alkenyl group, or an unsubstituted or substituted alkynyl group, and $R^{B1}$ to $R^{B4}$ may each independently have a ring structure, provided that, at least one of $R^{B1}$, $R^{B2}$, $R^{B3}$, or $R^{B4}$ is different from the others, and $M^+$ represents a cation.

**12.** The lithographic printing plate precursor according to any one of claims 1 to 11, further comprising: a protective layer on the image-recording layer.

**13.** The lithographic printing plate precursor according to any one of claims 1 to 12, further comprising: an undercoat layer between the support and the image-recording layer.

**14.** A method of preparing a lithographic printing plate, the method comprising:

a step of imagewise exposing the lithographic printing plate precursor according to any one of claims 1 to 13; and a step of supplying at least one selected from the group consisting of a printing ink and dampening water on a printer to remove an image-recording layer in a non-image area.

FIG. 1

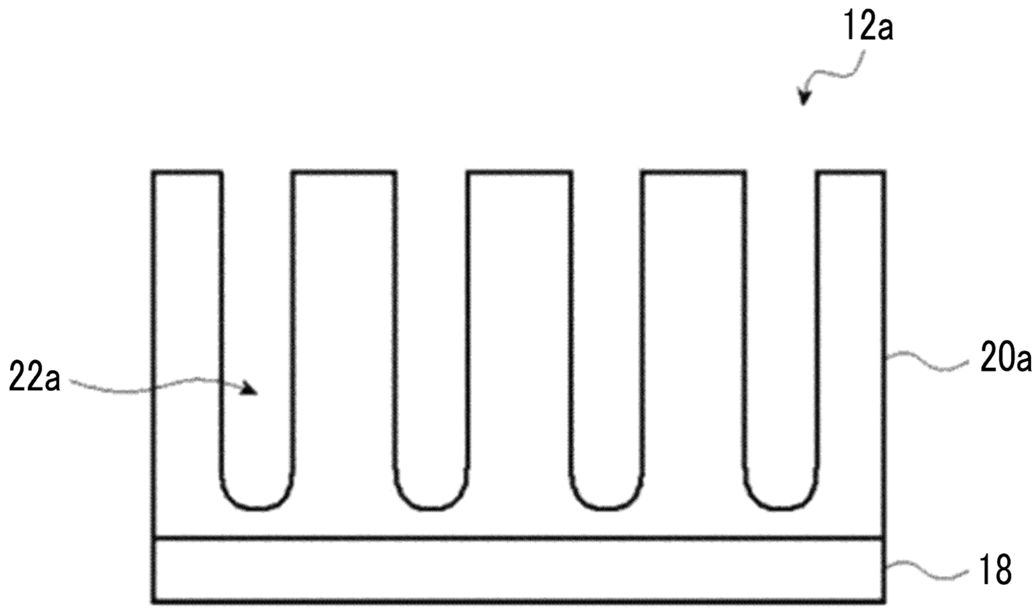


FIG. 2

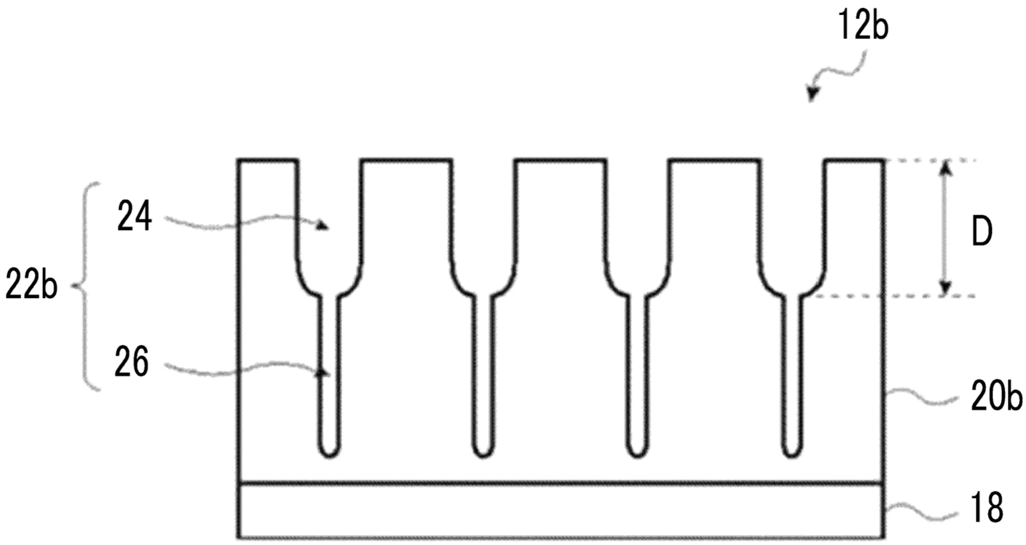

FIG. 3

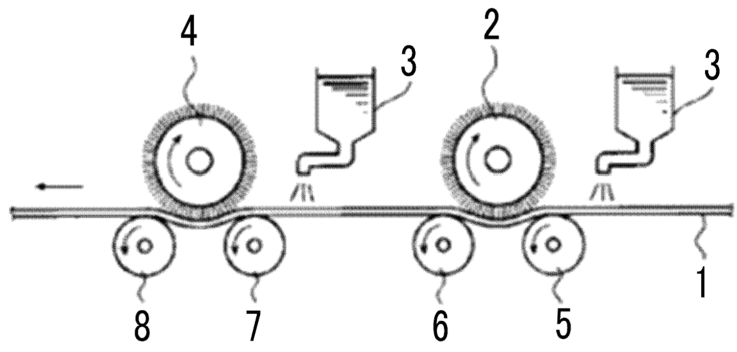


FIG. 4

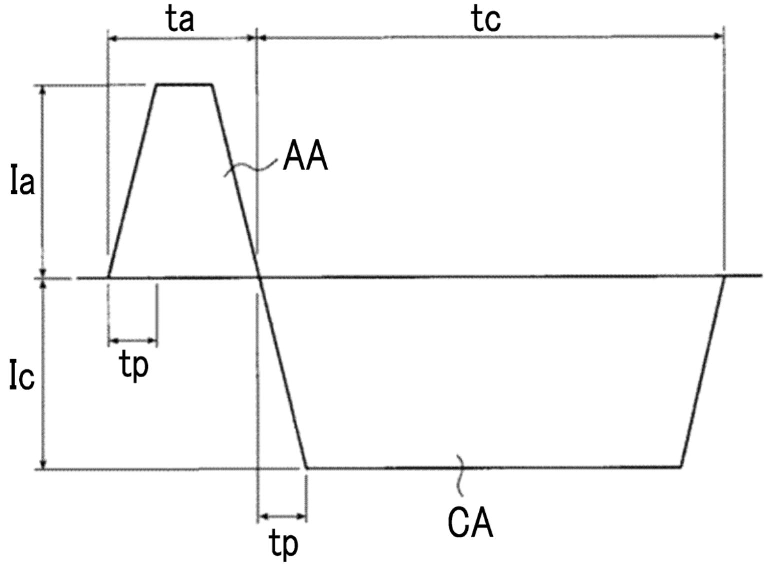

FIG. 5

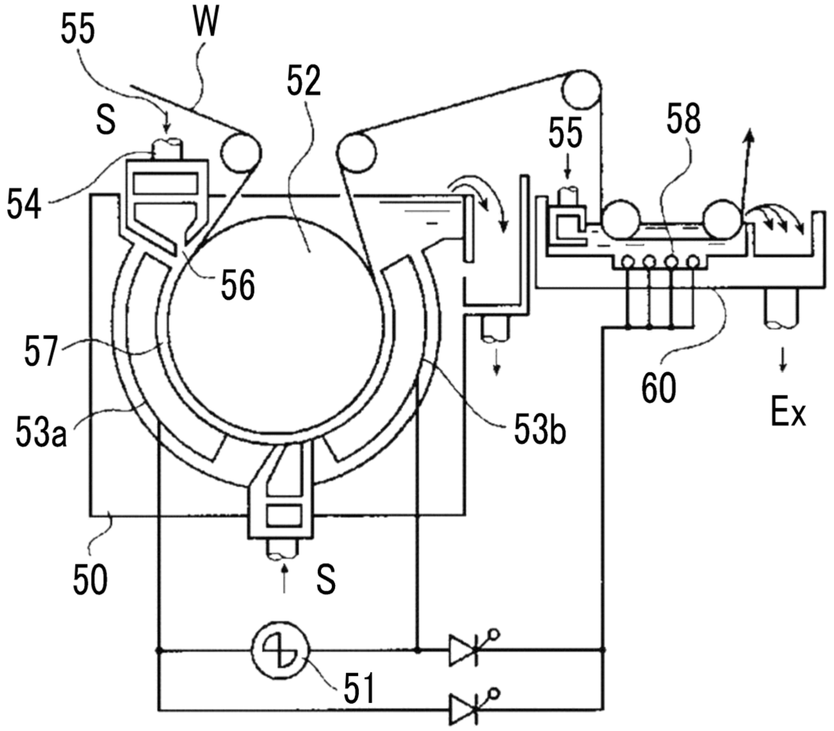
55
W
52
S
55
58
54
56
57
53a
53b
60
Ex
50
S
51

FIG. 6

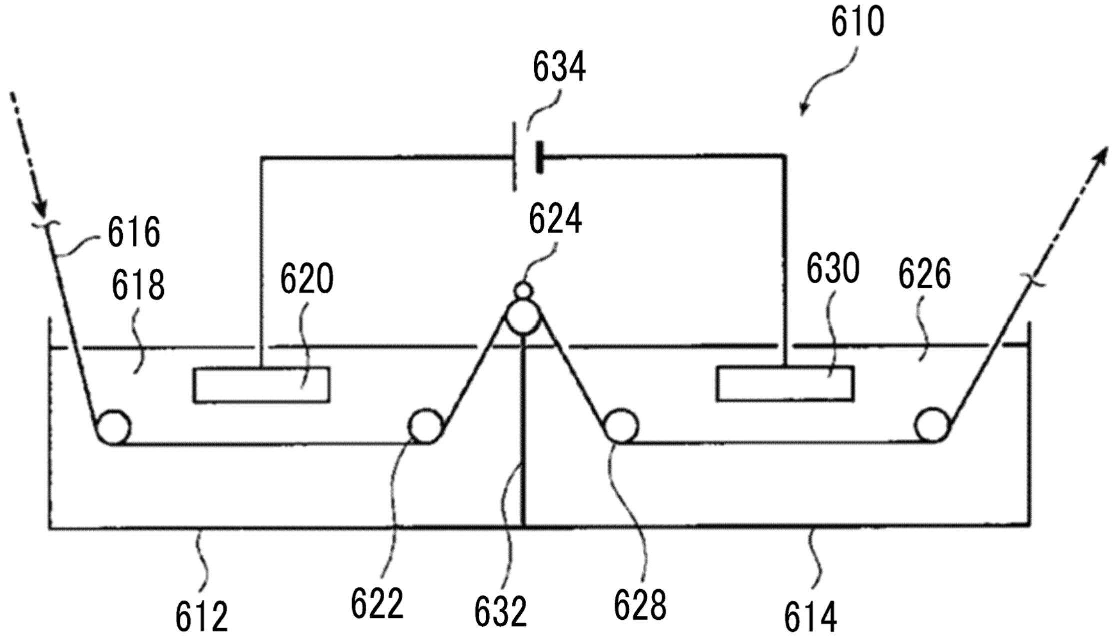
610
634
616
624
618
620
630
626
612
622
632
628
614

Europäisches Patentamt
European Patent Office
Office européen des brevets

# EUROPEAN SEARCH REPORT

Application Number
EP 25 21 8578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/136355 A1 (VAN AERT HUUB [BE] ET AL) 23 June 2005 (2005-06-23)<br>* the whole document *<br>* especially claims 1-7, the examples and 22-36 * | 1-5 | INV.<br>B41C1/10 |
| X | US 2016/054654 A1 (AOSHIMA NORIO [JP]) 25 February 2016 (2016-02-25)<br>* the whole document *<br>* especially claims 1-13 and the examples * | 1-5 | |
| X | US 2015/168837 A1 (LOCCUFIER JOHAN [BE] ET AL) 18 June 2015 (2015-06-18)<br>* the whole document *<br>* especially claims 1-28 and the examples * | 1-5 | |
| X | US 2024/391232 A1 (ARIMURA KEISUKE [JP] ET AL) 28 November 2024 (2024-11-28)<br>* the whole document *<br>* especially all the examples, BYK-302 in 755-776 and 633 * | 1-14 | TECHNICAL FIELDS SEARCHED (IPC)<br>B41C |
| X | US 2021/362529 A1 (YOKOKAWA NATSUMI [JP] ET AL) 25 November 2021 (2021-11-25)<br>* the whole document *<br>* especially BYK-306 example 1 in 960-973 and 897 * | 1-14 | |
| X | US 2012/141942 A1 (BALBINOT DOMENICO [DE] ET AL) 7 June 2012 (2012-06-07)<br>* the whole document *<br>* especially BYK-307 in examples 1-5 in 146-160 * | 1-5 | |

-/--

The present search report has been drawn up for all claims

1

| Place of search | Date of completion of the search | Examiner |
|---|---|---|
| Munich | 23 April 2026 | Vogel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches Patentamt
European Patent Office
Office européen des brevets

# EUROPEAN SEARCH REPORT

Application Number
EP 25 21 8578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/104450 A1 (MEMETEA LIVIA T [US] ET AL) 5 May 2011 (2011-05-05)<br>* the whole document *<br>* especially BYK-333 in all examples and comparative examples *<br>----- | 1-5 | |
| X | US 7 579 133 B2 (YU YISONG [CA] ET AL) 25 August 2009 (2009-08-25)<br>* the whole document *<br>* especially BYK-345 in examples 25-33 *<br>----- | 1-5 | |
| X | US 2017/021656 A1 (RAY KEVIN [US] ET AL) 26 January 2017 (2017-01-26)<br>* the whole document *<br>* especially BYK-378 in example 1 and comparative examples 2-4 *<br>----- | 1-5 | |
| X | US 2003/073032 A1 (AOSHIMA KEITARO [JP]) 17 April 2003 (2003-04-17)<br>* the whole document *<br>* especially claims 1-20 and the examples *<br>----- | 1-5,14 | TECHNICAL FIELDS SEARCHED (IPC) |
| X | US 2012/088191 A1 (ANDRE XAVIER [BE] ET AL) 12 April 2012 (2012-04-12)<br>* the whole document *<br>* especially Tego Glide 410 in tables 6+8 in all test samples *<br>----- | 1-5 | |
| X | US 2011/287365 A1 (PIESTERT OLIVER [DE] ET AL) 24 November 2011 (2011-11-24)<br>* the whole document *<br>* especially Tego Glide 440 in table 4 *<br>-----<br>-/-- | 1-5 | |

The present search report has been drawn up for all claims

1

| Place of search | Date of completion of the search | Examiner |
|---|---|---|
| Munich | 23 April 2026 | Vogel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 25 21 8578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/183622 A1 (CHECHIK HELENA [IL] ET AL) 18 July 2013 (2013-07-18)<br>* the whole document *<br>* especially Tego Glide 450 in example 1 and comparative examples 1 and 2 *<br>----- | 1-5 | |
| T | Anonymous: "Reactive & Non-Reactive Modified Silicone Fluid (For North and South America)",<br>,<br>1 July 2025 (2025-07-01), XP093391340,<br>Retrieved from the Internet:<br>URL:https://www.shinetsusilicone-global.com/catalog/pdf/ModifiedSiliconeFluid_US.pdf<br>* the whole document *<br>----- | | |

TECHNICAL FIELDS SEARCHED (IPC)

The present search report has been drawn up for all claims

1

| Place of search | Date of completion of the search | Examiner |
|---|---|---|
| Munich | 23 April 2026 | Vogel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 3 of 3

# ANNEX TO THE EUROPEAN SEARCH REPORT ON EUROPEAN PATENT APPLICATION NO.

EP 25 21 8578

This annex lists the patent family members relating to the patent documents cited in the above-mentioned European search report. The members are as contained in the European Patent Office EDP file on
The European Patent Office is in no way liable for these particulars which are merely given for the purpose of information.

23-04-2026

| Patent document cited in search report | Publication date | Patent family member(s) | Publication date |
|---|---|---|---|
| US 2005136355 A1 | 23-06-2005 | NONE | |
| US 2016054654 A1 | 25-02-2016 | CN 102163010 A | 24-08-2011 |
| | | CN 104298070 A | 21-01-2015 |
| | | CN 104483818 A | 01-04-2015 |
| | | EP 2357530 A2 | 17-08-2011 |
| | | US 2011200943 A1 | 18-08-2011 |
| | | US 2016033868 A1 | 04-02-2016 |
| | | US 2016054654 A1 | 25-02-2016 |
| US 2015168837 A1 | 18-06-2015 | CN 104334351 A | 04-02-2015 |
| | | EP 2855152 A1 | 08-04-2015 |
| | | US 2015168837 A1 | 18-06-2015 |
| | | WO 2013182328 A1 | 12-12-2013 |
| US 2024391232 A1 | 28-11-2024 | EP 4474163 A1 | 11-12-2024 |
| | | JP WO2023145972 A1 | 03-08-2023 |
| | | US 2024391232 A1 | 28-11-2024 |
| | | WO 2023145972 A1 | 03-08-2023 |
| US 2021362529 A1 | 25-11-2021 | CN 113382869 A | 10-09-2021 |
| | | EP 3904099 A1 | 03-11-2021 |
| | | JP 7351862 B2 | 27-09-2023 |
| | | JP WO2020158138 A1 | 14-10-2021 |
| | | US 2021362529 A1 | 25-11-2021 |
| | | WO 2020158138 A1 | 06-08-2020 |
| US 2012141942 A1 | 07-06-2012 | US 2012141942 A1 | 07-06-2012 |
| | | WO 2012074749 A1 | 07-06-2012 |
| US 2011104450 A1 | 05-05-2011 | CN 102612435 A | 25-07-2012 |
| | | EP 2496416 A2 | 12-09-2012 |
| | | JP 2013510338 A | 21-03-2013 |
| | | US 2011104450 A1 | 05-05-2011 |
| | | WO 2011056905 A2 | 12-05-2011 |
| US 7579133 B2 | 25-08-2009 | AT E520529 T1 | 15-09-2011 |
| | | AU 2004228076 A1 | 21-10-2004 |
| | | BR PI0409373 A | 25-04-2006 |
| | | CN 1805850 A | 19-07-2006 |
| | | CN 101879809 A | 10-11-2010 |
| | | EP 1615772 A1 | 18-01-2006 |
| | | JP 2006524146 A | 26-10-2006 |
| | | US 2004202962 A1 | 14-10-2004 |
| | | US 2006292486 A1 | 28-12-2006 |
| | | US 2008070163 A1 | 20-03-2008 |

EPO FORM P0459

For more details about this annex : see Official Journal of the European Patent Office, No. 12/82

# ANNEX TO THE EUROPEAN SEARCH REPORT ON EUROPEAN PATENT APPLICATION NO. EP 25 21 8578

This annex lists the patent family members relating to the patent documents cited in the above-mentioned European search report. The members are as contained in the European Patent Office EDP file on
The European Patent Office is in no way liable for these particulars which are merely given for the purpose of information.

23-04-2026

| Patent document cited in search report | Publication date | Patent family member(s) | Publication date |
|---|---|---|---|
| | | US 2009246689 A1 | 01-10-2009 |
| | | WO 2004089630 A1 | 21-10-2004 |
| US 2017021656 A1 | 26-01-2017 | EP 3132932 A2 | 22-02-2017 |
| | | US 2017021656 A1 | 26-01-2017 |
| US 2003073032 A1 | 17-04-2003 | AT E340073 T1 | 15-10-2006 |
| | | DE 60123173 T2 | 30-08-2007 |
| | | EP 1170123 A2 | 09-01-2002 |
| | | JP 2002023350 A | 23-01-2002 |
| | | US 2003073032 A1 | 17-04-2003 |
| US 2012088191 A1 | 12-04-2012 | AT E553920 T1 | 15-05-2012 |
| | | BR PI1015004 A2 | 05-04-2016 |
| | | CN 102458855 A | 16-05-2012 |
| | | EP 2263874 A1 | 22-12-2010 |
| | | ES 2381535 T3 | 29-05-2012 |
| | | US 2012088191 A1 | 12-04-2012 |
| | | WO 2010145947 A2 | 23-12-2010 |
| US 2011287365 A1 | 24-11-2011 | US 2011287365 A1 | 24-11-2011 |
| | | WO 2011146548 A1 | 24-11-2011 |
| US 2013183622 A1 | 18-07-2013 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2024117242 A
- WO 2007097302 A
- WO 2018181993 A
- WO 2019013268 A
- WO 2020262685 A
- WO 2022019217 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- WO 2020262692 A
- JP 2008544322 A
- WO 2016027886 A
- WO 2019219560 A
- WO 2023023681 A
- WO 2023032681 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2008284817 A
- JP 2008151929 A
- JP 2018165797 A
- US 4123279 A
- JP 2019162855 A
- US 2714066 A
- US 3181461 A
- JP 5045885 A
- JP H545885 A
- JP 6035174 A
- JP H635174 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2010076336 A
- WO 2016133072 A


### Non-patent literature cited in the description


- **NAOKI INAMOTO**. Chemical Seminar 10 Hammett Side-Structure and Reactivity. Maruzen Co., Ltd., June 1983
- *Dye Handbooks*, 1970